# EUROPEAN PATENT APPLICATION

(11) **EP 4 583 111 A1**
(43) Date of publication of application: **09.07.2025**
(21) Application number: 24804723.5
(22) Date of filing: 19.09.2024
(51) Int. Cl.: G11C 29/44

(54) **LOGIC CHIP, MEMORY CHIP, CHIP STACK STRUCTURE, AND MEMORY**

(30) Priority: 15.11.2023 CN 202311543580
(71) Applicant: CXMT Corporation, Hefei, Anhui 230601 (CN)
(72) Inventor: ZHANG, Jiarui, Hefei, Anhui 230601 (CN)
(74) Representative: Gulde & Partner
(86) International application number: PCT/CN2024/119831
(87) International publication number: WO 2025/102969

(57) **Abstract**

The present disclosure provides a logic chip, a memory chip, a chip stack structure, and a memory. The logic chip is provided with a plurality of channel signal regions, conductive vias in each one of the plurality of channel signal regions are divided into a plurality of repair unit groups, and each one of the plurality of repair unit groups includes four repair units, where a first repair unit and a second repair unit are arranged symmetrically about a first axis, a third repair unit and a fourth repair unit are arranged symmetrically about the first axis, and the first repair unit and the fourth repair unit are arranged symmetrically about a second axis.

## Description

### CROSS-REFERENCE TO RELATED APPLICATIONS

The present application claims priority to Chinese Patent Application No. 202311543580.4 filed with China National Intellectual Property Administration on November 15, 2023 and entitled "LOGIC CHIP, MEMORY CHIP, CHIP STACK STRUCTURE, AND MEMORY", the content of which is incorporated herein by reference in its entirety.

### TECHNICAL FIELD

The present disclosure relates to the field of semiconductor technologies, in particular to a logic chip, a memory chip, a chip stack structure, and a memory.

### BACKGROUND

With the development of integrated circuit technologies, remarkable progress has been made in the manufacturing process of semiconductor devices. In recent years, however, the development of two-dimensional semiconductor technology has been accompanied by various challenges, including physical limits, limits of existing development technology, limits of storage electron density, etc. In this context, to solve the difficulties encountered by two-dimensional semiconductor devices and to pursue lower production costs per unit memory cell, a plurality of chips may be stacked by using a bonding process (e.g., hybrid bonding, bumping, and wire bonding) to form a three-dimensional semiconductor device. However, for the three-dimensional semiconductor device, connection structures between different chips still have problems such as large parasitic capacitance and large parasitic resistance, which affect the signal transmission quality.

### SUMMARY

Embodiments of the present disclosure provide a logic chip, a memory chip, a chip stack structure, and a memory. In a first aspect, an embodiment of the present disclosure provides a logic chip. The logic chip includes m channel signal regions sequentially arranged along a first direction, the logic chip has a chip axis extending along a second direction and passing through a center of the logic chip, the m channel signal regions are arranged symmetrically about the chip axis, and m is a positive integer; each one of the channel signal regions has a first axis and a second axis, where the first axis extends along the first direction or the second direction, and the second axis and the first axis are perpendicular to each other and intersect at a center of a corresponding channel signal region thereof; each one of the channel signal regions is penetrated through by a plurality of conductive vias along a third direction, any two of the first direction, the second direction, and the third direction are perpendicular to each other, the first direction and the second direction are parallel to a top surface of the logic chip, and the third direction is perpendicular to the top surface of the logic chip; for each one of the channel signal regions, the plurality of conductive vias therein are divided into a plurality of repair unit groups; each one of the plurality of repair unit groups includes a first repair unit, a second repair unit, a third repair unit, and a fourth repair unit; the first repair unit and the second repair unit are arranged symmetrically about the first axis of a corresponding channel signal region thereof, the third repair unit and the fourth repair unit are arranged symmetrically about the first axis of a corresponding channel signal region thereof, and the first repair unit and the fourth repair unit are arranged symmetrically about the second axis of a corresponding channel signal region thereof; each one of the repair units includes at least one redundant conductive via and at least one normal conductive via, and in a case that any one of the at least one normal conductive via is damaged, an effective signal transmitted by the normal conductive via is switched to a next conductive via in a same one of the repair units along a preset switching direction; any one of the conductive vias in any one of the repair units is electrically connected to an internal circuit of the logic chip when used for transmitting an effective signal; the normal conductive via in the first repair unit and the normal conductive via in the second repair unit are in one-to-one correspondence and are arranged symmetrically about the first axis of a corresponding channel signal region thereof, the normal conductive via in the third repair unit and the normal conductive via in the fourth repair unit are in one-to-one correspondence and are arranged symmetrically about the first axis of a corresponding channel signal region thereof, and the normal conductive via in the first repair unit and the normal conductive via in the fourth repair unit are in one-to-one correspondence and are arranged symmetrically about the second axis of a corresponding channel signal region thereof.

In a second aspect, an embodiment of the present disclosure provides a memory chip. The memory chip includes m channels sequentially arranged along a first direction, the memory chip has a chip axis extending along a second direction and passing through a center of the memory chip, and the m channels are arranged symmetrically about the chip axis; each one of the channels includes a first memory array region, a channel signal region, and a second memory array region sequentially arranged along the second direction, a center of each one of the channel signal regions is coincident with a center of a corresponding channel thereof, and m is a positive integer; each one of the channel signal regions has a first axis and a second axis, where the first axis extends along the first direction or the second direction, and the second axis and the first axis are perpendicular to each other and intersect at a center of a corresponding channel signal region thereof; each one of the channel signal regions is penetrated through by a plurality of conductive vias along a third direction, any two of the first direction, the second direction, and the third direction are perpendicular to each other, the first direction and the second direction are parallel to a top surface of the memory chip, and the third direction is perpendicular to the top surface of the memory chip; for each one of the channel signal regions, the plurality of conductive vias therein are divided into a plurality of repair unit groups; each one of the plurality of repair unit groups includes a first repair unit, a second repair unit, a third repair unit, and a fourth repair unit; the first repair unit and the second repair unit are arranged symmetrically about the first axis of a corresponding channel signal region thereof, the third repair unit and the fourth repair unit are arranged symmetrically about the first axis of a corresponding channel signal region thereof, and the first repair unit and the fourth repair unit are arranged symmetrically about the second axis of a corresponding channel signal region thereof; each one of the repair units includes at least one redundant conductive via and at least one normal conductive via, and in a case that any one of the at least one normal conductive via is damaged, an effective signal transmitted by the normal conductive via is switched to a next conductive via in a same one of the repair units along a preset switching direction; any one of the conductive vias in the first repair unit is electrically connected to an internal circuit of the memory chip when used for transmitting an effective signal; the normal conductive via in the first repair unit and the normal conductive via in the second repair unit are in one-to-one correspondence and are arranged symmetrically about the first axis of a corresponding channel signal region thereof, the normal conductive via in the third repair unit and the normal conductive via in the fourth repair unit are in one-to-one correspondence and are arranged symmetrically about the first axis of a corresponding channel signal region thereof, and the normal conductive via in the first repair unit and the normal conductive via in the fourth repair unit are in one-to-one correspondence and are arranged symmetrically about the second axis of a corresponding channel signal region thereof.

In a third aspect, an embodiment of the present disclosure provides a chip stack structure. The chip stack structure includes the logic chip as described in the first aspect and at least one stack unit, and the logic chip and the at least one stack unit are sequentially stacked along a third direction; each one of the at least one stack unit includes a first memory chip, a second memory chip, a third memory chip, and a fourth memory chip sequentially stacked along the third direction, and the third direction is perpendicular to a top surface of each one of the chips; the first memory chip, the second memory chip, the third memory chip, and the fourth memory chip are each the memory chip as described in the second aspect; the first memory chip and the second memory chip are stacked in a face-to-face manner, the second memory chip and the third memory chip are stacked in a back-to-back manner, and the third memory chip and the fourth memory chip are stacked in a face-to-face manner; the logic chip and the first memory chip are stacked in a back-to-back manner, or the logic chip and the first memory chip are stacked in a face-to-back manner.

In a fourth aspect, an embodiment of the present disclosure provides a memory. The memory includes the chip stack structure as described in any of the third aspect.

The embodiments of the present disclosure provide a logic chip, a memory chip, a chip stack structure, and a memory, where each chip is provided with a plurality of channel signal regions, and each one of the plurality of channel signal regions is provided with conductive vias symmetrically arranged, such that the chip stack structure formed by the memory chip realizes a rotation-type transmission of signals through the direct connection configuration of the conductive vias with small parasitic resistance and parasitic capacitance. Meanwhile, repair units are symmetrically divided in each one of the plurality of channel signal regions, such that a redundancy repair function of the chip stack structure can be realized, which improves the stability of the memory chip.

### BRIEF DESCRIPTION OF THE DRAWINGS

FIG. 1 is a schematic structural diagram of a chip;
FIG. 2A is a first schematic constitutional diagram of a chip stack structure;
FIG. 2B is a first schematic constitutional diagram of a chip stack structure;
FIG. 3 is a schematic diagram of a logic chip provided according to an embodiment of the present disclosure;
FIG. 4A/FIG. 4B are schematic diagrams of a logic chip provided according to an embodiment of the present disclosure;
FIG. 5 to FIG. 6D are schematic diagrams of repair units in a logic chip provided according to an embodiment of the present disclosure;
FIG. 7 to FIG. 8D are schematic diagrams of repair units in another logic chip provided according to an embodiment of the present disclosure;
FIG. 9 is a schematic diagram of a memory chip provided according to an embodiment of the present disclosure;
FIG. 10A/FIG. 10B are schematic diagrams of a memory chip provided according to an embodiment of the present disclosure;
FIG. 11 to FIG. 12D are schematic diagrams of repair units in a memory chip provided according to an embodiment of the present disclosure;
FIG. 13 to FIG. 14D are schematic diagrams of repair units in another memory chip provided according to an embodiment of the present disclosure;
FIG. 15 is a schematic diagram of a composition structure of a chip stack structure provided according to an embodiment of the present disclosure;
FIG. 16A/FIG. 16B are schematic diagrams of positions of repair units in a chip stack structure provided according to an embodiment of the present disclosure;
FIG. 17A/FIG. 17B/FIG. 17C are specific schematic diagrams of a first chip stack structure provided according to an embodiment of the present disclosure;
FIG. 18A/FIG. 18B are specific schematic diagrams of a second chip stack structure provided according to an embodiment of the present disclosure;
FIG. 19A/FIG. 19B are specific schematic diagrams of a third chip stack structure provided according to an embodiment of the present disclosure;
FIG. 20A/FIG. 20B are specific schematic diagrams of a fourth chip stack structure provided according to an embodiment of the present disclosure;
FIG. 21 is a schematic diagram of signal transmission in a chip stack structure provided according to an embodiment of the present disclosure;
FIG. 22A/FIG. 22B are schematic diagrams of a repair process of a chip stack structure provided according to an embodiment of the present disclosure;
FIG. 23 is a schematic diagram of signal transmission in another chip stack structure provided according to an embodiment of the present disclosure;
FIG. 24A/FIG. 24B are schematic diagrams of a repair process of another chip stack structure provided according to an embodiment of the present disclosure; and
FIG. 25 is a schematic diagram of a composition structure of a memory provided according to an embodiment of the present disclosure.

### DETAILED DESCRIPTION

The technical solutions in the embodiments of the present disclosure will be clearly and completely described below with reference to the drawings in the embodiments of the present disclosure. It can be understood that the specific embodiments described herein are merely illustrative of the related applications and are not intended to limit the present disclosure. In addition, it should be noted that for the convenience of description, only the portions relevant to the related applications are shown in the drawings.

Unless defined otherwise, all technical and scientific terms used herein have the same meaning as commonly understood by those skilled in the art to which the present disclosure belongs. The terms used herein are for the purpose of describing the embodiments of the present disclosure only and are not intended to limit the present disclosure.

In the following description, reference is made to "some embodiments" which describe a subset of all possible embodiments, but it can be understood that "some embodiments" may be the same subset or different subsets of all possible embodiments and may be combined with each other without conflict.

It should be noted that the terms "first\second\third" referred to in the embodiments of the present disclosure are merely used for distinguishing similar objects and do not represent a specific ordering for the objects. It can be understood that "first\second\third" may be subjected to interchange of a specific order or sequence if permitted, such that the embodiments of the present disclosure described herein can be implemented in an order other than that shown or described herein.

Before describing the embodiments of the present disclosure, three directions for describing three-dimensional structures that may be used in the planes involved in the following embodiments are defined. Taking the Cartesian coordinate system as an example, the three directions may include a first direction, a second direction, and a third direction.

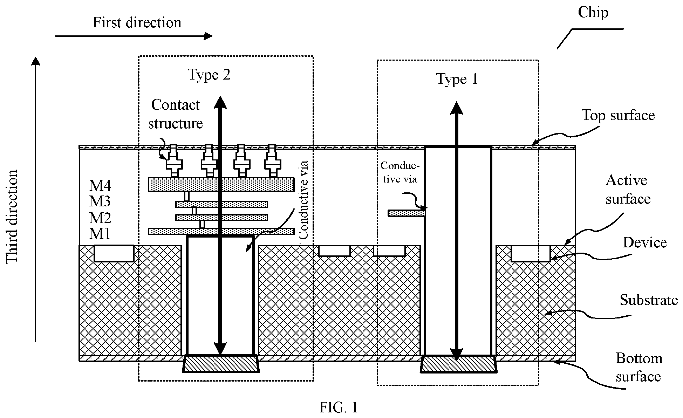

Referring to FIG. 1, a semiconductor chip (specifically, a memory chip or a logic chip) may include a top surface at a front side and a bottom surface at a back side opposite to the front side. A direction intersecting with (e.g., perpendicular to) the top surface and the bottom surface of the semiconductor chip is defined as a third direction in the case that the flatness of the top surface and the bottom surface is ignored. On the top surface of the semiconductor chip, two directions perpendicular to each other, i.e., a first direction and a second direction, are defined, and the first direction is perpendicular to one edge of the semiconductor chip, and the second direction is perpendicular to another edge of the semiconductor chip.

Referring to FIG. 1, the semiconductor chip includes a substrate, an active surface is formed at a side of the substrate for manufacturing devices (e.g., transistors and capacitors), and a plurality of metal layers, for example, M1, M2, M3, ..., are distributed between the substrate and the top surface. FIG. 1 further shows two types of conductive vias ..., (e.g., through-silicon-vias (TSVs)), both of which are used for signal connection between different stacked chips.

As shown in FIG. 1, a type 1 conductive via penetrates through the bottom surface and the top surface along the third direction, and the conductive via is connected to an internal circuit of the chip through the metal layers.

As shown in FIG. 1, a type 2 conductive via penetrates through the substrate only along the third direction, and the aid of a contact structure penetrating through the top surface along the third direction is needed for realizing signal transmission. The contact structure and the conductive via are not electrically connected directly, but are electrically connected indirectly through the metal layers. For example, the contact structure in FIG. 1 is connected to M4, M4 is connected to M1 via M3 and M2 in turn, and M1 is connected to the conductive via. Of course, in other embodiments, the contact structure and the conductive via may be designed to be electrically connected directly.

Meanwhile, the types of the conductive vias are not limited to the above two types which are merely examples. In particular, the illustrations presented in the present disclosure are not meant to be actual views of any particular microelectronic apparatus or components thereof, but are merely idealized representations for describing illustrative embodiments. The drawings are not necessarily to scale.

The embodiments of the present disclosure are described in detail below with reference to the drawings.

In an embodiment, a memory chip and a logic chip are provided. The memory chip and the logic chip both include a plurality of conductive vias penetrating through the chip along the third direction. The conductive vias are used for implementing signal transmission between different chips, and all the conductive vias may each be located at any position. In particular, every four conductive vias can be functionally regarded as a conductive via group, but the respective positions of the four conductive vias are not limited.

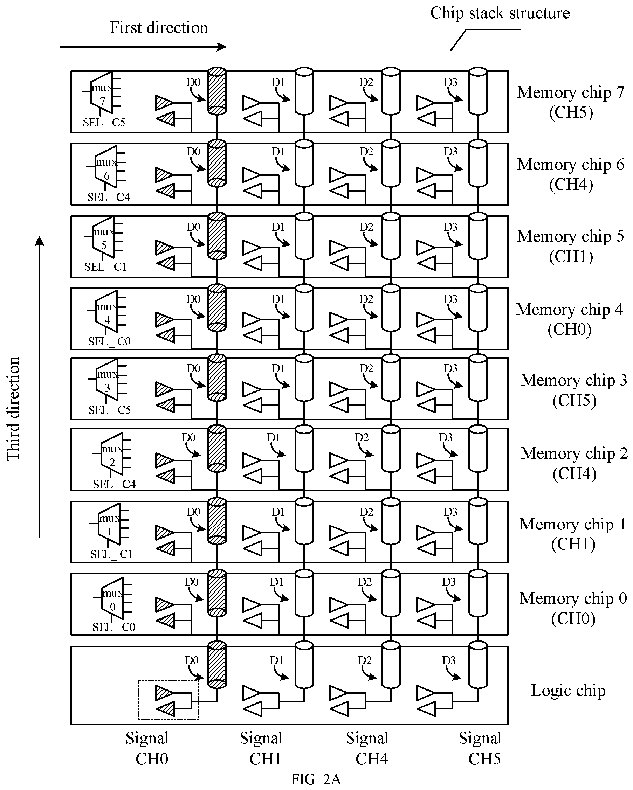

In a specific embodiment, eight memory chips and one logic chip are stacked to form a 3D memory device, the respective conductive vias of the eight memory chips are aligned along the third direction, and nine conductive vias aligned along the third direction are connected to form an electrical path. Referring to FIG. 2A, a schematic diagram of signal transmission in a chip stack structure is shown. As shown in FIG. 2A, the chip stack structure includes memory chips 0-7 and a logic chip. FIG. 2A only shows four conductive vias D0-D3 for each memory chip, and the four conductive vias D0-D3 belong to the same conductive via group. In this case, the conductive vias D0 in the eight memory chips and the one logic chip are all aligned to form one electrical path, the conductive vias D1 in the eight memory chips and the one logic chip are all aligned to form one electrical path, ..., and so on. Meanwhile, each memory chip and the logic chip are further provided with a plurality of driving circuits (only one driving circuit is shown in a dashed box in FIG. 2A, and the other driving circuits are not shown), and each conductive via is connected to one driving circuit. Each memory chip is further provided with a plurality of data selectors (e.g., mux0-7 in FIG. 2A), and each conductive via group corresponds to one data selector, that is, all the conductive vias of one conductive via group are connected to a data port of a data selector through respective driving circuits. That is, the data selector may decide the signal transmitted by which conductive via is to be output to the inside of the memory chip or the signal output by the memory chip is output to which conductive via.

For the whole memory device, different regions in different memory chips are divided into different channels (for example, CH0, CH1, CH4, and CH5) for management, and the signal Signal_CH0 of the channel CH0 is transmitted through an electrical path formed by "the conductive via D0 in the logic chip, the conductive via D0 in the memory chip 0-the conductive via D0 in the memory chip 1-the conductive via D0 in the memory chip 2-the conductive via D0 in the memory chip 3-the conductive via D0 in the memory chip 4-the conductive via D0 in the memory chip 5-the conductive via D0 in the memory chip 6-the conductive via D0 in the memory chip 7". The select signals of the data selector mux0 in the memory chip 0 and the data selector mux4 in the memory chip 4 are both SEL_C0, that is, the signal Signal_CH0 can enter the memory chip 0 and the memory chip 4 through the aforementioned electrical path. The process of signal output can be understood similarly.

As can be seen from the above, the memory chip 0 only needs to acquire signals from the conductive via D0, and the memory chip 1 only needs to acquire signals from the conductive via D1, ..., that is, each memory chip only needs to acquire signals from one conductive via in one conductive via group. It is worth noting that different memory chips may need to acquire signals from different conductive vias. However, since all memory chips need to be designed to have the same structure during the manufacturing process (which can save cost and labor to the maximum), all conductive vias in the memory chips need to be designed with corresponding driving structures and data selectors for structural consistency. Further, in the case that the chip stack structure shown in FIG. 2A is adopted, each conductive via corresponds to a driving circuit. In the working process of the chip stack structure, all driving circuits in all memory chips in the same channel need to be driven, resulting in a large load and large parasitic capacitance, which seriously affects the performance of the chips, restricts the transmission efficiency, increases the power consumption, and restricts the number of stacked chips in the three-dimensional device.

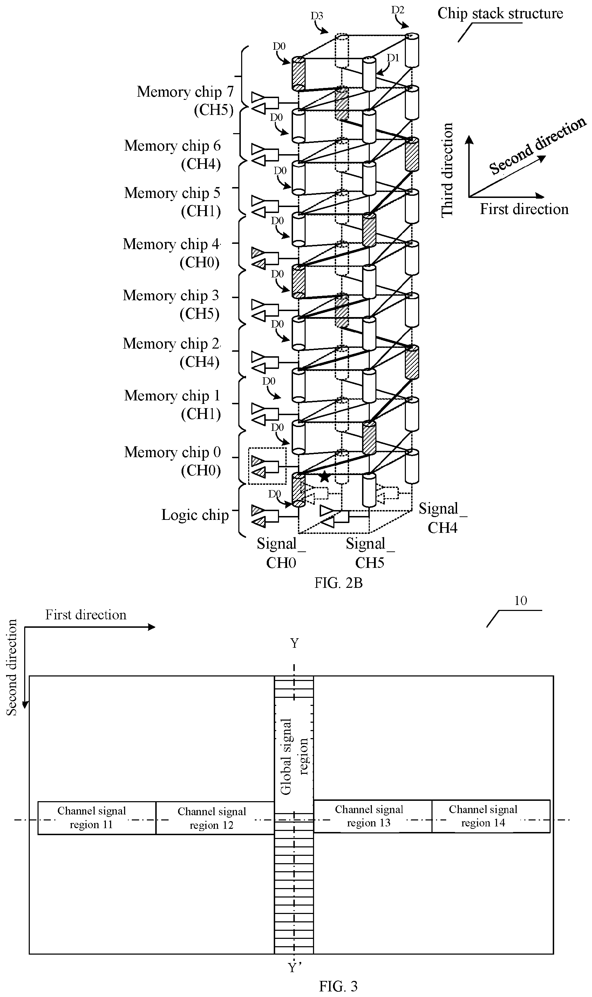

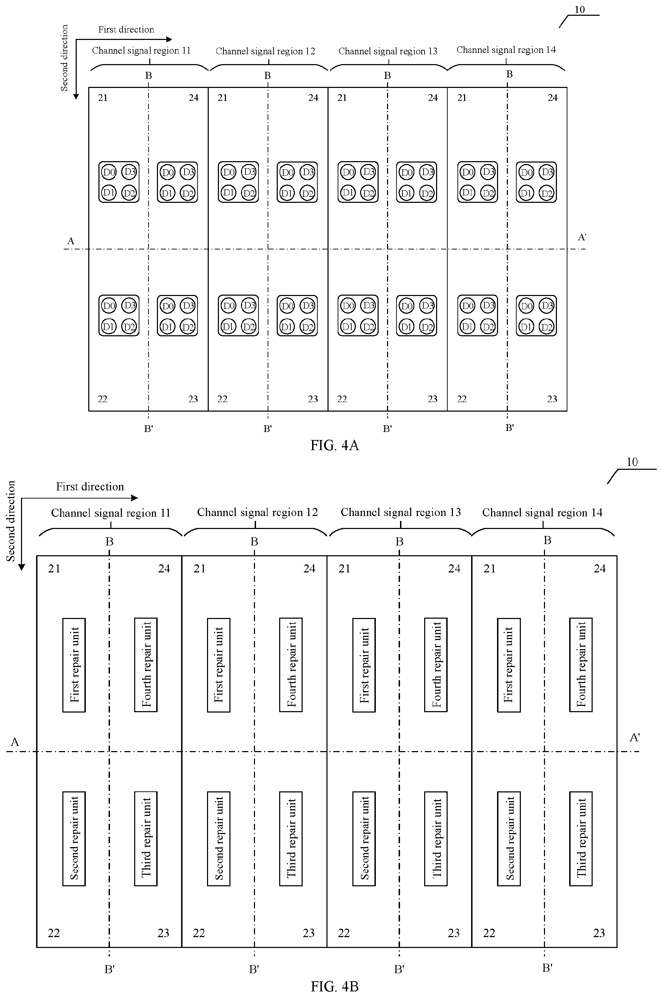

In another embodiment, referring to FIG. 2B, a schematic diagram of signal transmission in another chip stack structure is shown. In particular, in FIG. 2B, only some of the conductive vias (D0-D3) are identified, and others are omitted, but for FIG. 4A, the identifiers of the conductive vias aligned along the third direction are the same. As shown in FIG. 2B, the chip stack structure also includes eight memory chips and one logic chip aligned along the third direction, but each conductive via in each memory chip is connected to another conductive via at a different position in another memory chip in a rotating manner, such that a general spiral-up connection is realized, i.e., the signal Signal_CH0 of the channel CH0 is transmitted through "the conductive via D0 in the logic chip-the conductive via D1 in the memory chip 0-the conductive via D2 in the memory chip 1-the conductive via D3 in the memory chip 2-the conductive via D0 in the memory chip 3-the conductive via D1 in the memory chip 4-the conductive via D2 in the memory chip 5-the conductive via D3 in the memory chip 6-the conductive via D0 in the memory chip 7", and other signals are similarly transmitted.

In this way, the memory chip 0 can acquire the signal Signal_CH0 through the output end of the conductive via D0 in the logic chip, the memory chip 1 can acquire the signal Signal_CH1 through the input end of the conductive via D0 in the memory chip 0, the memory chip 2 can acquire the signal Signal_CH4 through the input end of the conductive via D0 in the memory chip 1, and the memory chip 3 can acquire the signal Signal_CH5 through the input end of the conductive via D0 in the memory chip 2, ..., such that for each memory chip, only one conductive via in each conductive via group needs to be connected to the driving circuit, and no data selector is needed, such that the number of devices can be reduced, thereby reducing the parasitic capacitance. However, compared with the direct connection configuration of the conductive vias in FIG. 2A, the process of the rotational connection of the conductive vias in FIG. 2B is more complicated. Specifically, in FIG. 2B, a horizontal interconnection structure needs to be disposed between adjacent conductive vias in each memory chip (only one horizontal interconnection structure is marked with a five-pointed star in FIG. 2B), and the signal interconnection structures may be metal interconnection lines, conductive vias, or the like. To implement the rotational connection of the conductive vias, the input signal signal_CH0 has to be transmitted upward from the conductive via D0 of the logic chip to the interconnection structure below the conductive via D0 of the memory chip 0 (instead of accessing the conductive via D0 of the memory chip 0) and then horizontally transmitted from the interconnection structure below the conductive via D0 of the memory chip 0 to the conductive via D1 of the memory chip 0. That is, for the structure shown in FIG. 2B, a signal also needs to pass through the interconnection structures in each memory chip during the signal process, and the situation is similar for outputting signals, which inevitably results in increased parasitic resistance and increased process complexity.

In particular, in the chip stack structures of FIG. 2A and FIG. 2B, active surfaces of all chips are upward facing, i.e., different memory chips are stacked in a back-to-face manner. The memory chips and the logic chip are also stacked in a back-to-face manner, i.e., the bottom surface of the upper chip is in contact with the top surface of the lower chip.

In summary, in one aspect, the chip stack structure in FIG. 2A needs to be provided with more conductive vias to transmit corresponding signals, which, together with the corresponding driving circuits and data selectors, cause a large load and large parasitic capacitance, while the chip stack structure in FIG. 2B causes large parasitic resistance due to the rotational configuration; in another aspect, the stack structures in FIG. 2A and FIG. 2B both have some problems and cannot be directly applied to face-to-face stack structures. Specifically, if a face-to-face chip stack structure is desired to be further realized, one method is to use two sets of masks to manufacture two different chips as a chip with active surface facing upward and a chip with active surface facing downward, respectively, and this process is characterized by high process complexity and uncontrollable cost; another method is to form an additional group of conductive vias and connect the two groups of conductive vias to the same driving circuit in the memory chip, but the method may result in complex internal wiring of the memory chip, which may not only increase the process complexity, but also increase the power consumption.

In an embodiment of the present disclosure, referring to FIG. 3, a schematic diagram of an active surface in the logic chip 10 is shown. As shown in FIG. 3, the logic chip 10 includes m channel signal regions (FIG. 3 shows an example where m = 4) sequentially arranged along the first direction, the logic chip 10 has a chip axis YY' extending along the second direction and passing through a center of the logic chip 10, and the m channel signal regions are arranged symmetrically about the chip axis YY'.

As shown in FIG. 3, the center of the active surface of the logic chip 10 and the vicinity thereof are also defined as a global signal region. In this case, a first channel signal region 11, a second channel signal region 12, the global signal region, a third channel signal region 13, and a fourth channel signal region 14 are sequentially distributed along the first direction, and upper and lower sides of the channel signal regions of the logic chip 10 are used for distributing some logic control circuits of the stacked memory.

FIG. 3 is illustrated with m = 4, and the description is given below with m = 4, but m can be any positive integer. Specifically, if m is an even number, m/2 channel signal regions are located at one side of the global signal region along the first direction, and the remaining m/2 channel signal regions are located at the other side of the global signal region along the first direction; if m is an odd number, an (m+1)^{th}/2 channel signal region needs to be divided into two parts that are respectively located at two sides of the global signal region along the first direction, while other (m-1)/2 channel signal regions are located at one side of the global signal region along the first direction, and the remaining (m-1)/2 channel signal regions are located at the other side of the global signal region along the first direction.

It should be noted that, in the chip manufacturing process, to distinguish different channel signal regions of the chip, a positioning structure may be manufactured in a reference channel signal region (for example, the first channel signal region) of the logic chip 10, such that during subsequent packaging, the position of the reference channel is identified by the positioning structure, and other channels are identified based on the orientation of the active surface of the chip.

It should be noted that the global signal region and the channel signal regions are all penetrated through by a plurality of conductive vias along the third direction, and the third direction is perpendicular to the active surface, that is, any two of the first direction, the second direction, and the third direction are perpendicular to each other. Here, the conductive via may be a through-silicon-via (TSV), specifically a vertical interconnection structure penetrating through a silicon wafer/chip, or in other embodiments, the conductive via may be another conductive via with a conductive function, which is not specifically limited. In addition, the conductive via may take the form of the aforementioned type 1 or the form of the aforementioned type 2.

For the global signal region, each conductive via is used for transmitting a global signal, and the global signal is shared by all regions of the corresponding memory chip. The global signal includes, but is not limited to: a reset signal, a power-on signal, a stack identification signal SID/CID, a power-related signal Voltage Monitor, and a timing-related signal Timing Aligner. In some cases, the global signal region may also refer to a pad region. The global signal may be a design for test (DFT) test signal, and the working condition of the internal circuit of the chip and the transmission condition of the related signal may be learned through the global signal. In addition, since a DFT pin pad (PAD) in a logic chip is generally located in the middle of the chip, it is preferable for the conductive vias for DFT and other global signals to be located in a narrower region in the middle of the chip, that is, at the position of the global signal region as shown in FIG. 3.

That is, the global signal transmitted by the global signal region is commonly used by m channels in each memory chip in the subsequent stack structure; the channel control signal transmitted by each channel signal region is only used by a specific channel in each memory chip in the subsequent stack structure.

Referring to FIG. 4A, each channel signal region includes a first axis AA' and a second axis BB', the first axis AA' extends along the first direction or the second direction, and the second axis BB' and the first axis AA' are perpendicular to each other and intersect at a center of a corresponding channel signal region thereof. For example, in FIG. 3, the first axis AA' extends along the first direction and the second axis BB' extends along the second direction; in other embodiments, the first axis AA' may extend along the second direction and the second axis BB' may extend along the first direction. In FIG. 4A, the global signal region is temporarily omitted. As shown in FIG. 4A, each channel signal region is penetrated through by a plurality of conductive vias (D0, D1, D2, D3) along the third direction, and each conductive via is used for transmitting the aforementioned channel control signal. Any two of the first direction, the second direction, and the third direction are perpendicular to each other, the first direction and the second direction are parallel to a top surface of the logic chip 10, and the third direction is perpendicular to the top surface of the logic chip 10.

In the embodiment of the present disclosure, referring to FIG. 4B, for each channel signal region, (all or part of) the conductive vias therein are divided into a plurality of repair unit groups. Each repair unit group includes a first repair unit, a second repair unit, a third repair unit, and a fourth repair unit; the first repair unit and the second repair unit are arranged symmetrically about the first axis AA' of a corresponding channel signal region thereof, the third repair unit and the fourth repair unit are arranged symmetrically about the first axis AA' of a corresponding channel signal region thereof, and the first repair unit and the fourth repair unit are arranged symmetrically about the second axis BB' of a corresponding channel signal region thereof. The above symmetrical characteristics may be referred to as four-quadrant symmetry. In particular, the repair unit groups in FIG. 4B are merely illustrative, and the shape of a real repair unit group may be in various forms.

Each repair unit (when not specified, a repair unit may refer to any one of the first repair unit, the second repair unit, the third repair unit, and the fourth repair unit) includes at least one redundant conductive via and at least one normal conductive via. Here, the normal conductive via refers to a conductive via for transmitting an effective signal in the initial design, and the redundant conductive via refers to a conductive via not for transmitting any signal in the initial design. However, when any normal conductive via is damaged, the redundant conductive via may be changed into a normal conductive via for transmitting the effective signal, such that the memory can still work normally. That is, for the same repair unit, when any normal conductive via is damaged, an effective signal transmitted by the normal conductive via is switched to a next conductive via in the same repair unit along a preset switching direction. Specifically: (1) if the next conductive via switched to is a redundant conductive via, the repair is finished, and the redundant conductive via becomes a new normal conductive via; and (2) if the next conductive via switched to is another normal conductive via, the signal originally transmitted by the normal conductive via is continuously switched to a next conductive via along the preset switching direction until it is switched to a redundant conductive via.

In particular, the logic chip 10 further includes a plurality of signal select circuits (which may each specifically include a data selector Mux and a driving unit). Take signal output as an example, a signal to be transmitted generated inside the logic chip 10 is transmitted to an input end of the signal select circuit, and an output end of the signal select circuit is connected to the plurality of conductive vias. In this case, the signal select circuit only transmits the signal to be transmitted to one of the conductive vias, and in the case that the conductive via is damaged, the signal select circuit can transmit the signal to be transmitted to another conductive via, thereby realizing the switching of the conductive vias (i.e., the switching of signal transmission channels); the corresponding structure of signal input can be understood adaptively.

In this way, via the signal select circuit, any conductive via in any repair unit is electrically connected to the internal circuit of the logic chip 10 when used for transmitting an effective signal, and any conductive via in any repair unit is electrically isolated from the internal circuit of the logic chip 10 when not used for transmitting an effective signal. Alternatively, it can be understood that any conductive via in any repair unit is electrically connected to the internal circuit of the logic chip 10 when functioning as a normal conductive via, and any conductive via in any repair unit is electrically isolated from the internal circuit of the logic chip 10 when not functioning as a normal conductive via.

The number of redundant conductive vias and the number of normal conductive vias in each repair unit can be flexibly determined. For example, in the case that each repair unit includes four different conductive vias, the number of normal conductive vias:the number of redundant conductive vias = 2:2, or the number of normal conductive vias:the number of redundant conductive vias = 1:3, or the number of normal conductive vias:the number of redundant conductive vias = 3:1, and the like; or in the case that each repair unit includes six different conductive vias, the number of normal conductive vias:the number of redundant conductive vias = 4:2, or the number of normal conductive vias:the number of redundant conductive vias = 3:3, ..., which can be selected according to practical application scenarios.

In the embodiment of the present disclosure, the normal conductive vias in the repair units are in the following symmetry relationship: the normal conductive via in the first repair unit and the normal conductive via in the second repair unit are in one-to-one correspondence and are arranged symmetrically about the first axis AA' of a corresponding channel signal region thereof, the normal conductive via in the third repair unit and the normal conductive via in the fourth repair unit are in one-to-one correspondence and are arranged symmetrically about the first axis AA' of a corresponding channel signal region thereof, and the normal conductive via in the first repair unit and the normal conductive via in the fourth repair unit are in one-to-one correspondence and are arranged symmetrically about the second axis BB' of a corresponding channel signal region, i.e., the positions of the normal conductive vias also have the characteristics of four-quadrant symmetry.

In this way, the repair units in the logic chip 10 are in four-quadrant symmetry, and the normal conductive vias therein are also in four-quadrant symmetry, such that the chip stack structure formed by the logic chip and memory chips (which also have the characteristics) realizes a rotation-type transmission of signals through the direct connection configuration of the conductive vias with small parasitic resistance and parasitic capacitance, as detailed in the following description. Meanwhile, through the four-quadrant symmetrically arranged repair units, a redundancy repair function of the above structure can be realized, which improves the stability of the chip. In addition, the distribution of the conductive via groups and the repair units in different channel signal regions is the same, and the same mask can be adopted.

In an implementation of the present disclosure, for each repair unit group, the preset switching direction of the conductive vias in the first repair unit and the preset switching direction of the conductive vias in the second repair unit are arranged symmetrically about the first axis AA' of a corresponding channel signal region thereof; the preset switching direction of the conductive vias in the third repair unit and the preset switching direction of the conductive vias in the fourth repair unit are arranged symmetrically about the first axis AA' of a corresponding channel signal region thereof; the preset switching direction of the conductive vias in the first repair unit and the preset switching direction of the conductive vias in the fourth repair unit are arranged symmetrically about the second axis BB' of a corresponding channel signal region thereof; the preset switching direction of the conductive vias in the second repair unit and the preset switching direction of the conductive vias in the third repair unit are arranged symmetrically about the second axis BB' of a corresponding channel signal region thereof.

Referring to FIG. 4A, each channel signal region is divided into 2×2 signal zones, i.e., a first signal zone 21, a second signal zone 22, a third signal zone 23, and a fourth signal zone 24; (all or part of) the conductive vias of each signal zone are divided into n conductive via groups with the same arrangement manner, and n is a positive integer. Each dashed box in FIG. 4A is a conductive via group. As shown in FIG. 4A, the conductive via groups in the first signal zone 21 and the conductive via groups in the second signal zone 22 are in one-to-one correspondence and are arranged symmetrically about the first axis AA' of a corresponding channel signal region thereof, the conductive via groups in the third signal zone 23 and the conductive via groups in the fourth signal zone 24 are in one-to-one correspondence and are arranged symmetrically about the first axis AA' of a corresponding channel signal region thereof, and the conductive via groups in the first signal zone 21 and the conductive via groups in the fourth signal zone 24 are in one-to-one correspondence and are arranged symmetrically about the second axis BB' of a corresponding channel signal region thereof, i.e., the conductive via groups are also in four-quadrant symmetry. Here, FIG. 4A shows only one conductive via group for each signal zone, but there are many conductive via groups for each signal zone.

As shown in FIG. 4A, each one conductive via group includes a first conductive via D0, a second conductive via D1, a third conductive via D2, and a fourth conductive via D3, which are in the following symmetry relationship:
(1) in the same channel signal region, the first conductive via D0 in one conductive via group in the first signal zone 21, the second conductive via D1 in a corresponding conductive via group in the second signal zone 22, the third conductive via D2 in a corresponding conductive via group in the third signal zone 23, and the fourth conductive via D3 in a corresponding conductive via group in the fourth signal zone 24 form a whole symmetrical about the first axis AA' and symmetrical about the second axis BB';
(2) in the same channel signal region, the second conductive via D1 in one conductive via group in the first signal zone 21, the first conductive via D0 in a corresponding conductive via group in the second signal zone 22, the fourth conductive via D3 in a corresponding conductive via group in the third signal zone 23, and the third conductive via D2 in a corresponding conductive via group in the fourth signal zone 24 form a whole symmetrical about the first axis AA' and symmetrical about the second axis BB';
(3) in the same channel signal region, the third conductive via D2 in one conductive via group in the first signal zone 21, the fourth conductive via D3 in a corresponding conductive via group in the second signal zone 22, the first conductive via D0 in a corresponding conductive via group in the third signal zone 23, and the second conductive via D1 in a corresponding conductive via group in the fourth signal zone 24 form a whole symmetrical about the first axis AA' and symmetrical about the second axis BB';
(4) in the same channel signal region, the fourth conductive via D3 in one conductive via group in the first signal zone 21, the third conductive via D2 in a corresponding conductive via group in the second signal zone 22, the second conductive via D1 in a corresponding conductive via group in the third signal zone 23, and the first conductive via D0 in a corresponding conductive via group in the fourth signal zone 24 form a whole symmetrical about the first axis AA' and symmetrical about the second axis BB'.

It should be understood that in FIG. 4A, the four conductive vias in each conductive via group are arranged in a 2×2 array, but in other embodiments, the four conductive vias in each conductive via group may be arranged arbitrarily, as long as the above symmetry principle is observed.

Due to the limited space, the following drawings only use one channel signal region as an example to illustrate the composition and principle of the repair unit group, but in fact, the structures of all the channel signal regions are the same, i.e., the channel signal region in the drawings may be understood as any one of the channel signal region 11, the channel signal region 12, the channel signal region 13, and the channel signal region 14.

In some embodiments, B conductive via groups in each signal zone are referred to as one conductive via combination, conductive via groups b in the corresponding conductive via combinations in all the signal zones form a whole symmetrical about the first axis AA' and symmetrical about the second axis BB', B is a positive integer less than or equal to n, and b is a natural number less than B.

Corresponding conductive via combinations in all of the signal zones in the same channel signal region form four repair unit groups in total:
(1) for a first repair unit group, the first repair unit includes respective first conductive vias D0 of all the conductive via groups in the conductive via combination in the first signal zone 21, the second repair unit includes respective second conductive vias D1 of all the conductive via groups in the conductive via combination in the second signal zone 22, the third repair unit includes respective third conductive vias D2 of all the conductive via groups in the conductive via combination in the third signal zone 23, and the fourth repair unit includes respective fourth conductive vias D3 of all the conductive via groups in the conductive via combination in the fourth signal zone 24;
(2) for a second repair unit group, the first repair unit includes respective first conductive vias D0 of all the conductive via groups in the conductive via combination in the second signal zone 22, the second repair unit includes respective second conductive vias D1 of all the conductive via groups in the conductive via combination in the first signal zone 21, the third repair unit includes respective third conductive vias D2 of all the conductive via groups in the conductive via combination in the fourth signal zone 24, and the fourth repair unit includes respective fourth conductive vias D3 of all the conductive via groups in the conductive via combination in the third signal zone 23;
(3) for a third repair unit group, the first repair unit includes respective first conductive vias D0 of all the conductive via groups in the conductive via combination in the third signal zone 23, the second repair unit includes respective second conductive vias D1 of all the conductive via groups in the conductive via combination in the fourth signal zone 24, the third repair unit includes respective third conductive vias D2 of all the conductive via groups in the conductive via combination in the first signal zone 21, and the fourth repair unit includes respective fourth conductive vias D3 of all the conductive via groups in the conductive via combination in the second signal zone 22;
(4) for a fourth repair unit group, the first repair unit includes respective first conductive vias D0 of all the conductive via groups in the conductive via combination in the fourth signal zone 24, the second repair unit includes respective second conductive vias D1 of all the conductive via groups in the conductive via combination in the third signal zone 23, the third repair unit includes respective third conductive vias D2 of all the conductive via groups in the conductive via combination in the second signal zone 22, and the fourth repair unit includes respective fourth conductive vias D3 of all the conductive via groups in the conductive via combination in the first signal zone 21.

It should be noted that, for the same logic chip 10, B may have multiple values. For example, in the same logic chip 10, there is not only a conductive via combination composed of four conductive via groups, but also a conductive via combination composed of six conductive via groups, or conductive via combinations in more forms. However, no matter how many conductive via groups are included, each conductive via combination necessarily forms four repair unit groups.

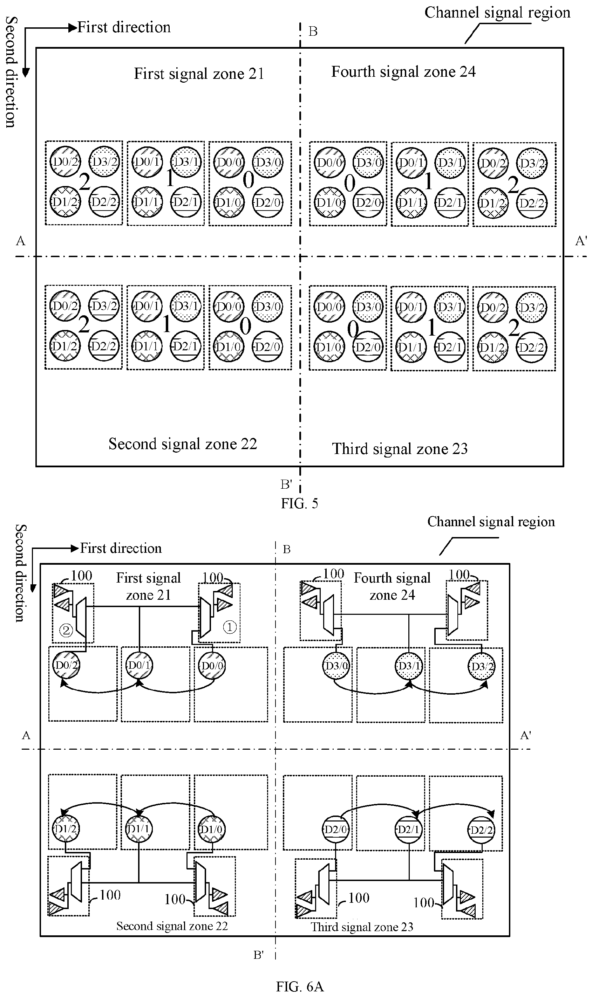

In a first specific embodiment, referring to FIG. 5, B = 3, and b is 0, 1, or 2. That is, the conductive via group 0 in the first signal zone 21, the conductive via group 0 in the second signal zone 22, the conductive via group 0 in the third signal zone 23, and the conductive via group 0 in the fourth signal zone 24 form a whole symmetrical about the first axis AA' and symmetrical about the second axis BB'; the conductive via group 1 in the first signal zone 21, the conductive via group 1 in the second signal zone 22, the conductive via group 1 in the third signal zone 23, and the conductive via group 1 in the fourth signal zone 24 form a whole symmetrical about the first axis AA' and symmetrical about the second axis BB', ..., and so on.

The conductive via groups 0-2 in each signal zone in the same channel signal region form four repair unit groups separately.

Referring to FIG. 6A, for a first repair unit group_1: (1) the first repair unit_1 includes respective first conductive vias of the conductive via group 0, the conductive via group 1, and the conductive via group 2 in the first signal zone 21, i.e., D0/0, D0/1, and D0/2 in the first signal zone 21; (2) the second repair unit_1 includes respective second conductive vias of the conductive via group 0, the conductive via group 1, and the conductive via group 2 in the second signal zone 22, i.e., D1/0, D1/1, and D1/2 in the second signal zone 22; (3) the third repair unit_1 includes respective third conductive vias of the conductive via group 0, the conductive via group 1, and the conductive via group 2 in the third signal zone 23, i.e., D2/0, D2/1, and D2/2 in the third signal zone 23; and (4) the fourth repair unit_1 includes respective fourth conductive vias of the conductive via group 0, the conductive via group 1, and the conductive via group 2 in the fourth signal zone 24, i.e., D3/0, D3/1, and D3/2 in the fourth signal zone 24.

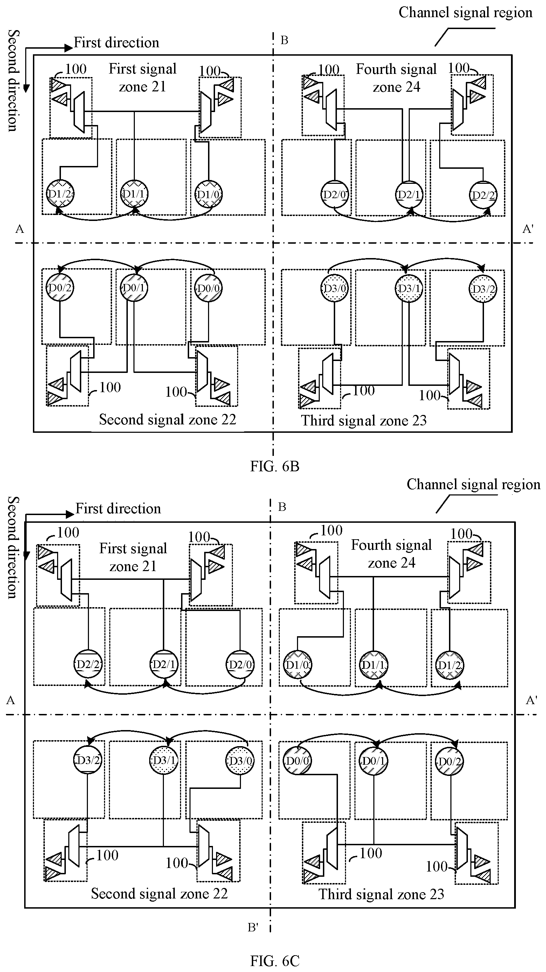

Referring to FIG. 6B, for the second repair unit group_2, (1) the first repair unit_2 includes respective first conductive vias of the conductive via group 0, the conductive via group 1, and the conductive via group 2 in the second signal zone 22, i.e., D0/0, D0/1, and D0/2 in the second signal zone 22; (2) the second repair unit_2 includes respective second conductive vias of the conductive via group 0, the conductive via group 1, and the conductive via group 2 in the first signal zone 21, i.e., D1/0, D1/1, and D1/2 in the first signal zone 21; (3) the third repair unit_2 includes respective third conductive vias of the conductive via group 0, the conductive via group 1, and the conductive via group 2 in the fourth signal zone 24, i.e., D2/0, D2/1, and D2/2 in the fourth signal zone 24; and (4) the fourth repair unit_2 includes respective fourth conductive vias of the conductive via group 0, the conductive via group 1, and the conductive via group 2 in the third signal zone 23, i.e., D3/0, D3/1, and D3/2 in the third signal zone 23.

Referring to FIG. 6C, for the third repair unit group_3, (1) the first repair unit_3 includes respective first conductive vias of the conductive via group 0, the conductive via group 1, and the conductive via group 2 in the third signal zone 23, i.e., D0/0, D0/1, and D0/2 in the third signal zone 23; (2) the second repair unit_3 includes respective second conductive vias of the conductive via group 0, the conductive via group 1, and the conductive via group 2 in the fourth signal zone 24, i.e., D1/0, D1/1, and D1/2 in the fourth signal zone 24; (3) the third repair unit_3 includes respective third conductive vias of the conductive via group 0, the conductive via group 1, and the conductive via group 2 in the first signal zone 21, i.e., D2/0, D2/1, and D2/2 in the first signal zone 21; and (4) the fourth repair unit_3 includes respective fourth conductive vias of the conductive via group 0, the conductive via group 1, and the conductive via group 2 in the second signal zone 22, i.e., D3/0, D3/1, and D3/2 in the second signal zone 22.

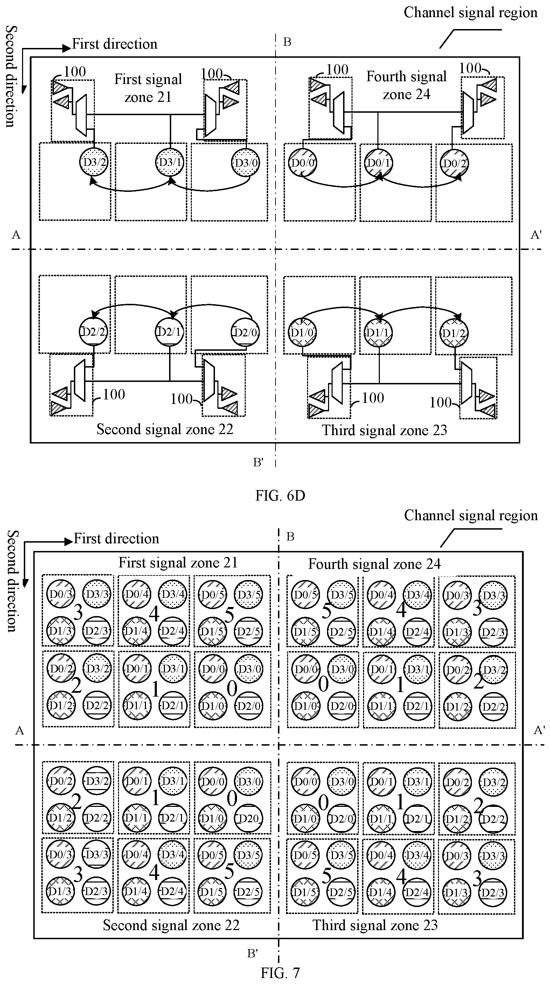

Referring to FIG. 6D, for the fourth repair unit group_4, (1) the first repair unit_4 includes respective first conductive vias of the conductive via group 0, the conductive via group 1, and the conductive via group 2 in the fourth signal zone 24, i.e., D0/0, D0/1, and D0/2 in the fourth signal zone 24; (2) the second repair unit_4 includes respective second conductive vias of the conductive via group 0, the conductive via group 1, and the conductive via group 2 in the third signal zone 23, i.e., D2/0, D2/1, and D2/2 in the third signal zone 23; (3) the third repair unit_4 includes respective third conductive vias of the conductive via group 0, the conductive via group 1, and the conductive via group 2 in the second signal zone 22, i.e., D2/0, D2/1, and D2/2 in the second signal zone 22; and (4) the fourth repair unit_4 includes respective fourth conductive vias of the conductive via group 0, the conductive via group 1, and the conductive via group 2 in the first signal zone 21, i.e., D3/0, D3/1, and D3/2 in the first signal zone 21.

It should be noted that as shown in FIG. 6A, for the first repair unit group, the first repair unit_1 (D0/0, D0/1, and D0/2 of the first signal zone 21) and the second repair unit_1 (D1/0, D1/1, and D1/2 of the second signal zone 22) are arranged symmetrically about the first axis AA', the third repair unit_1 (D2/0, D2/1, and D2/2 of the third signal zone 23) and the fourth repair unit_1 (D3/0, D3/1, and D3/2 of the fourth signal zone 24) are arranged symmetrically about the first axis AA', the first repair unit_1 (D0/0, D0/1, and D0/2 of the first signal zone 21) and the fourth repair unit_1 (D3/0, D3/1, and D3/2 of the fourth signal zone 24) are arranged symmetrically about the second axis BB', and the second repair unit_1 (D1/0, D1/1, and D1/2 of the first signal zone 22) and the third repair unit_1 (D2/0, D2/1, and D2/2 of the third signal zone 23) are arranged symmetrically about the second axis BB'. Meanwhile, the second to fourth repair unit groups also have similar characteristics.

An example of the preset switching direction is provided below to better understand the foregoing description, but the following example is not the only solution.

Assuming that all the conductive vias in the conductive via group 0 are normal conductive vias, the preset switching direction of the conductive vias in an X^{th} repair unit is set such that an X^{th} conductive via in the conductive via group 0 is allowed to switch to an X^{th} conductive via in the conductive via group 1 in the same signal zone, the X^{th} conductive via in the conductive via group 1 is allowed to switch to an X^{th} conductive via in the conductive via group 2 in the same signal zone, and X is one, two, three, or four.

That is, referring to FIG. 6A, for the first repair unit group, the preset switching direction of the conductive vias in the first repair unit_1 is set to D0/0-D0/1-D0/2 in the first signal zone 21; the preset switching direction of the conductive vias in the second repair unit_1 is set to D1/0-D1/1-D1/2 in the second signal zone 22; the preset switching direction of the conductive vias in the third repair unit_1 is set to D2/0-D2/1-D2/2 in the third signal zone 23; the preset switching direction of the conductive vias in the fourth repair unit_1 is set to D3/0-D3/1-D3/2 in the fourth signal zone 24.

Referring to FIG. 6B, for the second repair unit group, the preset switching direction of the conductive vias in the first repair unit_2 is set to D0/0-D0/1-D0/2 in the second signal zone 22; the preset switching direction of the conductive vias in the second repair unit_2 is set to D1/0-D1/1-D1/2 in the first signal zone 21; the preset switching direction of the conductive vias in the third repair unit_2 is set to D2/0-D2/1-D2/2 in the fourth signal zone 24; the preset switching direction of the conductive vias in the fourth repair unit_2 is set to D3/0-D3/1-D3/2 in the third signal zone 23.

Referring to FIG. 6C, for the third repair unit group, the preset switching direction of the conductive vias in the first repair unit_3 is set to D0/0-D0/1-D0/2 in the third signal zone 23; the preset switching direction of the conductive vias in the second repair unit_3 is set to D1/0-D1/1-D1/2 in the fourth signal zone 22; the preset switching direction of the conductive vias in the third repair unit_3 is set to D2/0-D2/1-D2/2 in the first signal zone 21; the preset switching direction of the conductive vias in the fourth repair unit_3 is set to D3/0-D3/1-D3/2 in the second signal zone 22.

Referring to FIG. 6D, for the fourth repair unit group, the preset switching direction of the conductive vias in the first repair unit_4 is set to D0/0-D0/1-D0/2 in the fourth signal zone 24; the preset switching direction of the conductive vias in the second repair unit_4 is set to D1/0-D1/1-D1/2 in the third signal zone 22; the preset switching direction of the conductive vias in the third repair unit_4 is set to D2/0-D2/1-D2/2 in the second signal zone 23; the preset switching direction of the conductive vias in the fourth repair unit_4 is set to D3/0-D3/1-D3/2 in the second signal zone 21.

It should be noted that, for each repair unit described above, the ratio of the number of normal conductive vias to that of the redundant conductive vias may be arbitrarily set, for example, 1:2, 2:1, etc.

For ease of understanding, the following provides a specific description of a signal switching-related circuit in which a repair ratio of the number of normal conductive vias:the number of redundant conductive vias is illustratively 2:1. To implement the above switching process, referring to FIG. 6A, FIG. 6B, FIG. 6C, and FIG. 6D, the logic chip 10 further includes a plurality of signal select circuits 100 for implementing the above switching of the conductive vias. Specifically, each signal select circuit 100 is composed of a data selector and a plurality of driving units. The data selectors in the signal select circuits 100 are connected to a plurality of conductive via groups, and the driving circuits in the signal select circuits 100 are connected to the internal circuit of the logic chip 10, such that via the signal select circuits 100, a specified one of the conductive vias can be selected to be electrically connected to the internal circuit of the logic chip 10, and thus switching of the conductive vias can be performed.

Take the first repair unit_1 (D0/0, D0/1, and D0/2 in the first signal zone 21) of the first repair unit group as an example, referring to FIG. 6A, D0/0 and D0/1 are connected to a first signal select circuit 100, and the first signal select circuit 100 connects D0/0 to the internal circuit of the logic circuit 10; D0/1 and D0/2 are connected to a second signal select circuit 100, and the second signal select circuit 100 connects D0/1 to the internal circuit of the logic circuit 10. Then, if D0/0 is damaged, the first signal select circuit 100 connects D0/1 to the internal circuit of the logic circuit 10, i.e., the signal originally transmitted by D0/0 will be transmitted by D0/1; the second signal select circuit 100 connects D0/2 to the internal circuit of the logic circuit 10, i.e., the signal originally transmitted by D0/1 will be transmitted by D0/2. The other repair units can be similarly understood.

It should be noted that FIG. 6A to FIG. 6D are only an example of the preset switching direction; the preset switching direction can actually be selected flexibly. Take the first repair unit_1 as an example, currently the switching may be sequentially along D0/0, D0/1, D0/2, or along D0/2, D0/1, D0/0, or the switching may be performed with D0/1 as a switching start point, etc. Of course, the four repair units must follow the aforementioned symmetry characteristics. That is, if the first repair unit_1 adopts another switching form and another definition of normal conductive vias, the second repair unit_1, the third repair unit_1, and the fourth repair unit_1 must adopt the corresponding switching form and definition of normal vias as well.

In this way, the positions of the conductive vias and the preset switching directions of different repair units all maintain the above symmetry relationship, such that the chip stack structure subsequently formed can realize a rotation-type transmission of signals through the direct connection configuration, which is detailed in the following description.

In a second specific embodiment, referring to FIG. 7, B = 6, and b is 0, 1, 2, 3, 4, or 5. In this case, the conductive via groups 0-5 in each signal zone in the same channel signal region form four repair unit groups separately:
The six conductive via groups in each signal zone are respectively referred to as conductive via groups 0-5, conductive via groups b in all the signal zones form a whole symmetrical about the first axis AA' and symmetrical about the second axis BB', and b ≤ 5. That is, the conductive via group 0 in the first signal zone 21, the conductive via group 0 in the second signal zone 22, the conductive via group 0 in the third signal zone 23, and the conductive via group 0 in the fourth signal zone 24 form a whole symmetrical about the first axis AA' and symmetrical about the second axis BB'; the conductive via group 1 in the first signal zone 21, the conductive via group 1 in the second signal zone 22, the conductive via group 1 in the third signal zone 23, and the conductive via group 1 in the fourth signal zone 24 form a whole symmetrical about the first axis AA' and symmetrical about the second axis BB', ..., and so on.

The conductive via groups 0-5 in each signal zone in the same channel signal region form four repair unit groups separately.

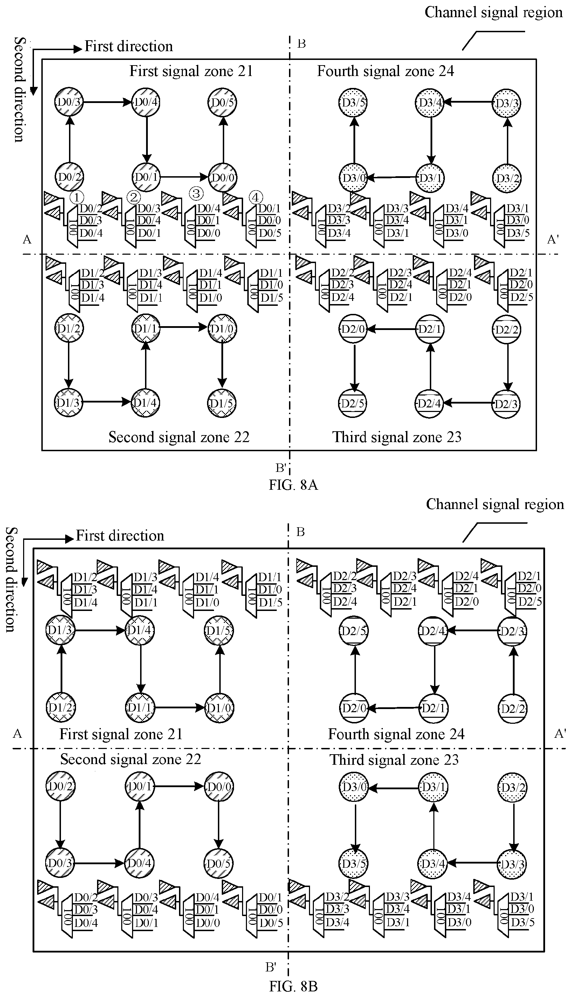

Referring to FIG. 8A, for the first repair unit group_A: (1) the first repair unit_A includes respective first conductive vias of the conductive via groups 0-5 in the first signal zone 21, i.e., D0/0, D0/1, D0/2, D0/3, D0/4, and D0/5 in the first signal zone 21; (2) the second repair unit_A includes respective second conductive vias of the conductive via groups 0-5 in the second signal zone 22, i.e., D1/0, D1/1, D1/2, D1/3, D1/4, and D1/5 in the second signal zone 22; (3) the third repair unit_A includes respective third conductive vias of the conductive via groups 0-5 in the third signal zone 23, i.e., D2/0, D2/1, D2/2, D2/3, D2/4, and D2/5 in the third signal zone 23; and (4) the fourth repair unit_A includes respective fourth conductive vias of the conductive via groups 0-5 in the fourth signal zone 24, i.e., D3/0, D3/1, D3/2, D3/3, D3/4, and D3/5 in the fourth signal zone 24.

Referring to FIG. 8B, for the second repair unit group_B, (1) the first repair unit_B includes respective first conductive vias of the conductive via groups 0-5 in the second signal zone 22, i.e., D0/0, D0/1, D0/2, D0/3, D0/4, and D0/5 in the second signal zone 22; (2) the second repair unit_B includes respective second conductive vias of the conductive via groups 0-5 in the first signal zone 21, i.e., D1/0, D1/1, D1/2, D1/3, D1/4, and D1/5 in the first signal zone 21; (3) the third repair unit_B includes respective third conductive vias of the conductive via groups 0-5 in the fourth signal zone 24, i.e., D2/0, D2/1, D2/2, D2/3, D2/4, and D2/5 in the fourth signal zone 24; and (4) the fourth repair unit_B includes respective fourth conductive vias of the conductive via groups 0-5 in the third signal zone 23, i.e., D3/0, D3/1, D3/2, D3/3, D3/4, and D3/5 in the third signal zone 23.

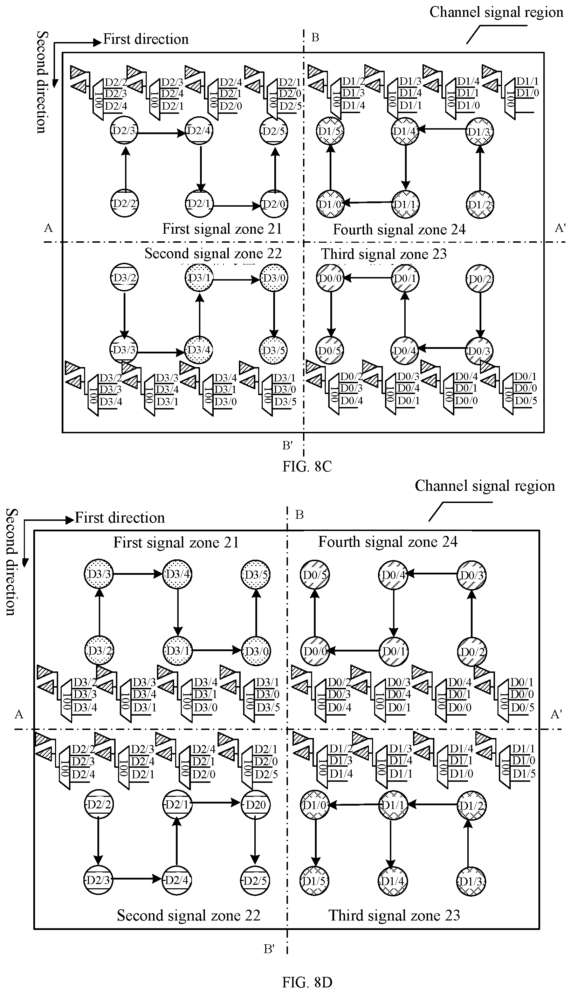

Referring to FIG. 8C, for the third repair unit group_C, the first repair unit_C includes respective first conductive vias of the conductive via groups 0-5 in the third signal zone 23, i.e., D0/0, D0/1, D0/2, D0/3, D0/4, and D0/5 in the third signal zone 23; (2) the second repair unit_C includes respective second conductive vias of the conductive via groups 0-5 in the fourth signal zone 24, i.e., D1/0, D1/1, D1/2, D1/3, D1/4, and D1/5 in the fourth signal zone 24; (3) the third repair unit_C includes respective third conductive vias of the conductive via groups 0-5 in the first signal zone 21, i.e., D2/0, D2/1, D2/2, D2/3, D2/4, and D2/5 in the first signal zone 21; and (4) the fourth repair unit_C includes respective fourth conductive vias of the conductive via groups 0-5 in the second signal zone 22, i.e., D3/0, D3/1, D3/2, D3/3, D3/4, and D3/5 in the second signal zone 22.

Referring to FIG. 8D, for the fourth repair unit group _D, the first repair unit includes respective first conductive vias of the conductive via groups 0-5 in the fourth signal zone 24, i.e., D0/0, D0/1, D0/2, D0/3, D0/4, and D0/5 in the fourth signal zone 24; (2) the second repair unit_D includes respective second conductive vias of the conductive via groups 0-5 in the third signal zone 23, i.e., D1/0, D1/1, D1/2, D1/3, D1/4, and D1/5 in the third signal zone 23; (3) the fourth repair unit_D includes respective third conductive vias of the conductive via groups 0-5 in the second signal zone 22, i.e., D2/0, D2/1, D2/2, D2/3, D2/4, and D2/5 in the second signal zone 22; and the fourth repair unit_D includes respective fourth conductive vias of the conductive via groups 0-5 in the first signal zone 21, i.e., D3/0, D3/1, D3/2, D3/3, D3/4, and D3/5 in the first signal zone 21.

It should be noted that, as shown in FIG. 8A, the first repair unit_A (D0/0, D0/1, D0/2, D0/3, D0/4, and D0/5 in the first signal zone 21) and the second repair unit_A (D1/0, D1/1, D1/2, D1/3, D1/4, and D1/5 in the second signal zone 22) are arranged symmetrically about the first axis AA', the fourth repair unit_A (D3/0, D3/1, D3/2, D3/3, D3/4, and D3/5 in the fourth signal zone 24) and the third repair unit_A (D2/0, D2/1, D2/2, D2/3, D2/4, and D2/5 in the third signal zone 23) are arranged symmetrically about the first axis AA', the first repair unit_A (D0/0, D0/1, D0/2, D0/3, D0/4, and D0/5 in the first signal zone 21) and the fourth repair unit_A (D3/0, D3/1, D3/2, D3/3, D3/4, and D3/5 in the fourth signal zone 24) are arranged symmetrically about the second axis BB', and the second repair unit_A (D1/0, D1/1, D1/2, D1/3, D1/4, and D1/5 in the second signal zone 22) and the third repair unit_A (D2/0, D2/1, D2/2, D2/3, D2/4, and D2/5 in the third signal zone 23) are arranged symmetrically about the second axis BB'. Meanwhile, the second to fourth repair unit groups also have similar characteristics.

An example of the preset switching direction is provided below to better understand the foregoing description, but the following example is not the only solution.

Assuming that the conductive vias in the conductive via groups 2 of all the signal zones are normal conductive vias, the preset switching direction of the conductive vias in an X^{th} repair unit is set such that an X^{th} conductive via in the conductive via group 2 is allowed to switch to an X^{th} conductive via in the conductive via group 3 in the same signal zone, the X^{th} conductive via in the conductive via group 3 is allowed to switch to an X^{th} conductive via in the conductive via group 4 in the same signal zone, the X^{th} conductive via in the conductive via group 4 is allowed to switch to an X^{th} conductive via in the conductive via group 1 in the same signal zone, the X^{th} conductive via in the conductive via group 1 is allowed to switch to an X^{th} conductive via in the conductive via group 0 in the same signal zone, and the X^{th} conductive via in the conductive via group 0 is allowed to switch to an X^{th} conductive via in the conductive via group 5 in the same signal zone.

Referring to FIG. 8A, the preset switching direction of the first repair unit group _A is described as follows:
(a) the preset switching direction of the conductive vias in the first repair unit_A is set to D0/2-D0/3-D0/4-D0/1-D0/0-D0/5 in the first signal zone 21; (b) the preset switching direction of the conductive vias in the second repair unit_A is set to D1/2-D1/3-D1/4-D1/1-D1/0-D1/5 in the second signal zone 22; (c) the preset switching direction of the conductive vias in the third repair unit_A is set to D2/2-D2/3-D2/4-D2/1-D2/0-D2/5 in the third signal zone 23; and (d) the preset switching direction of the conductive vias in the fourth repair unit_A is set to D3/2-D3/3-D3/4-D3/1-D3/0-D3/5 in the fourth signal zone 24.

Referring to FIG. 8B, the preset switching direction of the second repair unit group_B is described as follows:
(a) the preset switching direction of the conductive vias in the first repair unit_B is set to D0/2-D0/3-D0/4-D0/1-D0/0-D0/5 in the second signal zone 22; (b) the preset switching direction of the conductive vias in the second repair unit_B is set to D1/2-D1/3-D1/4-D1/1-D1/0-D1/5 in the first signal zone 21; (c) the preset switching direction of the conductive vias in the third repair unit_B is set to D2/2-D2/3-D2/4-D2/1-D2/0-D2/5 in the fourth signal zone 24; and (d) the preset switching direction of the conductive vias in the fourth repair unit_B is set to D3/2-D3/3-D3/4-D3/1-D3/0-D3/5 in the third signal zone 23.

Referring to FIG. 8C, the preset switching direction of the third repair unit group_C is described as follows:
(a) the preset switching direction of the conductive vias in the first repair unit_C is set to D0/2-D0/3-D0/4-D0/1-D0/0-D0/5 in the third signal zone 23; (b) the preset switching direction of the conductive vias in the second repair unit_C is set to D1/2-D1/3-D1/4-D1/1-D1/0-D1/5 in the fourth signal zone 24; (c) the preset switching direction of the conductive vias in the second repair unit_C is set to D2/2-D2/3-D2/4-D2/1-D2/0-D2/5 in the first signal zone 21; and (d) the preset switching direction of the conductive vias in the fourth repair unit_C is set to D3/2-D3/3-D3/4-D3/1-D3/0-D3/5 in the second signal zone 22.

Referring to FIG. 8D, the preset switching direction of the fourth repair unit group_C is described as follows:
(a) the preset switching direction of the conductive vias in the first repair unit_D is set to D0/2-D0/3-D0/4-D0/1-D0/0-D0/5 in the fourth signal zone 24; (b) the preset switching direction of the conductive vias in the second repair unit_D is set to D1/2-D1/3-D1/4-D1/1-D1/0-D1/5 in the third signal zone 23; (c) the preset switching direction of the conductive vias in the second repair unit_D is set to D2/2-D2/3-D2/4-D2/1-D2/0-D2/5 in the second signal zone 22; and (d) the preset switching direction of the conductive vias in the fourth repair unit_D is set to D3/2-D3/3-D3/4-D3/1-D3/0-D3/5 in the first signal zone 21.

The following provides a specific description of a signal switching-related circuit in which a repair ratio of the number of normal conductive vias:the number of redundant conductive vias is illustratively 4:2. Take the first repair unit_A (D0/0, D0/1, D0/2, D0/3, D0/4, and D0/5 of the first signal zone 21) of the first repair unit group as an example, referring to FIG. 8A, D0/2, D0/3, and D0/4 are connected to a first signal select circuit 100, and the first signal select circuit 100 connects D0/2 to the internal circuit of the logic circuit 10; D0/3, D0/4, and D0/1 are connected to a second signal select circuit 100, and the second signal select circuit 100 connects D0/3 to the internal circuit of the logic circuit 10; D0/4, D0/1, and D0/0 are connected to a third signal select circuit 100, and the third signal select circuit 100 connects D0/3 to the internal circuit of the logic circuit 10; D0/1, D0/0, and D0/5 are connected to a fourth signal select circuit 100, and the fourth signal select circuit 100 connects D0/1 to the internal circuit of the logic circuit 10. Then, if D0/2 is damaged, the first signal select circuit 100 connects D0/3 to the internal circuit of the logic circuit 10, i.e., the signal originally transmitted by D0/2 will be transmitted by D0/3; the second signal select circuit 100 connects D0/4 to the internal circuit of the logic circuit 10, i.e., the signal originally transmitted by D0/3 will be transmitted by D0/4; the third signal select circuit 100 connects D0/1 to the internal circuit of the logic circuit 10, i.e., the signal originally transmitted by D0/4 will be transmitted by D0/1; the fourth signal select circuit 100 connects D0/0 to the internal circuit of the logic circuit 10, i.e., the signal originally transmitted by D0/4 will be transmitted by D0/0. The other repair units can be similarly understood.

Similarly, FIG. 8A to FIG. 8D are only an example of the preset switching direction; the preset switching direction can also be selected flexibly.

It should be further noted that, in the foregoing example, in each signal zone, the conductive via group 0, the conductive via group 1, and the conductive via group 2 are aligned along the first direction; the conductive via group 3, the conductive via group 4, and the conductive via group 5 are aligned along the first direction, the conductive via group 2 and the conductive via group 3 are aligned along the second direction, the conductive via group 1 and the conductive via group 4 are aligned along the second direction, and the conductive via group 0 and the conductive via group 5 are aligned along the second direction. However, this is only an example, and the via groups 1-5 may be located at any positions of the same signal zone, separately.

In this way, the positions of the conductive vias and the preset switching directions of different repair units all maintain the above symmetry relationship, such that the chip stack structure subsequently formed can realize a rotation-type transmission of signals through the direct connection configuration, which is detailed in the following description.

It should be noted that for the same logic chip, the repair units shown in FIG. 5 may be adopted, or the repair units shown in FIG. 7 may be adopted, or the repair units shown in both FIG. 5 and FIG. 7 are adopted, or more types of repair units are included.

It should be further noted that the conductive via mentioned above can at least be embodied as a through-silicon-via (TSV), specifically a vertical interconnection structure penetrating through a silicon wafer/memory chip, such as type 1 in FIG. 1. Of course, the conductive via may also be type 2 in FIG. 1, which enables signal transmission together with a contact structure. In other embodiments, other electrical connection structures may be used as the conductive vias.

The conductive vias may be prepared via one or more of the following processes: a via-first process, a via-middle process, a via-last process, and a back side via-last process. The via-first process refers to a via process method in which a via structure is manufactured before a device structure, such as a metal oxide semiconductor field effect transistor (MOSFET, or MOS transistor), is manufactured. The via-middle process refers to a via process in which a via structure is formed during the manufacturing process in the process flow, often after a device is formed and before a stack is manufactured. The via-last process refers to a manufacturing process in which vias are formed at the front side of a wafer after a back end of line (BEOL) process is completed. The back side via-last process refers to a manufacturing process in which a via structure is formed at the back side of a wafer after a BEOL process is completed. That is, the via-first process may refer to first manufacturing vias and then manufacturing a circuit; the via-middle process may refer to first manufacturing a circuit and a portion of metal layers, then manufacturing vias, and finally manufacturing the remaining vias; the via-last process and the back side via-last process may refer to first manufacturing a circuit and metal layers and then manufacturing vias.

In summary, the embodiment of the present disclosure provides a logic chip, where the repair unit groups, the normal conductive vias, and the preset switching directions in each channel signal region are of special symmetry, such that the logic chip can be directly applied to a face-to-face stack structure without using two sets of masks or two sets of vias. The chip stack structure formed by the logic chip and memory chips (which also have the characteristics) realizes a rotation-type transmission of signals through the direct connection configuration of the conductive vias with small parasitic resistance and parasitic capacitance. Meanwhile, through the symmetrically arranged repair units, a redundancy repair function of the above structure can be realized, which improves the stability of the memory chips.

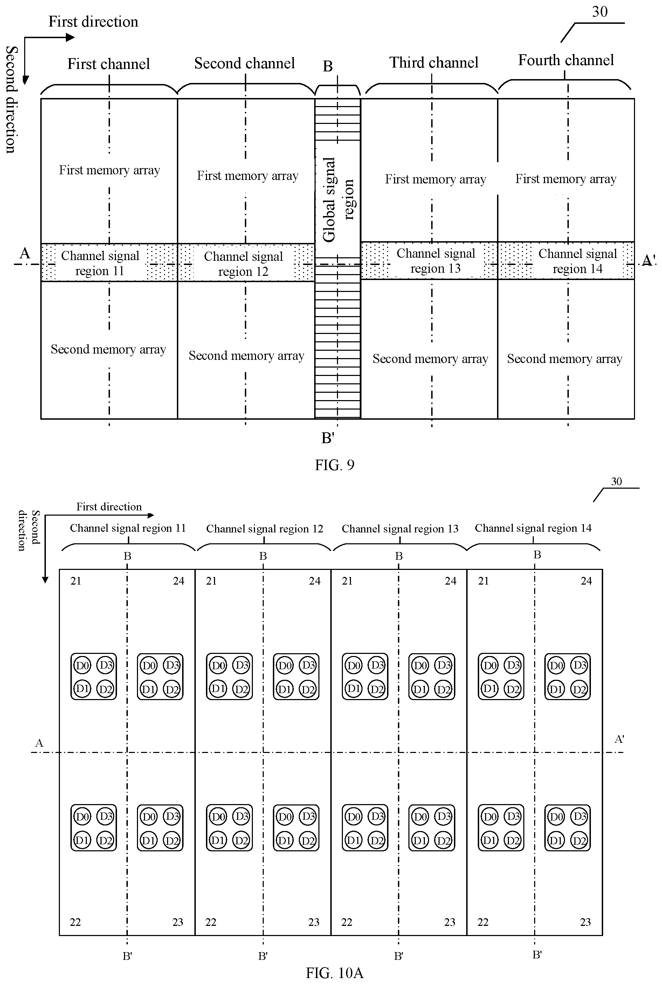

In another embodiment of the present disclosure, referring to FIG. 9, a schematic structural diagram of a memory chip 30 provided according to an embodiment of the present disclosure is shown, and it can be specifically understood as a schematic sectional diagram of an active surface. As shown in FIG. 9, the memory chip 30 includes m channels (FIG. 9 is illustrated with m = 4) sequentially arranged along the first direction, the memory chip 30 has a chip axis YY' extending along the second direction and passing through a center of the memory chip, and the m channels are arranged symmetrically about the chip axis YY'; each channel includes a first memory array region, a channel signal region, and a second memory array region that are sequentially arranged along the second direction, and a center of each channel signal region is coincident with a center of a corresponding channel thereof. Here, the area of the channel signal region in the logic chip 10 is the same as the area of the channel signal region in the memory chip 30. In particular, the area of the active surface of the logic chip 10 may be the same as the area of the active surface of the memory chip 30, or the area of the active surface of the logic chip 10 may be larger than the area of the active surface of the memory chip 30.

It should be noted that, in the chip manufacturing process, to distinguish different channels of the chip, a positioning structure may be manufactured in a reference channel (for example, the first channel) of the memory chip 30, such that during subsequent packaging, the position of the reference channel is identified by the positioning structure, and other channels are identified based on the orientation of the active surface of the chip.

FIG. 9 is illustrated with m = 4, and the description is given below with m = 4, but m can be any positive integer. Specifically, if m is an even number, m/2 channels are located at one side of the global signal region along the first direction, and the remaining m/2 channels are located at the other side of the global signal region along the first direction; if m is an odd number, an (m+1)^{th}/2 channel needs to be divided into two parts that are respectively located at two sides of the global signal region along the first direction, while other (m-1)/2 channels are located at one side of the global signal region along the first direction, and the remaining (m-1)/2 channels are located at the other side of the global signal region along the first direction.

FIG. 9 can be regarded as a sectional view of the active surface of the memory chip 30. As shown in FIG. 9, the center of the active surface of the memory chip 30 and the vicinity thereof are defined as a global signal region. In this case, the first channel, the second channel, the global signal region, the third channel, and the fourth channel are sequentially arranged along the first direction. The signal transmitted by the global signal region is commonly used by m channels of the memory chip; the signal transmitted by each channel signal region is only used by the corresponding channel thereof.

Referring to FIG. 10A, a schematic diagram of a channel signal region 11 of the first channel, a channel signal region 12 of the second channel, a channel signal region 13 of the third channel, and a channel signal region 14 of the fourth channel is specifically shown. In FIG. 10A, the global signal region is omitted.

As shown in FIG. 10A, each channel signal region has a first axis AA' and a second axis BB', the first axis AA' extends along the first direction or along the second direction, and the second axis BB' and the first axis AA' are perpendicular to each other and intersect at a center of a corresponding channel signal region thereof. FIG. 10A illustrates an example where the first axis AA' extends along the first direction, and other situations can be understood adaptively.

Due to the limited space, the following drawings only use one channel signal region as an example to illustrate the composition and principle of the repair unit group, but in fact, the structures of all the channel signal regions are the same, i.e., the channel signal region in the drawings may be understood as any one of the channel signal region 11, the channel signal region 12, the channel signal region 13, and the channel signal region 14.

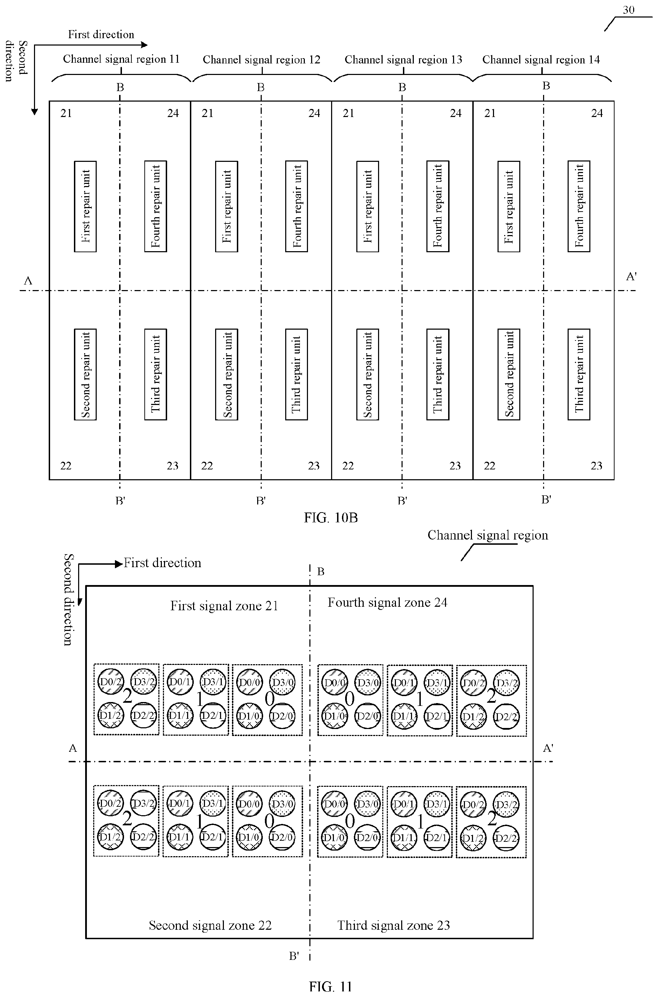

Referring to FIG. 10A, each channel signal region includes a first axis AA' and a second axis BB', the first axis AA' is parallel to the first side of the memory chip, and the first axis AA' and the second axis BB' are perpendicular to each other and intersect at a center point of a corresponding channel signal region thereof. In FIG. 11, the first axis AA' extends along the first direction and the second axis BB' extends along the second direction, but this is only an example and not a specific limitation. As shown in FIG. 10A, each channel signal region is penetrated through by a plurality of conductive vias along the third direction, the first direction and the second direction are parallel to a top surface of the memory chip 30, and the third direction is perpendicular to the top surface of the memory chip 30.

The memory chip 30 also has a structure similar to the repair units in the logic chip 10 described above, which will be described in detail below.

Referring to FIG. 10B, for each channel signal region, the plurality of conductive vias therein are divided into a plurality of repair unit groups. Each repair unit group includes a first repair unit, a second repair unit, a third repair unit, and a fourth repair unit; the first repair unit and the second repair unit are arranged symmetrically about the first axis AA' of a corresponding channel signal region thereof, the third repair unit and the fourth repair unit are arranged symmetrically about the first axis AA' of a corresponding channel signal region thereof, and the first repair unit and the fourth repair unit are arranged symmetrically about the second axis BB' of a corresponding channel signal region thereof.

Each repair unit includes at least one redundant conductive via and at least one normal conductive via, and in the case that any normal conductive via is damaged, an effective signal transmitted by the normal conductive via is switched to a next conductive via in the same repair unit along a preset switching direction. The normal conductive via in the first repair unit and the normal conductive via in the second repair unit are in one-to-one correspondence and are arranged symmetrically about the first axis AA' of a corresponding channel signal region thereof, the normal conductive via in the third repair unit and the normal conductive via in the fourth repair unit are in one-to-one correspondence and are arranged symmetrically about the first axis AA' of a corresponding channel signal region thereof, and the normal conductive via in the first repair unit and the normal conductive via in the fourth repair unit are in one-to-one correspondence and are arranged symmetrically about the second axis BB' of a corresponding channel signal region thereof.

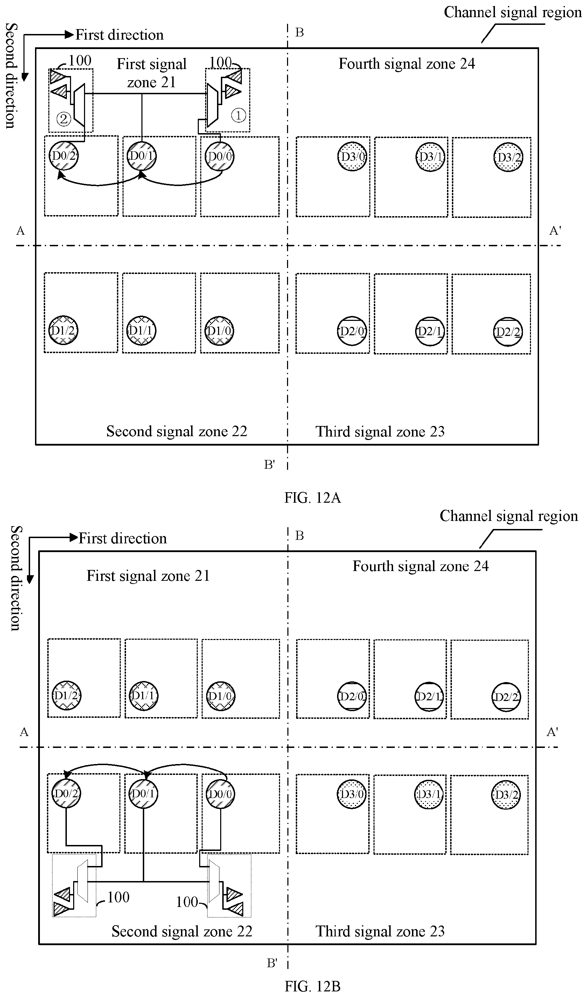

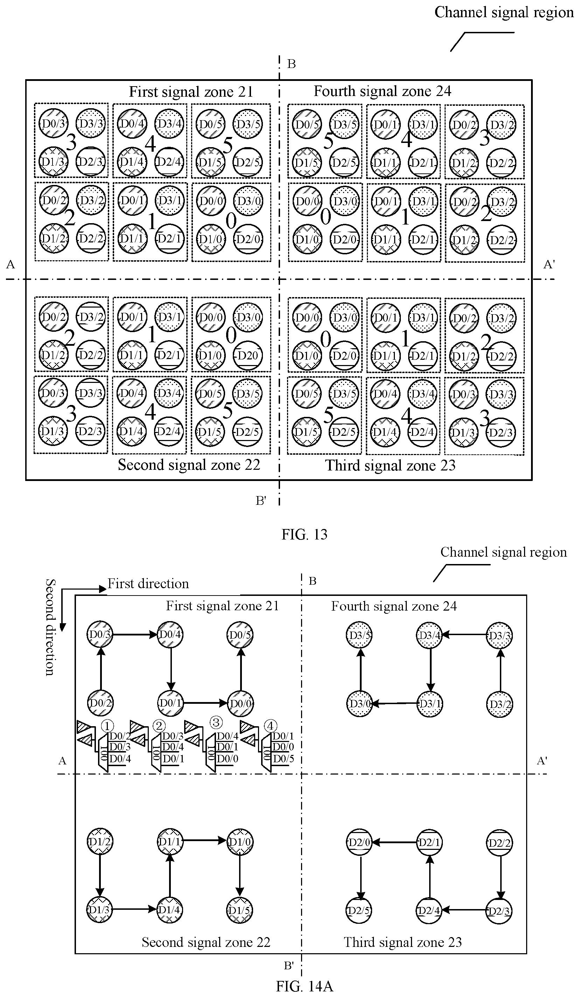

In particular, for the logic chip 10, the normal conductive via in each repair unit is electrically connected to the internal circuit of the logic chip 10. In other words, referring to FIG. 6A to FIG. 6D and FIG. 8A to FIG. 8D, each repair unit is connected to the corresponding signal select circuit 100, and any conductive via therein is electrically connected to the inside of the logic chip in the case that the conductive via is selected as a normal conductive via. However, for the memory chip 30, only the conductive via in the first repair unit is electrically connected to the internal circuit of the memory chip 30 when used for transmitting an effective signal, that is, only the normal conductive via in the first repair unit is electrically connected to the internal circuit of the memory chip 30. Illustratively, referring to the subsequent FIG. 12A to FIG. 12D or FIG. 14A to FIG. 14D, only the first repair unit is connected to the corresponding signal select circuit 100, such that the conductive via in the first repair unit is electrically connected to the inside of the logic chip in the case that the conductive via is selected as a normal conductive via; all the conductive vias in the remaining second to fourth repair units are completely independent from the internal circuit of the memory chip 30 and are not electrically connected to the inside of the memory chip 30 even in the case that the conductive vias are selected as normal conductive vias.

In an implementation of the present disclosure, for each repair unit group, the preset switching direction of the conductive vias in the first repair unit and the preset switching direction of the conductive vias in the second repair unit are arranged symmetrically about the first axis AA' of a corresponding channel signal region thereof; the preset switching direction of the conductive vias in the third repair unit and the preset switching direction of the conductive vias in the fourth repair unit are arranged symmetrically about the first axis AA' of a corresponding channel signal region thereof; the preset switching direction of the conductive vias in the first repair unit and the preset switching direction of the conductive vias in the fourth repair unit are arranged symmetrically about the second axis BB' of a corresponding channel signal region thereof; the preset switching direction of the conductive vias in the second repair unit and the preset switching direction of the conductive vias in the third repair unit are arranged symmetrically about the second axis BB' of a corresponding channel signal region thereof.

In some embodiments, referring to FIG. 10A, each channel signal region is divided into 2×2 signal zones, the conductive vias of each signal zone are divided into n conductive via groups with the same arrangement manner, and n is a positive integer; the conductive via groups in a first signal zone 21 and the conductive via groups in a second signal zone 22 are in one-to-one correspondence and are arranged symmetrically about the first axis AA', the conductive via groups in a third signal zone 23 and the conductive via groups in a fourth signal zone 24 are in one-to-one correspondence and are arranged symmetrically about the first axis AA', and the conductive via groups in the first signal zone 21 and the conductive via groups in the fourth signal zone 24 are in one-to-one correspondence and are arranged symmetrically about the second axis BB'; each conductive via group includes a first conductive via D0, a second conductive via D1, a third conductive via D2, and a fourth conductive via D3 that are arranged in a 2×2 array.

The conductive vias in each signal zone have the following characteristics:
(1) in the same channel signal region, the first conductive via D0 in one conductive via group in the first signal zone 21, the second conductive via D1 in a corresponding conductive via group in the second signal zone 22, the third conductive via D2 in a corresponding conductive via group in the third signal zone 23, and the fourth conductive via D3 in a corresponding conductive via group in the fourth signal zone 24 form a whole symmetrical about the first axis AA' and symmetrical about the second axis BB';
(2) in the same channel signal region, the second conductive via D1 in one conductive via group in the first signal zone 21, the first conductive via D0 in a corresponding conductive via group in the second signal zone 22, the fourth conductive via D3 in a corresponding conductive via group in the third signal zone 23, and the third conductive via D2 in a corresponding conductive via group in the fourth signal zone 24 form a whole symmetrical about the first axis AA' and symmetrical about the second axis BB';
(3) in the same channel signal region, the third conductive via D2 in one conductive via group in the first signal zone 21, the fourth conductive via D3 in a corresponding conductive via group in the second signal zone 22, the first conductive via D0 in a corresponding conductive via group in the third signal zone 23, and the second conductive via D1 in a corresponding conductive via group in the fourth signal zone 24 form a whole symmetrical about the first axis AA' and symmetrical about the second axis BB';
(4) in the same channel signal region, the fourth conductive via D3 in one conductive via group in the first signal zone 21, the third conductive via D2 in a corresponding conductive via group in the second signal zone 22, the second conductive via D1 in a corresponding conductive via group in the third signal zone 23, and the first conductive via D0 in a corresponding conductive via group in the fourth signal zone 24 form a whole symmetrical about the first axis AA' and symmetrical about the second axis BB'.

It should be understood that in FIG. 10A, the four conductive vias in each conductive via group are arranged in a 2×2 array, but in other embodiments, the four conductive vias in each conductive via group may be arranged arbitrarily, as long as the above symmetry principle is observed.

For better understanding, the following drawings only use one channel signal region as an example to illustrate the composition and principle of the repair unit group, but in particular, all the channel signal regions use the same structure, i.e., the channel signal region in the drawings may be understood as any one of the channel signal region 11, the channel signal region 12, the channel signal region 13, and the channel signal region 14.

In some embodiments, B conductive via groups in each signal zone are referred to as one conductive via combination, conductive via groups b in the corresponding conductive via combinations in all the signal zones form a whole symmetrical about the first axis AA' and symmetrical about the second axis BB', B is a positive integer less than or equal to n, and b is a natural number less than B.

Corresponding conductive via combinations in all of the signal zones in the same channel signal region form four repair unit groups in total:
(1) for a first repair unit group, the first repair unit includes respective first conductive vias D0 of all the conductive via groups in the conductive via combination in the first signal zone 21, the second repair unit includes respective second conductive vias D1 of all the conductive via groups in the conductive via combination in the second signal zone 22, the third repair unit includes respective third conductive vias D2 of all the conductive via groups in the conductive via combination in the third signal zone 23, and the fourth repair unit includes respective fourth conductive vias D3 of all the conductive via groups in the conductive via combination in the fourth signal zone 24;
(2) for a second repair unit group, the first repair unit includes respective first conductive vias D0 of all the conductive via groups in the conductive via combination in the second signal zone 22, the second repair unit includes respective second conductive vias D1 of all the conductive via groups in the conductive via combination in the first signal zone 21, the third repair unit includes respective third conductive vias D2 of all the conductive via groups in the conductive via combination in the fourth signal zone 24, and the fourth repair unit includes respective fourth conductive vias D3 of all the conductive via groups in the conductive via combination in the third signal zone 23;
(3) for a third repair unit group, the first repair unit includes respective first conductive vias D0 of all the conductive via groups in the conductive via combination in the third signal zone 23, the second repair unit includes respective second conductive vias D1 of all the conductive via groups in the conductive via combination in the fourth signal zone 24, the third repair unit includes respective third conductive vias D2 of all the conductive via groups in the conductive via combination in the first signal zone 21, and the fourth repair unit includes respective fourth conductive vias D3 of all the conductive via groups in the conductive via combination in the second signal zone 22;
(4) for a fourth repair unit group, the first repair unit includes respective first conductive vias D0 of all the conductive via groups in the conductive via combination in the fourth signal zone 24, the second repair unit includes respective second conductive vias D1 of all the conductive via groups in the conductive via combination in the third signal zone 23, the third repair unit includes respective third conductive vias D2 of all the conductive via groups in the conductive via combination in the second signal zone 22, and the fourth repair unit includes respective fourth conductive vias D3 of all the conductive via groups in the conductive via combination in the first signal zone 21.

It should be noted that, for the same logic chip 10, B may have multiple values. For example, in the same logic chip 10, there is not only a conductive via combination composed of four conductive via groups, but also a conductive via combination composed of six conductive via groups, or conductive via combinations in more forms. However, no matter how many conductive via groups are included, each conductive via combination necessarily forms four repair unit groups.

In a first specific embodiment, referring to FIG. 11, B = 3, and b is 0, 1, or 2. In this case, the conductive via groups 0-2 in each signal zone in the same channel signal region form four repair unit groups separately:
Referring to FIG. 12A, for a first repair unit group_1: (1) the first repair unit_1 includes respective first conductive vias of the conductive via group 0, the conductive via group 1, and the conductive via group 2 in the first signal zone 21, i.e., D0/0, D0/1, and D0/2 in the first signal zone 21; (2) the second repair unit_1 includes respective second conductive vias of the conductive via group 0, the conductive via group 1, and the conductive via group 2 in the second signal zone 22, i.e., D1/0, D1/1, and D1/2 in the second signal zone 22; (3) the third repair unit_1 includes respective third conductive vias of the conductive via group 0, the conductive via group 1, and the conductive via group 2 in the third signal zone 23, i.e., D2/0, D2/1, and D2/2 in the third signal zone 23; and (4) the fourth repair unit_1 includes respective fourth conductive vias of the conductive via group 0, the conductive via group 1, and the conductive via group 2 in the fourth signal zone 24, i.e., D3/0, D3/1, and D3/2 in the fourth signal zone 24.

Referring to FIG. 12B, for the second repair unit group_2, (1) the first repair unit_2 includes respective first conductive vias of the conductive via group 0, the conductive via group 1, and the conductive via group 2 in the second signal zone 22, i.e., D0/0, D0/1, and D0/2 in the second signal zone 22; (2) the second repair unit_2 includes respective second conductive vias of the conductive via group 0, the conductive via group 1, and the conductive via group 2 in the first signal zone 21, i.e., D1/0, D1/1, and D1/2 in the first signal zone 21; (3) the third repair unit_2 includes respective third conductive vias of the conductive via group 0, the conductive via group 1, and the conductive via group 2 in the fourth signal zone 24, i.e., D2/0, D2/1, and D2/2 in the fourth signal zone 24; and (4) the fourth repair unit_2 includes respective fourth conductive vias of the conductive via group 0, the conductive via group 1, and the conductive via group 2 in the third signal zone 23, i.e., D3/0, D3/1, and D3/2 in the third signal zone 23.

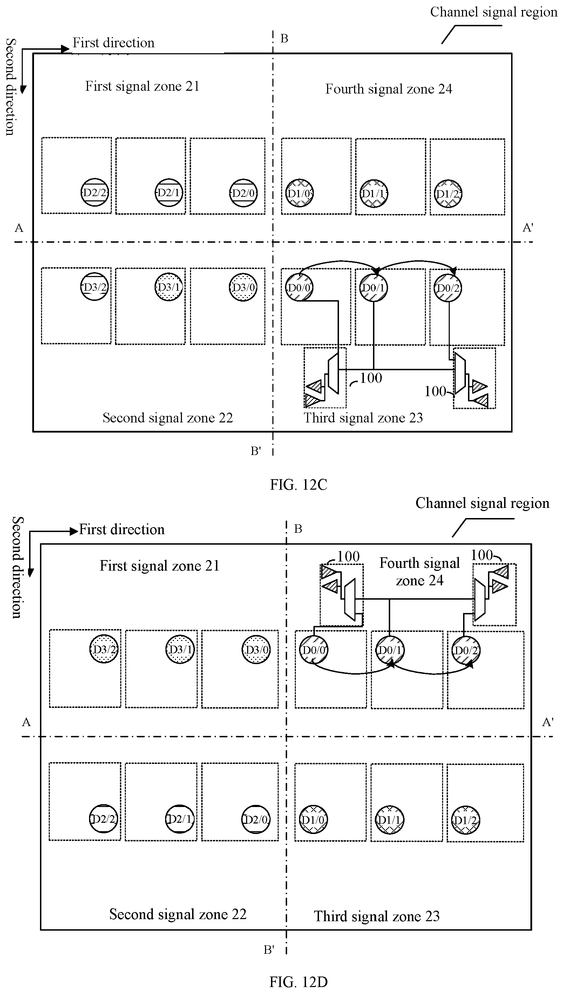

Referring to FIG. 12C, for the third repair unit group_3, (1) the first repair unit_3 includes respective first conductive vias of the conductive via group 0, the conductive via group 1, and the conductive via group 2 in the third signal zone 23, i.e., D0/0, D0/1, and D0/2 in the third signal zone 23; (2) the second repair unit_3 includes respective second conductive vias of the conductive via group 0, the conductive via group 1, and the conductive via group 2 in the fourth signal zone 24, i.e., D1/0, D1/1, and D1/2 in the fourth signal zone 24; (3) the third repair unit_3 includes respective third conductive vias of the conductive via group 0, the conductive via group 1, and the conductive via group 2 in the first signal zone 21, i.e., D2/0, D2/1, and D2/2 in the first signal zone 21; and (4) the fourth repair unit_3 includes respective fourth conductive vias of the conductive via group 0, the conductive via group 1, and the conductive via group 2 in the second signal zone 22, i.e., D3/0, D3/1, and D3/2 in the second signal zone 22.

Referring to FIG. 12D, for the fourth repair unit group_4, (1) the first repair unit_4 includes respective first conductive vias of the conductive via group 0, the conductive via group 1, and the conductive via group 2 in the fourth signal zone 24, i.e., D0/0, D0/1, and D0/2 in the fourth signal zone 24; (2) the second repair unit_4 includes respective second conductive vias of the conductive via group 0, the conductive via group 1, and the conductive via group 2 in the third signal zone 23, i.e., D2/0, D2/1, and D2/2 in the third signal zone 23; (3) the third repair unit_4 includes respective third conductive vias of the conductive via group 0, the conductive via group 1, and the conductive via group 2 in the second signal zone 22, i.e., D2/0, D2/1, and D2/2 in the second signal zone 22; and (4) the fourth repair unit_4 includes respective fourth conductive vias of the conductive via group 0, the conductive via group 1, and the conductive via group 2 in the first signal zone 21, i.e., D3/0, D3/1, and D3/2 in the first signal zone 21.

An example of the preset switching direction is provided below to better understand the foregoing description, but the following example is not the only solution.

In some embodiments, referring to FIG. 11, the conductive vias in the conductive via group 0 are all normal conductive vias. As mentioned above, only the normal conductive vias in the first repair unit will access the inside of the memory chip, and therefore, the preset switching direction of the conductive vias in any first repair unit is set such that a first conductive via in the conductive via group 0 is allowed to switch to a first conductive via in the conductive via group 1 in the same signal zone, and the first conductive via in the conductive via group 1 is allowed to switch to a first conductive via in the conductive via group 2 in the same signal zone.

That is, referring to FIG. 12A, for the first repair unit group, the preset switching direction of the conductive vias in the first repair unit_1 is set to D0/0-D0/1-D0/2 in the first signal zone 21; referring to FIG. 12B, for the second repair unit group, the preset switching direction of the conductive vias in the first repair unit_2 is set to D0/0-D0/1-D0/2 in the second signal zone 22; referring to FIG. 12C, for the third repair unit group, the preset switching direction of the conductive vias in the first repair unit_3 is set to D0/0-D0/1-D0/2 in the third signal zone 23; referring to FIG. 12D, for the fourth repair unit group, the preset switching direction of the conductive vias in the first repair unit_4 is set to D0/0-D0/1-D0/2 in the fourth signal zone 24.

For ease of understanding, the following provides a specific description of a signal switching-related circuit in which a repair ratio of the number of normal conductive vias:the number of redundant conductive vias is illustratively 2:1.

To implement the above switching process, referring to FIG. 12A to FIG. 12D, the memory chip 30 further includes a plurality of signal select circuits 100 for implementing the above switching of the conductive vias. Take the first repair unit_1 of the first repair unit group as an example, referring to FIG. 12A, D0/0 and D0/1 are connected to a first signal select circuit 100, and the first signal select circuit 100 connects D0/0 to the internal circuit of the logic circuit 10; D0/1 and D0/2 are connected to a second signal select circuit 100, and the second signal select circuit 100 connects D0/1 to the internal circuit of the logic circuit 10. Then, if D0/0 is damaged, the first signal select circuit 100 connects D0/1 to the internal circuit of the logic circuit 10, i.e., the signal originally transmitted by D0/0 will be transmitted by D0/1; the second signal select circuit 100 connects D0/2 to the internal circuit of the logic circuit 10, i.e., the signal originally transmitted by D0/1 will be transmitted by D0/2. However, for the second to fourth repair units, the signal select circuit 100 is not provided, and the conductive vias in the second to fourth repair units do not access the memory chip 30 regardless of whether they are used as normal conductive vias or redundant conductive vias. Therefore, the switching of the conductive vias for transmitting signals in the repair units of the memory chip only comes with the switching of the conductive vias for transmitting signals in the logic chip 10, an it is actually imperceptible to the memory chip 30. Therefore, only the preset switching direction of the first repair unit is emphasized in this embodiment.

The other repair units can be similarly understood.

It should be noted that FIG. 12A to FIG. 12D are only an example of the preset switching direction; the preset switching direction can actually be selected flexibly. Take the first repair unit_1 as an example, currently the switching may be sequentially along D0/0, D0/1, D0/2, or along D0/2, D0/1, D0/0, or the switching may be performed with D0/1 as a switching start point, etc.

In this way, the positions of the conductive vias and the preset switching directions of different repair units all maintain the above symmetry relationship, such that it is ensured that the chip stack structure subsequently formed can realize a rotation-type transmission of signals through the direct connection configuration, which is detailed in the following description.

In a second specific embodiment, referring to FIG. 13, B = 6, and b is 0, 1, 2, 3, 4, or 5. In this case, the conductive via groups 0-5 in each signal zone in the same channel signal region form four repair unit groups separately:
Referring to FIG. 14A, for the first repair unit group_A: (1) the first repair unit_A includes respective first conductive vias of the conductive via groups 0-5 in the first signal zone 21, i.e., D0/0, D0/1, D0/2, D0/3, D0/4, and D0/5 in the first signal zone 21; (2) the second repair unit_A includes respective second conductive vias of the conductive via groups 0-5 in the second signal zone 22, i.e., D1/0, D1/1, D1/2, D1/3, D1/4, and D1/5 in the second signal zone 22; (3) the third repair unit_A includes respective third conductive vias of the conductive via groups 0-5 in the third signal zone 23, i.e., D2/0, D2/1, D2/2, D2/3, D2/4, and D2/5 in the third signal zone 23; and (4) the fourth repair unit_A includes respective fourth conductive vias of the conductive via groups 0-5 in the fourth signal zone 24, i.e., D3/0, D3/1, D3/2, D3/3, D3/4, and D3/5 in the fourth signal zone 24.

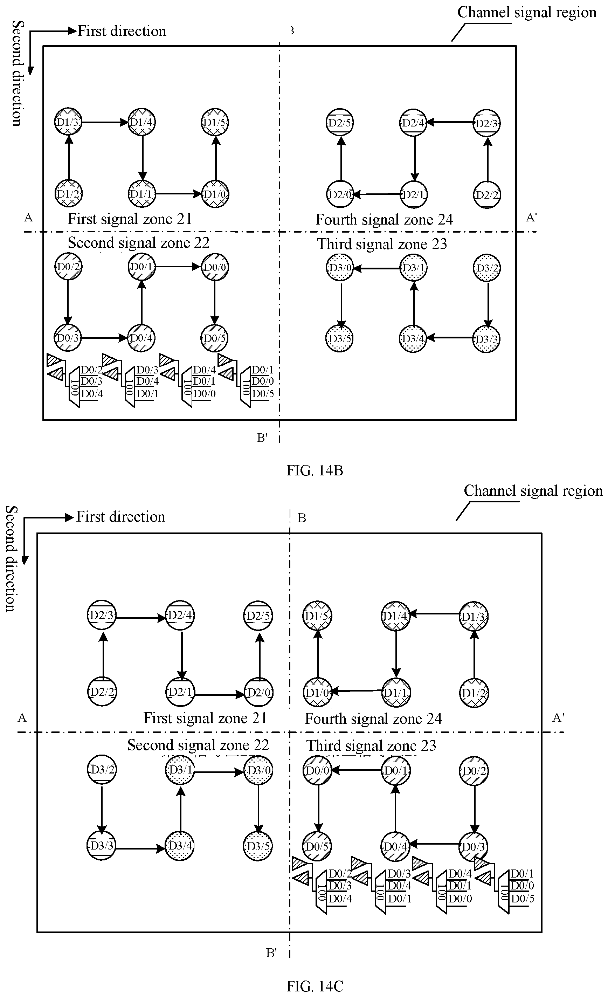

Referring to FIG. 14B, for the second repair unit group_B, (1) the first repair unit_B includes respective first conductive vias of the conductive via groups 0-5 in the second signal zone 22, i.e., D0/0, D0/1, D0/2, D0/3, D0/4, and D0/5 in the second signal zone 22; (2) the second repair unit_B includes respective second conductive vias of the conductive via groups 0-5 in the first signal zone 21, i.e., D1/0, D1/1, D1/2, D1/3, D1/4, and D1/5 in the first signal zone 21; (3) the third repair unit_B includes respective third conductive vias of the conductive via groups 0-5 in the fourth signal zone, i.e., D2/0, D2/1, D2/2, D2/3, D2/4, and D2/5 in the fourth signal zone 24; and (4) the fourth repair unit_B includes respective fourth conductive vias of the conductive via groups 0-5 in the third signal zone 23, i.e., D3/0, D3/1, D3/2, D3/3, D3/4, and D3/5 in the third signal zone 23.

Referring to FIG. 14C, for the third repair unit group _C, the first repair unit_C includes respective first conductive vias of the conductive via groups 0-5 in the third signal zone 23, i.e., D0/0, D0/1, D0/2, D0/3, D0/4, and D0/5 in the third signal zone 23; (2) the second repair unit_C includes respective second conductive vias of the conductive via groups 0-5 in the fourth signal zone 24, i.e., D1/0, D1/1, D1/2, D1/3, D1/4, and D1/5 in the fourth signal zone 24; (3) the third repair unit_C includes respective third conductive vias of the conductive via groups 0-5 in the first signal zone 21, i.e., D2/0, D2/1, D2/2, D2/3, D2/4, and D2/5 in the first signal zone 21; and (4) the fourth repair unit_C includes respective fourth conductive vias of the conductive via groups 0-5 in the second signal zone 22, i.e., D3/0, D3/1, D3/2, D3/3, D3/4, and D3/5 in the second signal zone 22.

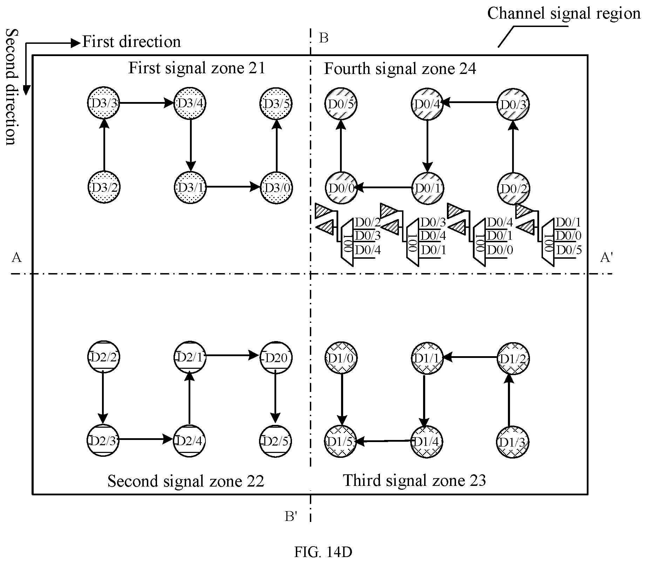

Referring to FIG. 14D, for the fourth repair unit group_D, the first repair unit includes respective first conductive vias of the conductive via groups 0-5 in the fourth signal zone 24, i.e., D0/0, D0/1, D0/2, D0/3, D0/4, and D0/5 in the fourth signal zone 24; (2) the second repair unit_D includes respective second conductive vias of the conductive via groups 0-5 in the third signal zone 23, i.e., D1/0, D1/1, D1/2, D1/3, D1/4, and D1/5 in the third signal zone 23; (3) the fourth repair unit_D includes respective third conductive vias of the conductive via groups 0-5 in the second signal zone 22, i.e., D2/0, D2/1, D2/2, D2/3, D2/4, and D2/5 in the second signal zone 22; and the fourth repair unit_D includes respective fourth conductive vias of the conductive via groups 0-5 in the first signal zone 21, i.e., D3/0, D3/1, D3/2, D3/3, D3/4, and D3/5 in the first signal zone 21.

An example of the preset switching direction is provided below to better understand the foregoing description, but the following example is not the only solution.

Assuming that the conductive vias in the conductive via groups 0 of all the signal zones are normal conductive vias, referring to FIG. 14A to FIG. 14D, the preset switching direction of the conductive vias in the first repair unit is set such that the first conductive via in the conductive via group 2 is allowed to switch to the first conductive via in the conductive via group 3 in the same signal zone, the first conductive via in the conductive via group 3 is allowed to switch to the first conductive via in the conductive via group 4 in the same signal zone, the first conductive via in the conductive via group 4 is allowed to switch to the first conductive via in the conductive via group 1 in the same signal zone, the first conductive via in the conductive via group 1 is allowed to switch to the first conductive via in the conductive via group 0 in the same signal zone, and the first conductive via in the conductive via group 0 is allowed to switch to the first conductive via in the conductive via group 5 in the same signal zone.

That is, referring to FIG. 14A, the preset switching direction of the conductive vias in the first repair unit_A is set to D0/2-D0/3-D0/4-D0/1-D0/0-D0/5 in the first signal zone 21; referring to FIG. 14B, the preset switching direction of the conductive vias in the first repair unit_B is set to D0/2-D0/3-D0/4-D0/1-D0/0-D0/5 in the second signal zone 22; referring to FIG. 14C, the preset switching direction of the conductive vias in the first repair unit_C is set to D0/2-D0/3-D0/4-D0/1-D0/0-D0/5 in the third signal zone 23; referring to FIG. 14D, the preset switching direction of the conductive vias in the first repair unit_D is set to D0/2-D0/3-D0/4-D0/1-D0/0-D0/5 in the fourth signal zone 24.

The following provides a specific description of a signal switching-related circuit in which a repair ratio of the number of normal conductive vias:the number of redundant conductive vias is illustratively 4:2. Take the first repair unit_A of the first repair unit group as an example, referring to FIG. 14A, D0/2, D0/3, and D0/4 are connected to a first signal select circuit 100, and the first signal select circuit 100 connects D0/2 to the internal circuit of the logic circuit 10; D0/3, D0/4, and D0/1 are connected to a second signal select circuit 100, and the second signal select circuit 100 connects D0/3 to the internal circuit of the logic circuit 10; D0/4, D0/1, and D0/0 are connected to a third signal select circuit 100, and the third signal select circuit 100 connects D0/3 to the internal circuit of the logic circuit 10; D0/1, D0/0, and D0/5 are connected to a fourth signal select circuit 100, and the fourth signal select circuit 100 connects D0/1 to the internal circuit of the logic circuit 10. Then, if D0/2 is damaged, the first signal select circuit 100 connects D0/3 to the internal circuit of the logic circuit 10, i.e., the signal originally transmitted by D0/2 will be transmitted by D0/3; the second signal select circuit 100 connects D0/4 to the internal circuit of the logic circuit 10, i.e., the signal originally transmitted by D0/3 will be transmitted by D0/4; the third signal select circuit 100 connects D0/1 to the internal circuit of the logic circuit 10, i.e., the signal originally transmitted by D0/4 will be transmitted by D0/1; the fourth signal select circuit 100 connects D0/0 to the internal circuit of the logic circuit 10, i.e., the signal originally transmitted by D0/4 will be transmitted by D0/0. The other repair units can be similarly understood.

Similarly, for the memory chip 30, only the conductive vias in the first repair unit (i.e., the conductive vias filled with the pure white pattern) are connected to the corresponding signal select circuit 100. Likewise, for the second to fourth repair units, the conductive vias in the second to fourth repair units do not access the memory chip 30 regardless of whether they are used as normal conductive vias or redundant conductive vias. Therefore, the switching of the conductive vias for transmitting signals in the repair units of the memory chip only comes with the switching of the conductive vias for transmitting signals in the logic chip 10, and it is actually imperceptible to the memory chip 30. Therefore, only the preset switching direction of the first repair unit is emphasized in this embodiment.

The embodiment of the present disclosure provides a memory chip 30, where the conductive vias in each channel signal region are arranged symmetrically about the first axis AA' and arranged symmetrically about the second axis BB'. Meanwhile, the switching directions of the repair units further composed of the conductive vias also follow the symmetry principle, such that the above memory chip not only has small parasitic capacitance and parasitic resistance when forming a chip stack structure, but also realizes a face-to-face stack manner. In addition, the embodiment of the present disclosure further provides a relevant mechanism for redundancy repair in the structure.

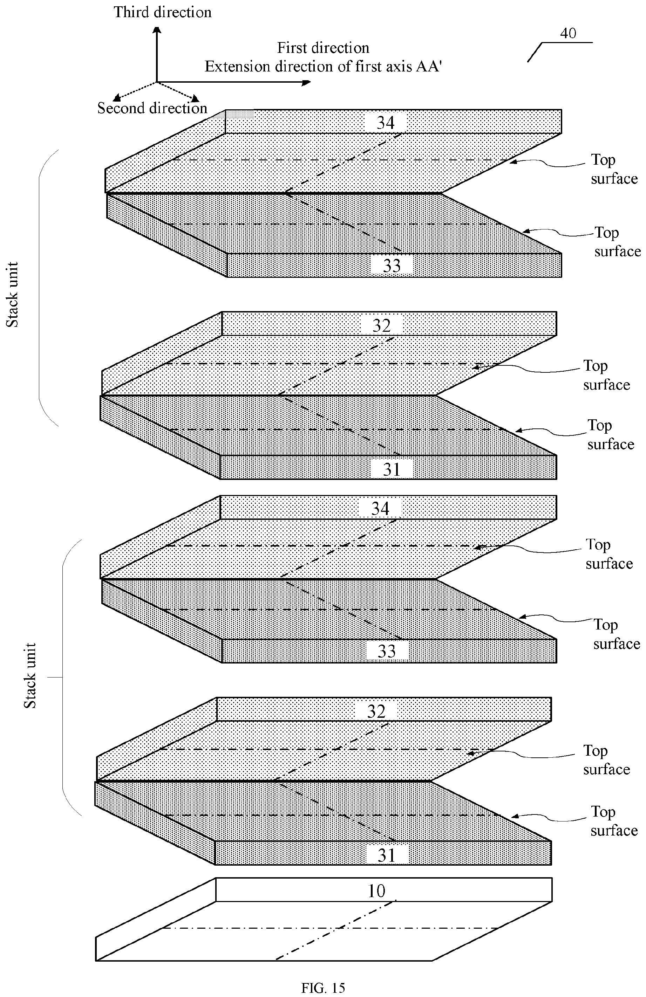

In yet another embodiment of the present disclosure, referring to FIG. 15, a schematic diagram of a composition structure of a chip stack structure 40 provided according to an embodiment of the present disclosure is shown. As shown in FIG. 15, the chip stack structure 40 includes the aforementioned logic chip 10 and at least one stack unit, and the logic chip 10 and the at least one stack unit are sequentially stacked along the third direction. Each stack unit includes a first memory chip 31, a second memory chip 32, a third memory chip 33, and a fourth memory chip 34 stacked along the third direction; the first memory chip 31, the second memory chip 32, the third memory chip 33, and the fourth memory chip 34 are each the aforementioned memory chip 30. The third direction is perpendicular to a top surface of each chip.

For each stack unit, the first memory chip 31 and the second memory chip 32 are stacked in a face-to-face manner, the second memory chip 32 and the third memory chip 33 are stacked in a back-to-back manner, and the third memory chip 33 and the fourth memory chip 34 are stacked in a face-to-face manner; the first memory chip 31 in the first stack unit and the logic chip 10 are stacked in a back-to-face manner, or the first memory chip 31 in the first stack unit and the logic chip 10 are stacked in a back-to-back manner.

In the embodiment of the present disclosure, face-to-face stacking means that the top surfaces of two chips are approximately aligned with each other along the third direction and the center points and the first axes AA' and the second axes BB' of the top surfaces of the two chips are all aligned along the third direction; back-to-back stacking means that the bottom surfaces of two chips are approximately aligned with each other along the third direction; face-to-back stacking means that the top surface of one chip is approximately aligned with the bottom surface of another chip along the third direction. The "chip" may refer to a logic chip or a memory chip in the case that whether it is a logic chip or a memory chip is not specified.

It should be noted that in one possibility, for two chips connected in a face-to-face manner, (positions where the conductive vias are aligned along the third direction in) bonding surfaces of the two chips are electrically connected through a hybrid bonding structure (also referred to as a bonding post); for two chips connected in a back-to-back manner or in a back-to-face manner, (positions where the conductive vias are aligned along the third direction in) bonding surfaces of the two chips are electrically connected through conductive bumps (UBumps, also referred to as microbumps).

In another possibility, for two chips connected in a face-to-face manner or for two chips connected in a back-to-back manner or for two chips connected in a back-to-face manner, (positions where the conductive vias are aligned along the third direction in) bonding surfaces of the two chips are connected through a hybrid bonding structure. In yet another possibility, for two chips connected in a face-to-face manner or for two chips connected in a back-to-back manner or for two chips connected in a back-to-face manner, (positions where the conductive vias are aligned along the third direction in) bonding surfaces of the two chips are connected through conductive bumps. Here, the above chip may refer to the logic chip 10 or the memory chip 30.

It should be noted that compared to the conductive bump bonding process, the face-to-face connection using the hybrid bonding process enables adjacent memory chips to fit more closely with almost no gaps, thereby greatly reducing the height of the chip stack structure, which is one of the advantages of the face-to-face stacking. Of course, two memory chips connected in a back-to-back manner may also be connected through a hybrid bonding structure, but the connection performance is not as good as that achieved by the conductive bump bonding process. In this way, in the embodiment of the present disclosure, the chip stack structure supports face-to-face stacking and achieves a better performance.

As described above, the logic chip 10 and each memory chip are each provided with n repair unit groups, and the n repair unit groups in the logic chip 10, the n repair unit groups in each first memory chip 31, the n repair unit groups in each second memory chip 32, the n repair unit groups in each third memory chip 33, and the n repair unit groups in each fourth memory chip 34 are in one-to-one correspondence and are aligned along the third direction, such that in the case that one of the conductive vias is damaged, the logic chip 10 and each memory chips 30 will synchronously perform a signal switching operation.

In some embodiments, the logic chip 10 includes m channel signal regions arranged along the first direction, each memory chip is provided with m channels arranged along the first direction, and each channel includes a first memory array region, a channel signal region, and a second memory array region that are sequentially arranged along the second direction; any two of the first direction, the second direction, and the third direction are perpendicular to each other, and the first direction and the second direction are parallel to the top surface of each chip.

In particular, two second directions are shown in FIG. 15, because for clarity, two adjacent chips have different perspective angles and thus each correspond to one second direction.

It should be understood that the logic chip 10 or each memory chip may be divided into a high-bit transmission region and a low-bit transmission region, and the arrows in the following drawings are all located in the high-bit transmission regions of the chips. In particular, the high-bit transmission region and the low-bit transmission region in the embodiment of the present disclosure only distinguish two regions of the memory chip, but do not impose any additional limitation and do not have any relationship with high-bit data and low-bit data that are often mentioned in a data transmission process.

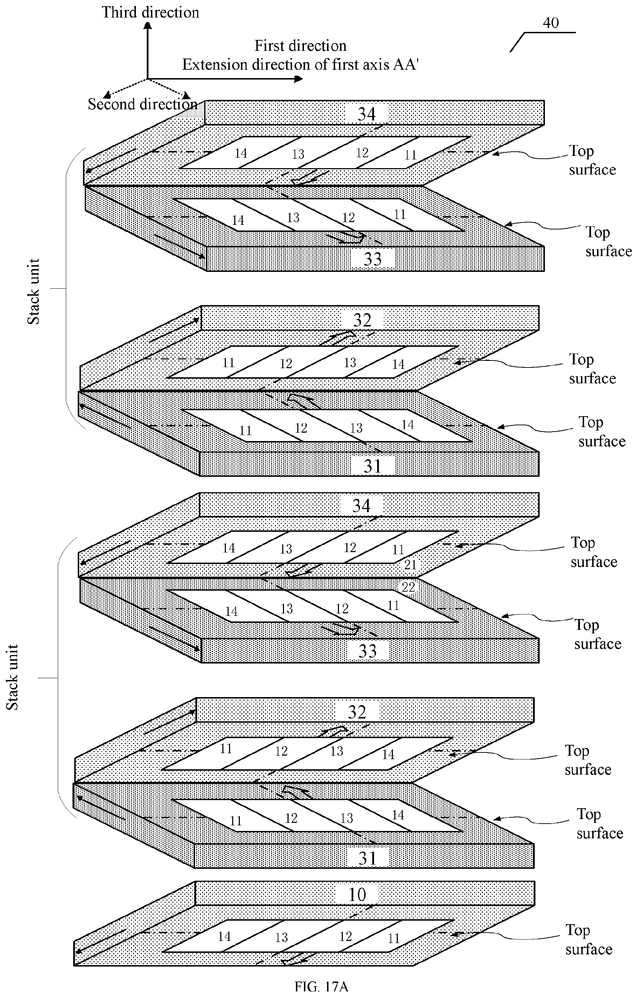

In a first specific embodiment, referring to FIG. 17A, in the case that the logic chip 10 and the first memory chip 31 are stacked in a back-to-back manner and the respective first axes AA' of the logic chip 10 and each memory chip 30 extend along the first direction (i.e., the first axes AA' each divide a corresponding chip thereof into a high-bit transmission region and a low-bit transmission region), the high-bit transmission region of the logic chip 10, the high-bit transmission region of the first memory chip 31, the low-bit transmission region of the second memory chip 32, the low-bit transmission region of the third memory chip 33, and the high-bit transmission region of the fourth memory chip 34 are aligned along the third direction, and the low-bit transmission region of the logic chip 10, the low-bit transmission region of the first memory chip 31, the high-bit transmission region of the second memory chip 32, the high-bit transmission region of the third memory chip 33, and the low-bit transmission region of the fourth memory chip 34 are aligned along the third direction.

The channel signal regions of the chips have the following alignment relationships: an (m-i)^{th} channel signal region in the logic chip 10 is aligned with the channel signal region in an (i+1)^{th} channel in the first memory chip 31, the channel signal region in an (i+1)^{th} channel in the second memory chip 32, the channel signal region in an (m-i)^{th} channel in the third memory chip 33, and the channel signal region in an (m-i)^{th} channel in the fourth memory chip 34 along the third direction, where i is a natural number less than m.

FIG. 17A is illustrated with m = 4. In this case:
(1) the fourth channel signal region 14 in the logic chip 10, the channel signal region 11 in the first channel in the first memory chip 31, the channel signal region 11 in the first channel in the second memory chip 32, the channel signal region 14 in the fourth channel in the third memory chip 33, and the channel signal region 14 in the fourth channel in the fourth memory chip 34 are aligned along the third direction;
(2) the third channel signal region 13 in the logic chip 10, the channel signal region 12 in the second channel in the first memory chip 31, the channel signal region 12 in the second channel in the second memory chip 32, the channel signal region 13 in the third channel in the third memory chip 33, and the channel signal region 13 in the third channel in the fourth memory chip 34 are aligned along the third direction;
(3) the second channel signal region 12 in the logic chip 10, the channel signal region 13 in the third channel in the first memory chip 31, the channel signal region 13 in the third channel in the second memory chip 32, the channel signal region 12 in the second channel in the third memory chip 33, and the channel signal region 12 in the second channel in the fourth memory chip 34 are aligned along the third direction;
(4) the first channel signal region 11 in the logic chip 10, the channel signal region 14 in the fourth channel in the first memory chip 31, the channel signal region 14 in the fourth channel in the second memory chip 32, the channel signal region 11 in the first channel in the third memory chip 33, and the channel signal region 11 in the first channel in the fourth memory chip 34 are aligned along the third direction.

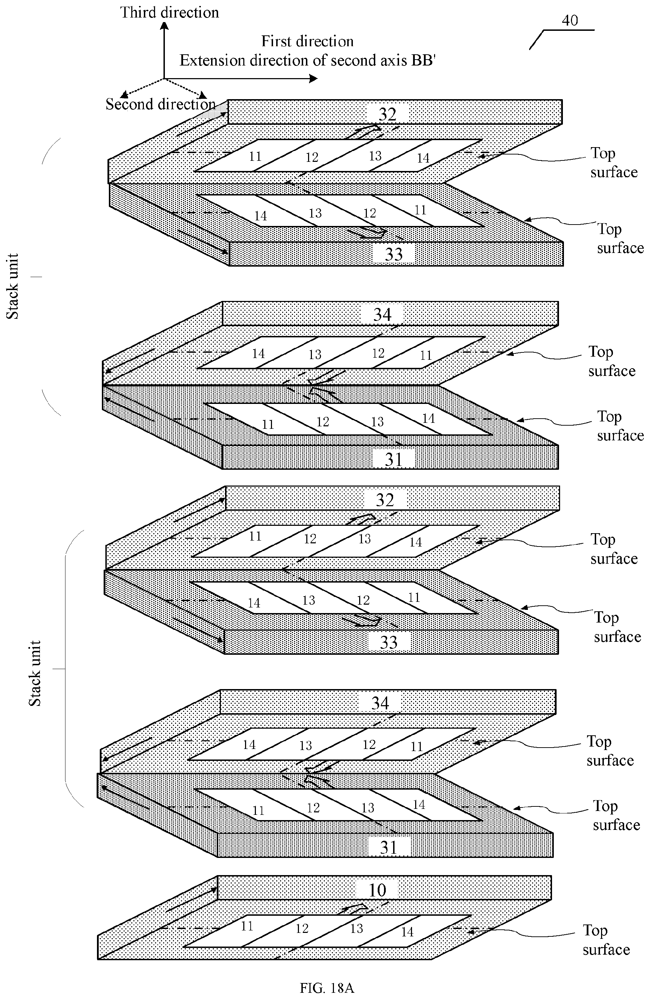

In a second specific embodiment, referring to FIG. 18A (illustrated with m = 4), in the case that the logic chip 10 and the first memory chip 31 are stacked in a back-to-back manner and the respective second axes BB' of the logic chip 10 and each memory chip extend along the first direction (i.e., the second axes BB' each divide a corresponding chip thereof into a high-bit transmission region and a low-bit transmission region), the low-bit transmission region of the logic chip 10, the high-bit transmission region of the first memory chip 31, the high-bit transmission region of the second memory chip 32, the low-bit transmission region of the third memory chip 33, and the low-bit transmission region of the fourth memory chip 34 are aligned along the third direction, and the high-bit transmission region of the logic chip 10, the low-bit transmission region of the first memory chip 31, the low-bit transmission region of the second memory chip 32, the high-bit transmission region of the third memory chip 33, and the high-bit transmission region of the fourth memory chip 34 are aligned along the third direction.

Specifically, the channel signal regions of the chips have the following symmetry relationships: an (i+1)^{th} channel signal region in the logic chip 10 is aligned with the channel signal region in an (i+1)^{th} channel in the first memory chip 31, the channel signal region in an (m-i)^{th} channel in the second memory chip 32, the channel signal region in an (m-i)^{th} channel in the third memory chip 33, and the channel signal region in an (i+1)^{th} channel in the fourth memory chip 34 along the third direction, where i is a natural number less than m.

FIG. 18A is illustrated with m = 4. In this case:
(1) the first channel signal region 11 in the logic chip 10, the channel signal region 11 in the first channel in the first memory chip 31, the channel signal region 14 in the fourth channel in the second memory chip 32, the channel signal region 14 in the fourth channel in the third memory chip 33, and the channel signal region 11 in the first channel in the fourth memory chip 34 are aligned along the third direction;
(2) the second channel signal region 12 in the logic chip 10, the channel signal region 12 in the second channel in the first memory chip 31, the channel signal region 13 in the third channel in the second memory chip 32, the channel signal region 13 in the third channel in the third memory chip 33, and the channel signal region 12 in the second channel in the fourth memory chip 34 are aligned along the third direction;
(3) the third channel signal region 13 in the logic chip 10, the channel signal region 13 in the third channel in the first memory chip 31, the channel signal region 12 in the second channel in the second memory chip 32, the channel signal region 12 in the second channel in the third memory chip 33, and the channel signal region 13 in the third channel in the fourth memory chip 34 are aligned along the third direction;
(4) the fourth channel signal region 14 in the logic chip 10, the channel signal region 14 in the fourth channel in the first memory chip 31, the channel signal region 11 in the first channel in the second memory chip 32, the channel signal region 11 in the first channel in the third memory chip 33, and the channel signal region 14 in the fourth channel in the fourth memory chip 34 are aligned along the third direction.

In brief, for FIG. 17A to FIG. 18B, the logic chip 10 and the fourth memory chip 34 are arranged in the same manner.

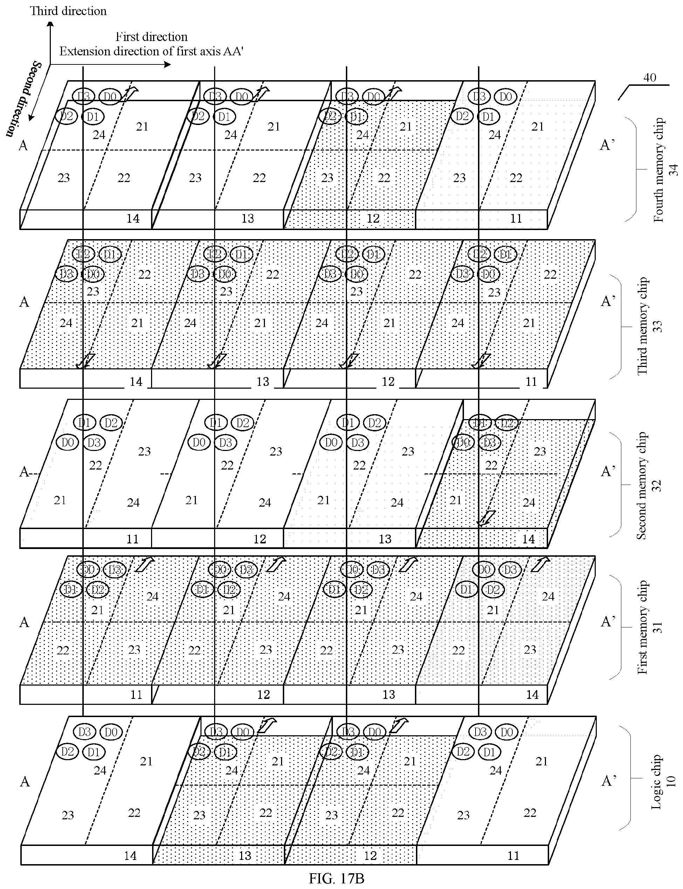

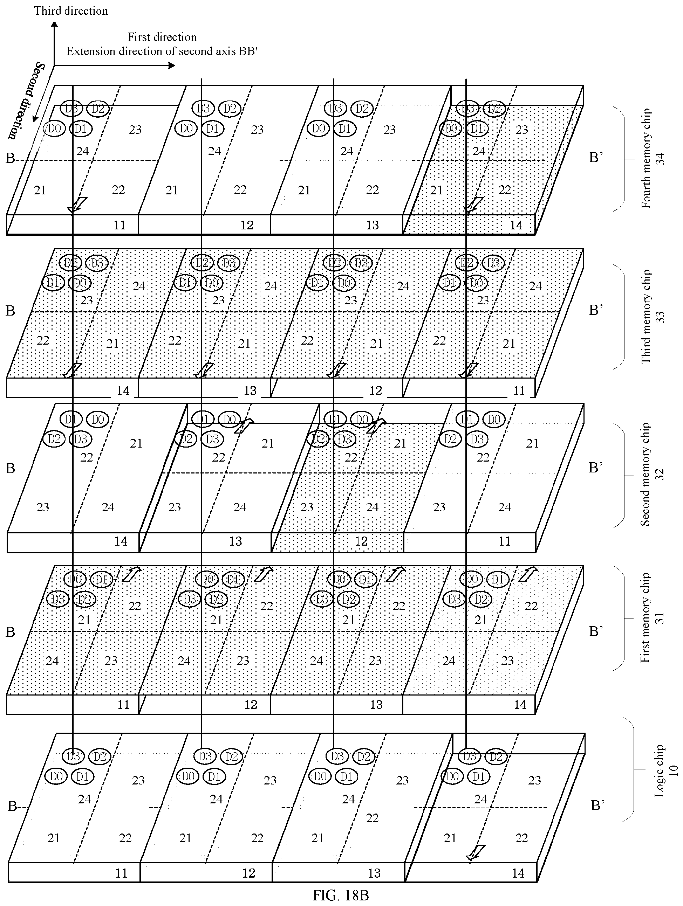

It should be further noted that the channel signal region in each channel of the memory chip 30 and the logic chip 31 is divided into 2×2 signal zones arranged in an array. Referring to FIG. 17B or FIG. 18B, a plurality of channel signal regions aligned along the third direction have the following characteristics:
(1) the fourth signal zones 24 belonging to the logic chip 10, the first signal zones 21 belonging to the first memory chip 31, the second signal zones 22 belonging to the second memory chip 32, the third signal zones 23 belonging to the third memory chip 33, and the fourth signal zones 24 belonging to the fourth memory chip 34 are aligned along the third direction;
(2) the third signal zones 23 belonging to the logic chip 10, the second signal zones 22 belonging to the first memory chip 31, the first signal zones 21 belonging to the second memory chip 32, the fourth signal zones 24 belonging to the third memory chip 33, and the third signal zones 23 belonging to the fourth memory chip 34 are aligned along the third direction;
(3) the second signal zones 22 belonging to the logic chip 10, the third signal zones 23 belonging to the first memory chip 31, the fourth signal zones 24 belonging to the second memory chip 32, the first signal zones 21 belonging to the third memory chip 33, and the second signal zones 22 belonging to the fourth memory chip 34 are aligned along the third direction;
(4) the first signal zones 21 belonging to the logic chip 10, the fourth signal zones 24 belonging to the first memory chip 31, the third signal zones 23 belonging to the second memory chip 32, the second signal zones 22 belonging to the third memory chip 33, and the first signal zones 21 belonging to the fourth memory chip 34 are aligned along the third direction.

In some embodiments, each signal zone includes n conductive via groups with the same arrangement manner. In each channel signal region, the conductive via groups in the first signal zone and the conductive via groups in the second signal zone are in one-to-one correspondence and are arranged symmetrically about the first axis, the conductive via groups in the third signal zone and the conductive via groups in the fourth signal zone are in one-to-one correspondence and are arranged symmetrically about the first axis, and the conductive via groups in the first signal zone and the conductive via groups in the fourth signal zone are in one-to-one correspondence and are arranged symmetrically about the second axis. Meanwhile, the conductive via groups in different channel signal regions are in one-to-one correspondence and each have the same arrangement manner (relative to the center of a corresponding signal zone thereof); each conductive via group includes a first conductive via, a second conductive via, a third conductive via, and a fourth conductive via.

Referring to FIG. 17B or FIG. 18B, for a plurality of signal zones aligned along the third direction:
(1) the fourth conductive vias D3 belonging to the logic chip 10, the first conductive vias D0 belonging to the first memory chip 31, the second conductive vias D1 belonging to the second memory chip 32, the third conductive vias D2 belonging to the third memory chip 33, and the fourth conductive vias D3 belonging to the fourth memory chip 34 are aligned along the third direction;
(2) the third conductive vias D2 belonging to the logic chip 10, the second conductive vias D1 belonging to the first memory chip 31, the first conductive vias D0 belonging to the second memory chip 32, the fourth conductive vias D3 belonging to the third memory chip 33, and the third conductive vias D2 belonging to the fourth memory chip 34 are aligned along the third direction;
(3) the second conductive vias D1 belonging to the logic chip 10, the third conductive vias D2 belonging to the first memory chip 31, the fourth conductive vias D3 belonging to the second memory chip 32, the first conductive vias D0 belonging to the third memory chip 33, and the second conductive vias D1 belonging to the fourth memory chip 34 are aligned along the third direction;
(4) the first conductive vias D0 belonging to the logic chip 10, the fourth conductive vias D3 belonging to the first memory chip 31, the third conductive vias D2 belonging to the second memory chip 32, the second conductive vias D1 belonging to the third memory chip 33, and the first conductive vias D0 belonging to the fourth memory chip 34 are aligned along the third direction, where a plurality of conductive vias aligned along the third direction are coupled to form a signal transmission channel.

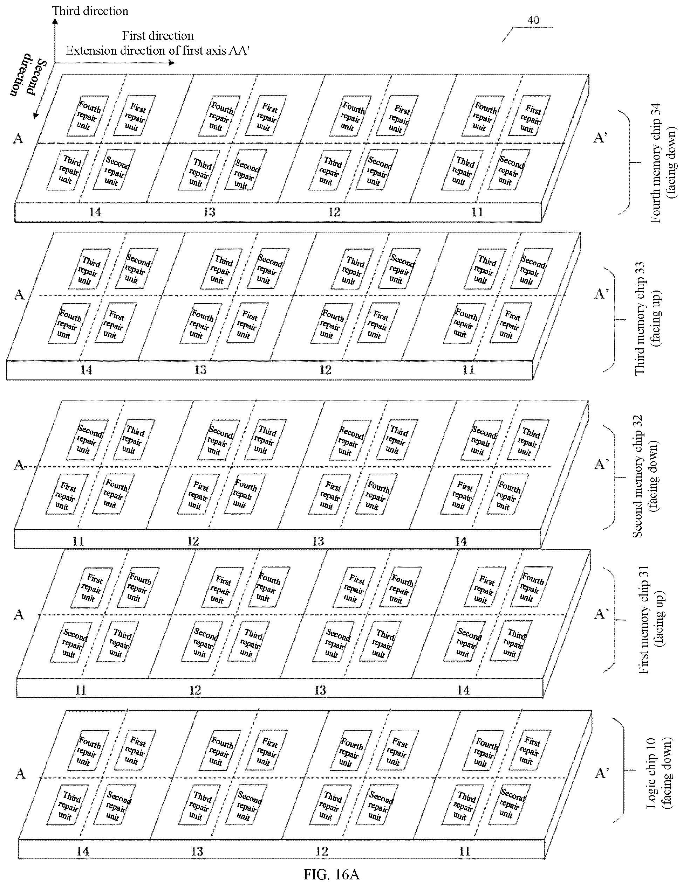

Referring to FIG. 16A, in stacking according to the first and second specific embodiments, the repair units of the chips have the following relationships:
(a) one fourth repair unit in the logic chip 10, one first repair unit in the first memory chip 31, one second repair unit in the second memory chip 32, one third repair unit in the third memory chip 33, and one fourth repair unit in the fourth memory chip 34 are aligned along the third direction, and the switching of conductive vias is performed synchronously;
(b) one third repair unit in the logic chip 10, one second repair unit in the first memory chip 31, one first repair unit in the second memory chip 32, one fourth repair unit in the third memory chip 33, and one third repair unit in the fourth memory chip 34 are aligned along the third direction, and the switching of conductive vias is performed synchronously;
(c) one second repair unit in the logic chip 10, one third repair unit in the first memory chip 31, one fourth repair unit in the second memory chip 32, one first repair unit in the third memory chip 33, and one second repair unit in the fourth memory chip 34 are aligned along the third direction, and the switching of conductive vias is performed synchronously;
(d) one first repair unit in the logic chip 10, one fourth repair unit in the first memory chip 31, one third repair unit in the second memory chip 32, one second repair unit in the third memory chip 33, and one first repair unit in the fourth memory chip 34 are aligned along the third direction, and the switching of conductive vias is performed synchronously.

It should be noted that for the logic chip 10, each repair unit therein is coupled to the internal circuit, i.e., the normal conductive via in each repair unit is electrically connected to the internal circuit of the logic chip 10. However, for the memory chip, only the first repair unit is coupled to the internal circuit, i.e., only the normal conductive via in the first repair unit is electrically connected to the internal circuit of the memory chip, and all the conductive vias in the second repair unit, the third repair unit, and the fourth repair unit are isolated from the internal circuit of the logic chip 10.

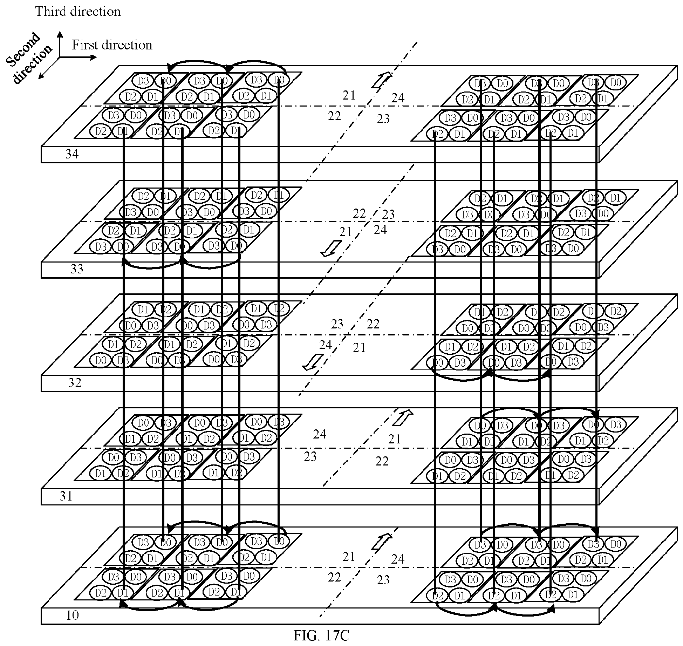

FIG. 17C takes the division form of the repair unit groups in FIG. 5 and FIG. 11 and the stacking manner of the first specific embodiment as an example and shows a schematic diagram illustrating symmetry and switching directions of one repair unit group of the logic chip 10 and the first repair unit in each corresponding memory chip, with other repair units omitted. That is, in FIG. 17C, the first repair unit, the second repair unit, the third repair unit, and the fourth repair unit indicated by curved arrows in the logic chip 10 are all coupled to the internal circuit. However, for the memory chip, only the first repair unit indicated by the curved arrow is coupled to the internal circuit.

The chip stack structure formed by the repair unit groups in FIG. 7 and FIG. 13 also has the above characteristics and can be understood accordingly.

In this way, the repair units of the chip stack structure 40 are aligned along the third direction and have a symmetrical switching direction, such that the same switching function can be realized.

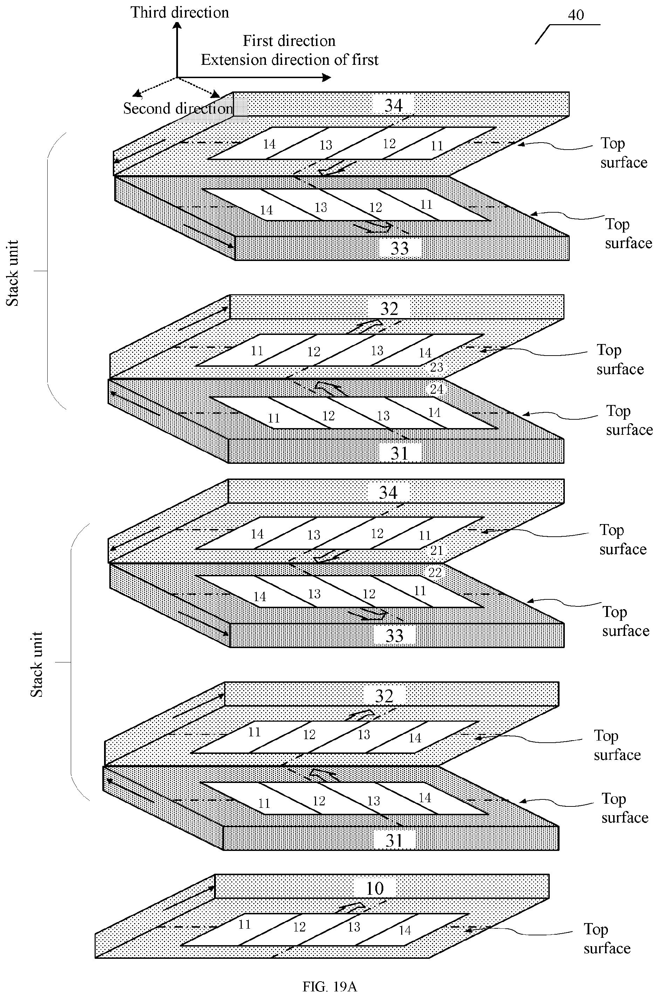

In a third specific embodiment, referring to FIG. 19A (illustrated with m = 4), in the case that the logic chip 10 and the first memory chip 31 are stacked in a back-to-back manner and the respective first axes AA' of the logic chip 10 and each memory chip extend along the first direction (i.e., the first axes AA' each divide a corresponding chip thereof into a high-bit transmission region and a low-bit transmission region), the low-bit transmission region of the logic chip 10, the high-bit transmission region of the first memory chip 31, the low-bit transmission region of the second memory chip 32, the low-bit transmission region of the third memory chip 33, and the high-bit transmission region of the fourth memory chip 34 are aligned along the third direction, and the high-bit transmission region of the logic chip 10, the low-bit transmission region of the first memory chip 31, the high-bit transmission region of the second memory chip 32, the high-bit transmission region of the third memory chip 33, and the low-bit transmission region of the fourth memory chip 34 are aligned along the third direction.

Specifically, the channel signal regions of the chips have the following symmetry relationships: an (i+1)^{th} channel signal region in the logic chip 10 is aligned with the channel signal region in an (i+1)^{th} channel in the first memory chip 31, the channel signal region in an (i+1)^{th} channel in the second memory chip 32, the channel signal region in an (m-i)^{th} channel in the third memory chip 33, and the channel signal region in an (m-i)^{th} channel in the fourth memory chip 34 along the third direction, where i is a natural number less than m.

FIG. 19A is illustrated with m = 4. In this case:
(1) the first channel signal region 11 in the logic chip 10, the channel signal region 11 in the first channel in the first memory chip 31, the channel signal region 11 in the first channel in the second memory chip 32, the channel signal region 14 in the fourth channel in the third memory chip 33, and the channel signal region 14 in the fourth channel in the fourth memory chip 34 are aligned along the third direction;
(2) the second channel signal region 12 in the logic chip 10, the channel signal region 12 in the second channel in the first memory chip 31, the channel signal region 12 in the second channel in the second memory chip 32, the channel signal region 13 in the third channel in the third memory chip 33, and the channel signal region 13 in the third channel in the fourth memory chip 34 are aligned along the third direction;
(3) the third channel signal region 13 in the logic chip 10, the channel signal region 13 in the third channel in the first memory chip 31, the channel signal region 13 in the third channel in the second memory chip 32, the channel signal region 12 in the second channel in the third memory chip 33, and the channel signal region 12 in the second channel in the fourth memory chip 34 are aligned along the third direction;
(4) the fourth channel signal region 14 in the logic chip 10, the channel signal region 14 in the fourth channel in the first memory chip 31, the channel signal region 14 in the fourth channel in the second memory chip 32, the channel signal region 11 in the first channel in the third memory chip 33, and the channel signal region 11 in the first channel in the fourth memory chip 34 are aligned along the third direction.

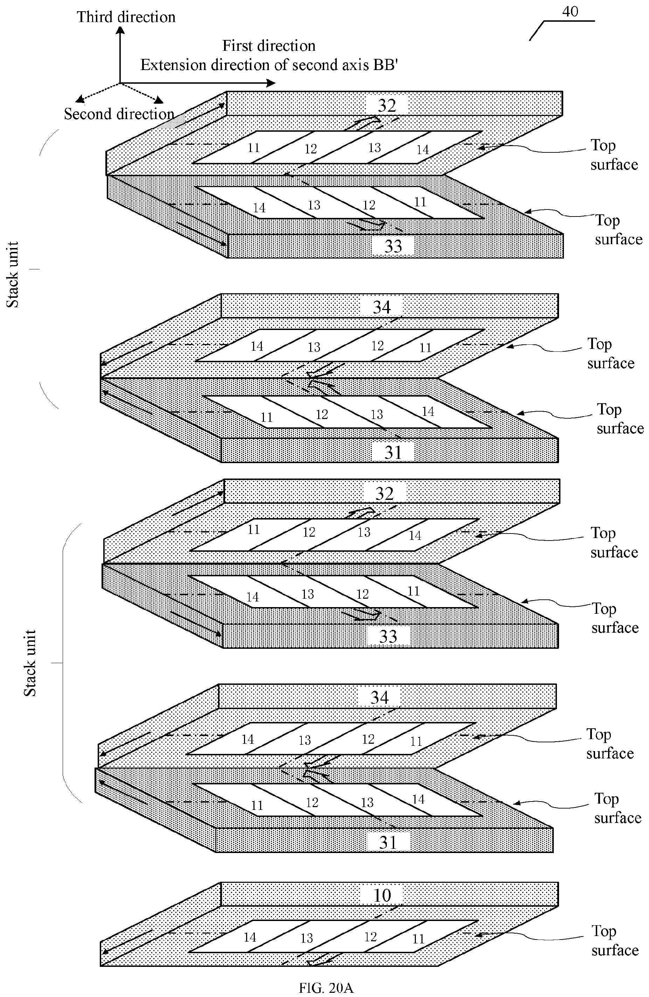

In a fourth specific embodiment, referring to FIG. 20A (illustrated with m = 4), in the case that m = 4, the logic chip 10 and the first memory chip 31 are stacked in a back-to-back manner and the respective second axes BB' of the logic chip 10 and each memory chip extend along the first direction (i.e., the second axes BB' each divide a corresponding chip thereof into a high-bit transmission region and a low-bit transmission region), the high-bit transmission region of the logic chip 10, the high-bit transmission region of the first memory chip 31, the high-bit transmission region of the second memory chip 32, the low-bit transmission region of the third memory chip 33, and the low-bit transmission region of the fourth memory chip 34 are aligned along the third direction, and the low-bit transmission region of the logic chip 10, the low-bit transmission region of the first memory chip 31, the low-bit transmission region of the second memory chip 32, the high-bit transmission region of the third memory chip 33, and the high-bit transmission region of the fourth memory chip 34 are aligned along the third direction.

Specifically, the channel signal regions of the chips have the following symmetry relationships: an (m-i)^{th} channel signal region in the logic chip 10 is aligned with the channel signal region in an (i+1)^{th} channel in the first memory chip 31, the channel signal region in an (m-i)^{th} channel in the second memory chip 32, the channel signal region in an (m-i)^{th} channel in the third memory chip 33, and the channel signal region in an (i+1)^{th} channel in the fourth memory chip 34 along the third direction, where i is a natural number less than m.
(1) the fourth channel signal region 14 in the logic chip 10, the channel signal region 11 in the first channel in the first memory chip 31, the channel signal region 14 in the fourth channel in the second memory chip 32, the channel signal region 14 in the fourth channel in the third memory chip 33, and the channel signal region 11 in the first channel in the fourth memory chip 34 are aligned along the third direction;
(2) the third channel signal region 13 in the logic chip 10, the channel signal region 12 in the second channel in the first memory chip 31, the channel signal region 13 in the third channel in the second memory chip 32, the channel signal region 13 in the third channel in the third memory chip 33, and the channel signal region 12 in the second channel in the fourth memory chip 34 are aligned along the third direction;
(3) the second channel signal region 12 in the logic chip 10, the channel signal region 13 in the third channel in the first memory chip 31, the channel signal region 12 in the second channel in the second memory chip 32, the channel signal region 12 in the second channel in the third memory chip 33, and the channel signal region 13 in the third channel in the fourth memory chip 34 are aligned along the third direction;
(4) the first channel signal region 11 in the logic chip 10, the channel signal region 14 in the fourth channel in the first memory chip 31, the channel signal region 11 in the first channel in the second memory chip 32, the channel signal region 11 in the first channel in the third memory chip 33, and the channel signal region 14 in the fourth channel in the fourth memory chip 34 are aligned along the third direction.

In brief, for FIG. 19A to FIG. 20B, the logic chip 10 and the second memory chip 32 are arranged in the same manner.

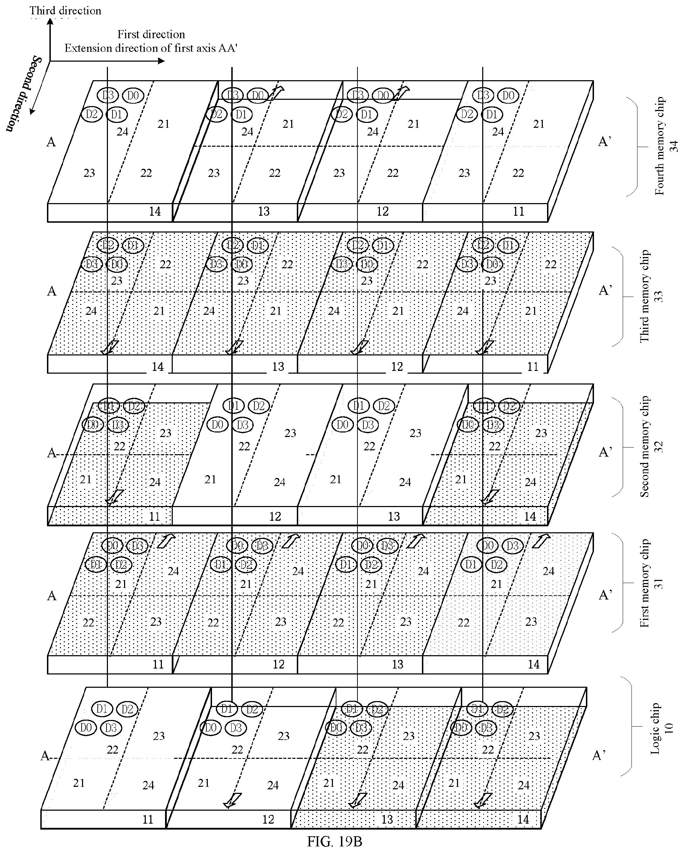

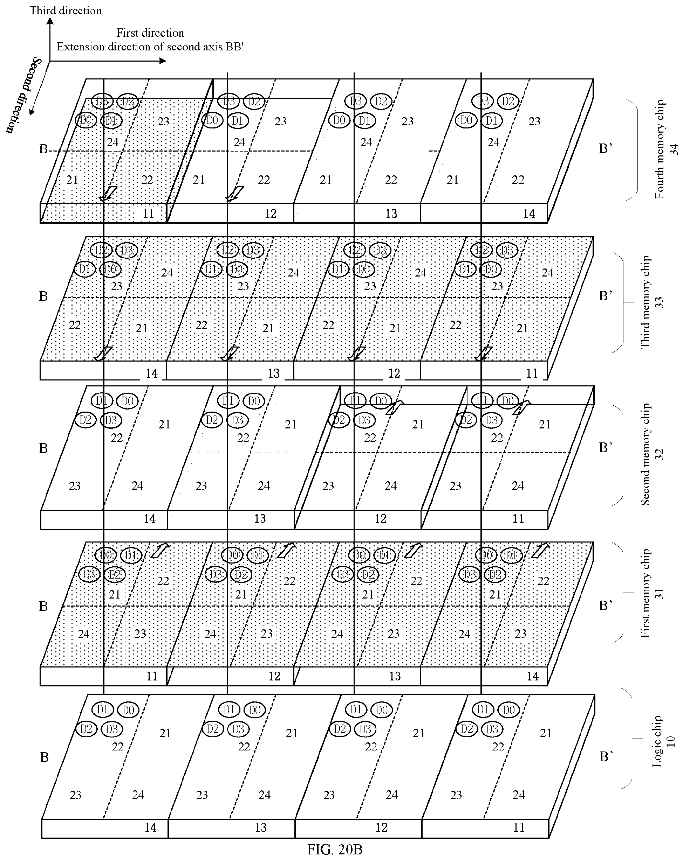

In some embodiments, referring to FIG. 19B and FIG. 20B, the channel signal region in each channel of the memory chip and the logic chip 10 is divided into 2×2 signal zones arranged in an array. Referring to FIG. 19B and FIG. 20B, for a plurality of channel signal regions aligned along the third direction:
(1) the second signal zone 22 belonging to the logic chip 10, the first signal zone 21 belonging to the first memory chip 31, the second signal zone 22 belonging to the second memory chip 32, the third signal zone 23 belonging to the third memory chip 33, and the fourth signal zone 24 belonging to the fourth memory chip 34 are aligned along the third direction;
(2) the first signal zone 21 belonging to the logic chip 10, the second signal zone 22 belonging to the first memory chip 31, the first signal zone 21 belonging to the second memory chip 32, the fourth signal zone 24 belonging to the third memory chip 33, and the third signal zone 23 belonging to the fourth memory chip 34 are aligned along the third direction;
(3) the fourth signal zone 24 belonging to the logic chip 10, the third signal zone 23 belonging to the first memory chip 31, the fourth signal zone 24 belonging to the second memory chip 32, the first signal zone 21 belonging to the third memory chip 33, and the second signal zone 22 belonging to the fourth memory chip 34 are aligned along the third direction;
(4) the third signal zone 23 belonging to the logic chip 10, the fourth signal zone 24 belonging to the first memory chip 31, the third signal zone 23 belonging to the second memory chip 32, the second signal zone 22 belonging to the third memory chip 33, and the first signal zone 21 belonging to the fourth memory chip 34 are aligned along the third direction.

Referring to FIG. 19B or FIG. 20B, each signal zone of the memory chip and the logic chip 10 includes n conductive via groups with the same arrangement manner, and each conductive via group includes a first conductive via, a second conductive via, a third conductive via, and a fourth conductive via.

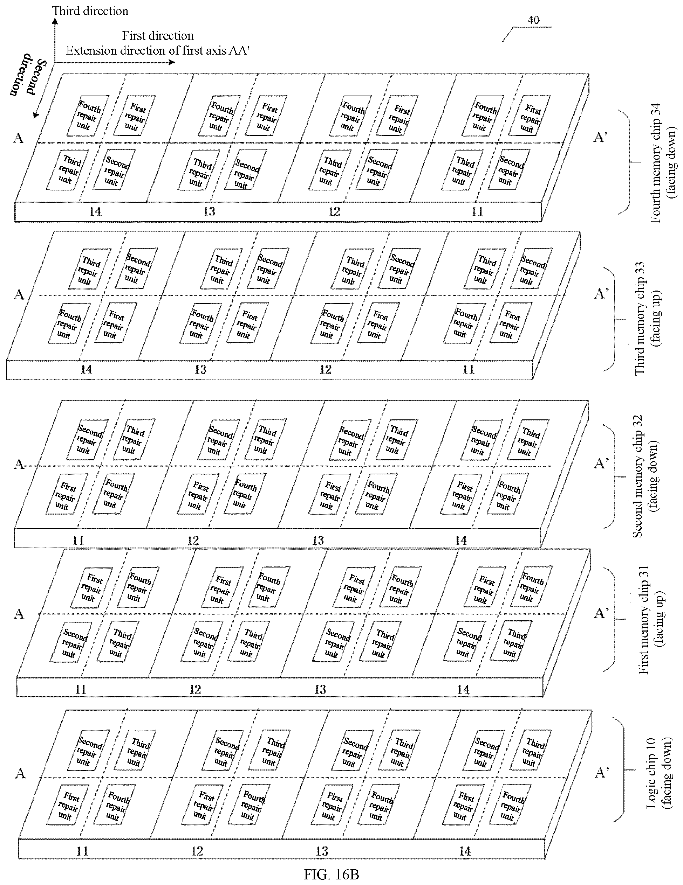

For a plurality of signal zones aligned along the third direction:
(1) the second conductive vias D1 belonging to the logic chip 10, the first conductive vias D0 belonging to the first memory chip 31, the second conductive vias D1 belonging to the second memory chip 32, the third conductive vias D2 belonging to the third memory chip 33, and the fourth conductive vias D3 belonging to the fourth memory chip 34 are aligned along the third direction;
(2) the first conductive vias D0 belonging to the logic chip 10, the second conductive vias D1 belonging to the first memory chip 31, the first conductive vias D0 belonging to the second memory chip 32, the fourth conductive vias D3 belonging to the third memory chip 33, and the third conductive vias D2 belonging to the fourth memory chip 34 are aligned along the third direction;
(3) the fourth conductive vias D3 belonging to the logic chip 10, the third conductive vias D2 belonging to the first memory chip 31, the fourth conductive vias D3 belonging to the second memory chip 32, the first conductive vias D0 belonging to the third memory chip 33, and the second conductive vias D1 belonging to the fourth memory chip 34 are aligned along the third direction;
(4) the third conductive vias D2 belonging to the logic chip 10, the fourth conductive vias D3 belonging to the first memory chip 31, the third conductive vias D2 belonging to the second memory chip 32, the second conductive vias D1 belonging to the third memory chip 33, and the first conductive vias D0 belonging to the fourth memory chip 34 are aligned along the third direction;
a plurality of conductive vias aligned along the third direction are coupled to form a signal transmission channel. Referring to FIG. 16B, for the third and fourth specific embodiments, the repair units of the chips have the following relationships:
(a) one second repair unit in the logic chip 10, one first repair unit in the first memory chip 31, one second repair unit in the second memory chip 32, one third repair unit in the third memory chip 33, and one fourth repair unit in the fourth memory chip 34 are aligned along the third direction, and the switching of conductive vias is performed synchronously;
(b) one first repair unit in the logic chip 10, one second repair unit in the first memory chip 31, one first repair unit in the second memory chip 32, one fourth repair unit in the third memory chip 33, and one third repair unit in the fourth memory chip 34 are aligned along the third direction, and the switching of conductive vias is performed synchronously;
(c) one fourth repair unit in the logic chip 10, one third repair unit in the first memory chip 31, one fourth repair unit in the second memory chip 32, one first repair unit in the third memory chip 33, and one second repair unit in the fourth memory chip 34 are aligned along the third direction, and the switching of conductive vias is performed synchronously;
(d) one third repair unit in the logic chip 10, one fourth repair unit in the first memory chip 31, one third repair unit in the second memory chip 32, one second repair unit in the third memory chip 33, and one first repair unit in the fourth memory chip 34 are aligned along the third direction, and the switching of conductive vias is performed synchronously.

Likewise, the repair units of the chip stack structure 40 are aligned along the third direction and have a symmetrical switching direction, such that the same switching function can be realized.

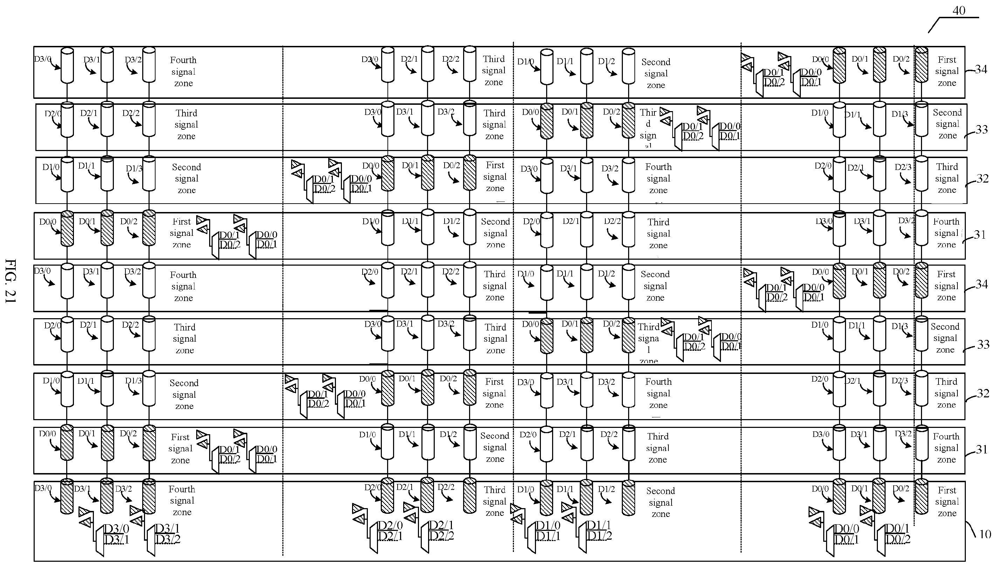

To more conveniently understand the signal switching process of the chip stack structure 40, the signal switching will be described below in a specific working scenario, in which the chip stack structure 40 formed by stacking the logic chip 10 provided in FIG. 5 and the memory chip 30 provided in FIG. 11 in the stack form of FIG. 17A is used, and it is assumed that each repair unit has a repair ratio of 2:1. Referring to FIG. 21, a schematic diagram of signal transmission in the chip stack structure 40 is provided.

FIG. 21 shows one of the repair unit groups in each chip. For the respective repair unit group, each memory chip is provided with only two signal select circuits 100, such that only two conductive vias in the first repair unit in the repair unit group are connected to the internal circuit of the memory chip, that is, only two signal channels formed by conductive vias are connected to the internal circuit of the memory chip; the logic chip 10 is provided with eight signal select circuits, such that two conductive vias in each repair unit in the repair unit group are connected to the internal circuit of the logic chip, that is, eight signal channels in total formed by conductive vias in four repair units are connected to the internal circuit of the logic chip, and thus the logic chip 10 can be connected to corresponding memory chips through two signal channels, separately to perform signal interaction.

Referring to FIG. 21 to FIG. 22B, the following exemplary working scenario is provided.

A specific process of signal switching is described with the fourth repair unit composed of D3/0, D3/1, and D3/2 in the fourth signal zone in the logic chip 10, the first repair unit composed of D0/0, D0/1, and D0/2 in the first signal zone in the first memory chip 31, the second repair unit composed of D1/0, D1/1, and D1/2 in the second signal zone in the second memory chip 32, the third repair unit composed of D2/0, D2/1, and D2/2 in the third signal zone in the third memory chip 33, and the fourth repair unit composed of D3/0, D3/1, and D3/2 in the fourth signal zone in the fourth memory chip 34 as an example.

As shown in FIG. 21, D3/0 in the fourth signal zone in the logic chip 10, D0/0 in the first signal zone in the first memory chip 31, D1/0 in the second signal zone in the second memory chip 32, D2/0 in the third signal zone in the third memory chip 33, and D3/0 in the fourth signal zone in the fourth memory chip 34 are connected to form a signal channel (first normal signal channel); meanwhile, D3/1 in the fourth signal zone in the logic chip 10, D0/1 in the first signal zone in the first memory chip 31, D1/1 in the second signal zone in the second memory chip 32, D2/1 in the third signal zone in the third memory chip 33, and D3/1 in the fourth signal zone in the fourth memory chip 34 are connected to form a signal channel (second normal signal channel), and all the above are normal conductive vias. Meanwhile, D3/2 in the fourth signal zone in the logic chip 10, D0/2 in the first signal zone in the first memory chip 31, D1/2 in the second signal zone in the second memory chip 32, D2/2 in the third signal zone in the third memory chip 33, and D3/2 in the fourth signal zone in the fourth memory chip 34 are connected to form a signal channel (first redundant signal channel).

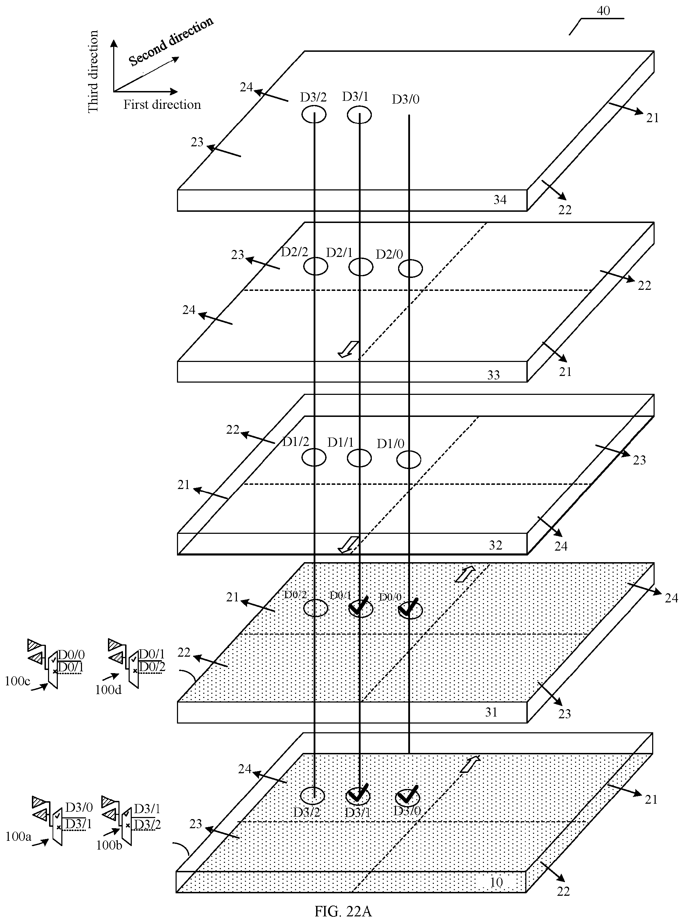

In the case that each conductive via is normal, referring to FIG. 22A, the signal select circuit 100a in the logic chip 10 connects D3/0 to the internal circuit, and the signal select circuit 100c in the first memory chip 31 connects D0/0 to the internal circuit, such that the first normal signal channel is used for transmitting an effective signal (denoted as signal1), the logic chip 10 can transmit/receive the effective signal signal1 from D3/0 through the signal select circuit 100a, and the first memory chip 31 can receive/transmit the effective signal signal1 from D0/0 through the signal select circuit 100c.

Similarly, the signal select circuit 100b in the logic chip 10 connects D3/1 to the internal circuit, the second normal signal channel transmits/receives another effective signal (denoted as signal2), and the signal select circuit 100d in the first memory chip 31 connects D0/1 to the internal circuit, thus receiving/transmitting the effective signal signal2.

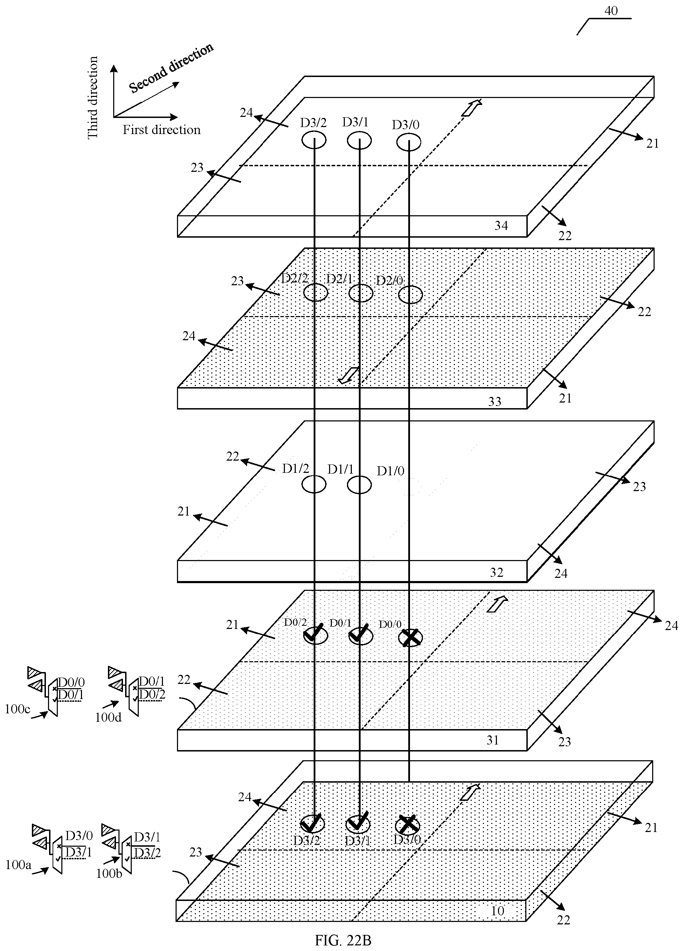

Referring to FIG. 22B, assuming that any one of the conductive vias in the first normal signal channel is damaged, i.e., the corresponding first normal signal channel cannot be used, repair needs to be performed by using the redundant signal channel. Then, for the logic chip 10, the signal select circuit 100a connects D0/1 to the internal circuit to replace the original D0/0 for transmitting/receiving the effective signal signal1, and the signal select circuit 100b connects D0/2 to the internal circuit to replace the original D0/1 for transmitting/receiving the effective signal signal2; meanwhile, for the first memory chip 31, the signal select circuit 100c connects D0/1 to the internal circuit to replace the original D0/0 for receiving/transmitting the effective signal signal1, and the signal select circuit 100d connects D0/2 to the internal circuit to replace the original D0/1 for receiving/transmitting the effective signal signal12. Thus, the switching from the first normal signal channel to the second normal signal channel and from the second normal signal channel to the first redundant signal channel is completed.

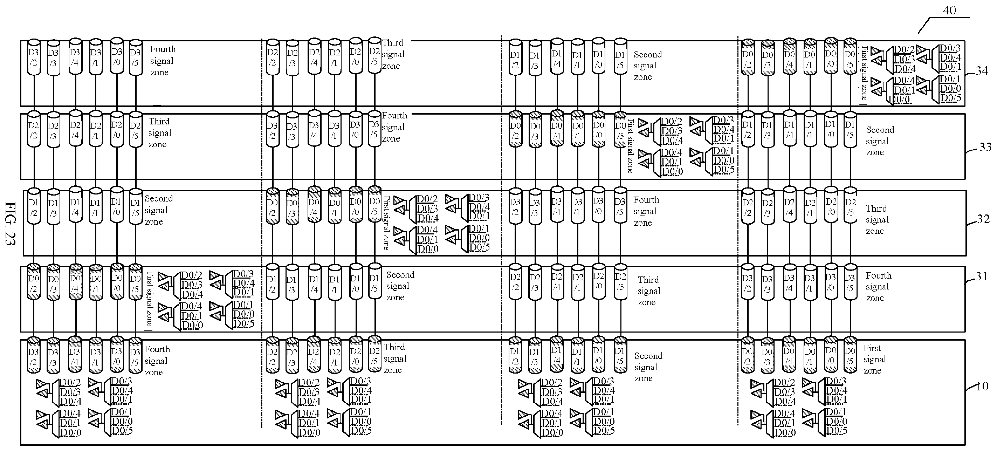

The signal switching will be described in detail below in the following specific working scenario, in which the chip stack structure 40 formed by stacking the logic chip 10 provided in FIG. 7 and the memory chip 30 provided in FIG. 13 in the stack form of FIG. 17A is used, and it is assumed that each repair unit has a repair ratio of 4:2. Referring to FIG. 23, a schematic diagram of signal transmission in the chip stack structure 40 is provided.

Referring to FIG. 23 to FIG. 24B, the following exemplary working scenario is provided.

A specific process of signal switching is described with the fourth repair unit composed of D3/0, D3/1, D3/2, D3/3, D3/4, and D3/5 in the fourth signal zone in the logic chip 10, the first repair unit composed of D0/0, D0/1, D0/2, D0/3, D0/4, and D0/5 in the first signal zone in the first memory chip 31, the second repair unit composed of D1/0, D1/1, D1/2, D1/3, D0/4, and D1/5 in the second signal zone in the second memory chip 32, the third repair unit composed of D2/0, D2/1, D2/2, D2/3, D2/4, and D2/5 in the third signal zone in the third memory chip 33, and the fourth repair unit composed of D3/0, D3/1, D3/2, D3/3, D3/4, and D3/5 in the fourth signal zone in the fourth memory chip 34 as an example.

As shown in FIG. 23, D3/2 in the fourth signal zone in the logic chip 10, D0/2 in the first signal zone in the first memory chip 31, D1/2 in the second signal zone in the second memory chip 32, D2/2 in the third signal zone in the third memory chip 33, and D3/2 in the fourth signal zone in the fourth memory chip 34 are connected to form a signal channel (first normal signal channel); D3/3 in the fourth signal zone in the logic chip 10, D0/3 in the first signal zone in the first memory chip 31, D1/3 in the second signal zone in the second memory chip 32, D2/3 in the third signal zone in the third memory chip 33, and D3/3 in the fourth signal zone in the fourth memory chip 34 are connected to form a signal channel (second normal signal channel); D3/4 in the fourth signal zone in the logic chip 10, D0/4 in the first signal zone in the first memory chip 31, D1/4 in the second signal zone in the second memory chip 32, D2/4 in the third signal zone in the third memory chip 33, and D3/4 in the fourth signal zone in the fourth memory chip 34 are connected to form a signal channel (third normal signal channel); D3/1 in the fourth signal zone in the logic chip 10, D0/1 in the first signal zone in the first memory chip 31, D1/1 in the second signal zone in the second memory chip 32, D2/1 in the third signal zone in the third memory chip 33, and D3/0 in the fourth signal zone in the fourth memory chip 34 are connected to form a signal channel (fourth normal signal channel); all the above are normal conductive vias.

Meanwhile, D3/0 in the fourth signal zone in the logic chip 10, D0/0 in the first signal zone in the first memory chip 31, D1/0 in the second signal zone in the second memory chip 32, D2/0 in the third signal zone in the third memory chip 33, and D3/0 in the fourth signal zone in the fourth memory chip 34 are connected to form a signal channel (first redundant signal channel), and D3/5 in the fourth signal zone in the logic chip 10, D0/5 in the first signal zone in the first memory chip 31, D1/5 in the second signal zone in the second memory chip 32, D2/5 in the third signal zone in the third memory chip 33, and D3/5 in the fourth signal zone in the fourth memory chip 34 are connected to form a signal channel (second redundant signal channel).

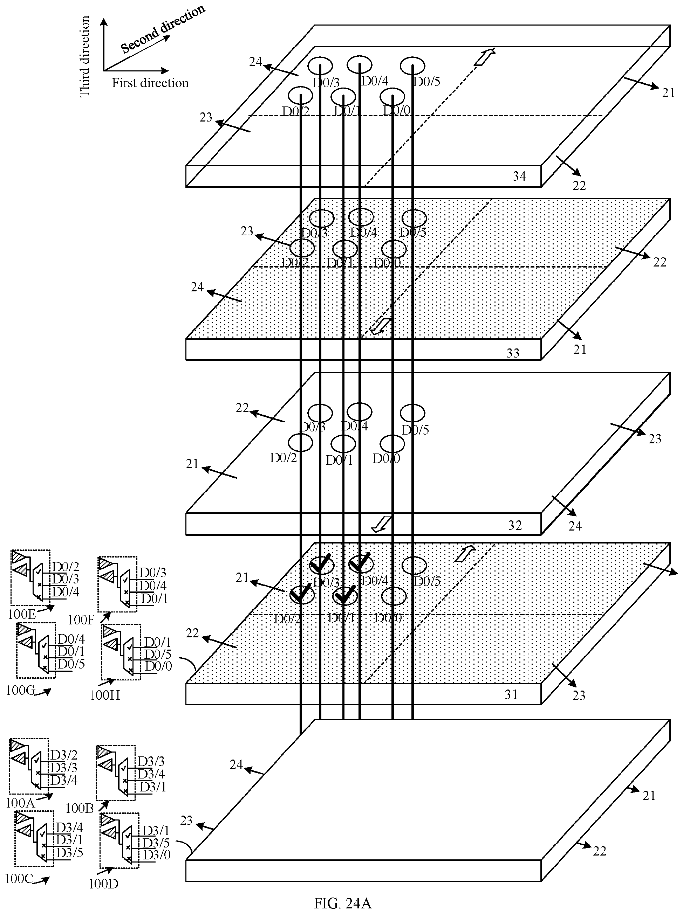

In the case that each conductive via is normal, referring to FIG. 24A, the signal select circuit 100A in the logic chip 10 connects D3/2 to the internal circuit, and the signal select circuit 100E in the first memory chip 31 connects D0/2 to the internal circuit, such that the first normal signal channel is used for transmitting an effective signal (denoted as signal1). Specifically, the logic chip 10 can transmit/receive the effective signal signal1 from D2/6 through the signal select circuit 100A, and the first memory chip 31 can receive/transmit the effective signal signal1 from D1/1 through the signal select circuit 100E.

Similarly, the signal select circuit 100B in the logic chip 10 connects D3/3 to the internal circuit, the second normal signal channel transmits/receives another effective signal (denoted as signal2), and the signal select circuit 100F in the first memory chip 31 connects D0/3 to the internal circuit, thus receiving/transmitting the effective signal signal2; the signal select circuit 100C in the logic chip 10 connects D3/4 to the internal circuit, the second normal signal channel transmits/receives another effective signal (denoted as signal3), and the signal select circuit 100G in the first memory chip 31 connects D0/4 to the internal circuit, thus receiving/transmitting the effective signal signal3; the signal select circuit 100D in the logic chip 10 connects D3/4 to the internal circuit, the second normal signal channel transmits/receives another effective signal (denoted as signal4), and the signal select circuit 100H in the first memory chip 31 connects D0/4 to the internal circuit, thus receiving/transmitting the effective signal signal4.

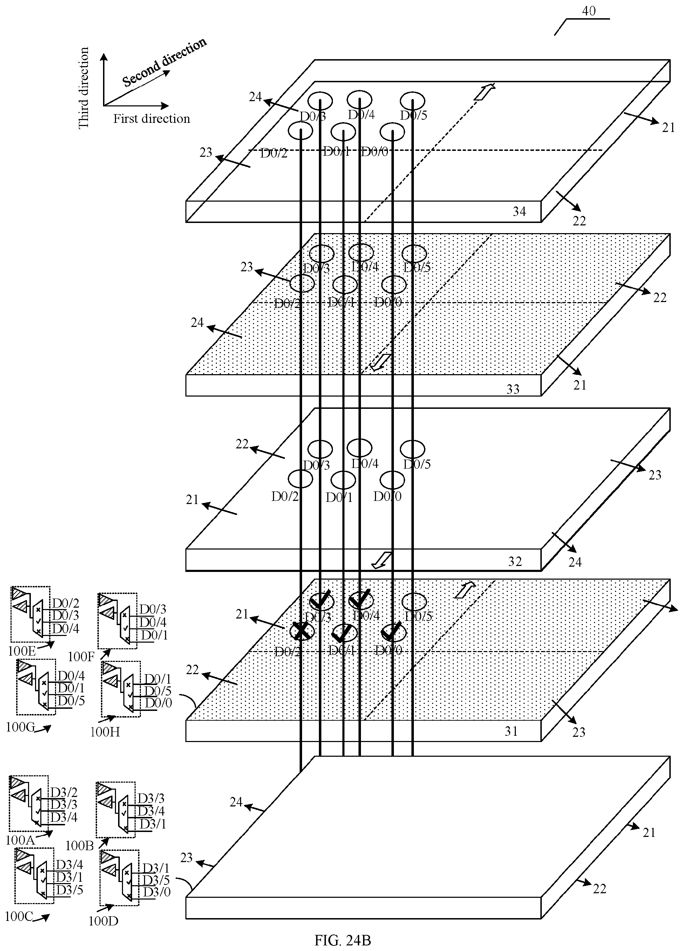

Referring to FIG. 24B, assuming that the first normal signal channel cannot be used and repair needs to be performed by using the redundant signal channel, for the logic chip 10, the signal select circuit 100A connects D3/3 to the internal circuit to replace the original D3/2 for transmitting/receiving the effective signal signal1, the signal select circuit 100B connects D3/4 to the internal circuit to replace the original D3/3 for transmitting/receiving the effective signal signal2, the signal select circuit 100C connects D3/1 to the internal circuit, to replace the original D3/4 for transmitting/receiving the effective signal signal3, and the signal select circuit 100D connects D3/0 to the internal circuit to replace the original D3/1 for transmitting/receiving the effective signal signal4.

Meanwhile, for the first memory chip 31, the signal select circuit 100E connects D0/3 to the internal circuit to replace the original D1/2 for receiving/transmitting the effective signal signal1, the signal select circuit 100F connects D0/4 to the internal circuit to replace the original D0/3 for receiving/transmitting the effective signal signal12, the signal select circuit 100G connects D0/1 to the internal circuit to replace the original D0/4 for receiving/transmitting the effective signal signal13, and the signal select circuit 100H connects D0/0 to the internal circuit to replace the original D0/1 for receiving/transmitting the effective signal signal15.

Therefore, the switching from the first normal signal channel to the second normal signal channel, from the second normal signal channel to the third normal signal channel, from the third normal signal channel to the fourth normal signal channel, and from the fourth normal signal channel to the first redundant signal channel is completed. Meanwhile, as can be seen from FIG. 17B, FIG. 18B, FIG. 19B, FIG. 20B, and FIG. 21 to FIG. 24B, for the chip stack structure 40, the bottom-up signal transmission path will be similar to the following form for transmission: referring to FIG. 17B and FIG. 18B, "the fourth conductive via D3 in the logic chip 10 (or the fourth conductive via D1 in the logic chip 10, referring to FIG. 19B and FIG. 20B)-the first conductive via D0 in the first memory chip 31-the second conductive via D1 in the second memory chip 32-the third conductive via D2 in the third memory chip 33-the fourth conductive via D3 in the fourth memory chip 34, ...". That is, for the chip stack structure 40, from a physical perspective, the conductive vias therein are still in a direct connection configuration, but from a perspective of absolute positions of the conductive vias on the active surface, the conductive vias therein can be regarded as in a functionally rotational configuration, that is, a signal transmission effect similar to that of FIG. 2B is achieved through the physical direct connection configuration (i.e., a rotation-type transmission, such as the conductive via D0-the conductive via D1-the conductive via D2-the conductive via D3, ...). In brief, the chip stack structure 40 in FIG. 2B needs a physical spiral structure, in which a lateral interconnection structure is necessarily present, whereas the chip stack structure 40 in the embodiment of the present disclosure is a physical direct connection structure and does not need a lateral interconnection structure, such that the parasitic resistance is greatly reduced, and the transmission speed and the transmission performance are greatly improved.

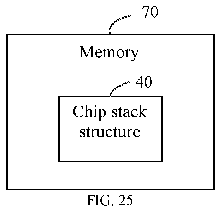

In still another embodiment of the present disclosure, referring to FIG. 25, a schematic diagram of a composition structure of a memory provided according to an embodiment of the present disclosure is shown. As shown in FIG. 25, the memory 70 includes the chip stack structure 40 of the foregoing embodiment.

In some embodiments, the chip stack structure 40 may be applied to the memory 70. The memory 70 may be, for example, a static random access memory (SRAM), a dynamic random access memory (DRAM), a synchronous dynamic random access memory (SDRAM), a double data rate SDRAM (DDR SDRAM), or the like, which is not specifically limited herein.

In the embodiment of the present disclosure, for the memory 70, the area of the chip can be reduced, such that the manufacturing cost of the chip can be reduced.

For details not disclosed in the embodiment of the present disclosure, reference may be made to the description of the foregoing embodiments for understanding.

The above description shows merely preferred embodiments of the present disclosure and is not intended to limit the protection scope of the present disclosure.

It should be noted that in the present disclosure, the terms "include", "comprise", or any other variants thereof are intended to cover non-exclusive inclusion, such that a process, a method, an item, or an apparatus including a series of elements includes not only those elements but also other elements not explicitly listed, or elements inherent to such process, method, item, or apparatus. Without further limitation, an element defined by the phrase "including a ..." or "comprising a ..." does not exclude the presence of other identical elements in the process, method, item, or apparatus that includes the element.

The serial numbers of the embodiments of the present disclosure described above are for the purpose of describing only and do not represent the superiority or inferiority of the embodiments.

The methods disclosed in the method embodiments provided in the present disclosure may be combined in any manner without conflict to obtain new method embodiments.

The features disclosed in the product embodiments provided in the present disclosure may be combined in any manner without conflict to obtain new product embodiments.

The features disclosed in the method or device embodiments provided in the present disclosure may be combined in any manner without conflict to obtain new method or device embodiments.

The above description is only the specific embodiments of the present disclosure, but the protection scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A logic chip (10), comprising m channel signal regions (11, 12, 13, 14) sequentially arranged along a first direction, wherein the logic chip (10) has a chip axis extending along a second direction and passing through a center of the logic chip (10), the m channel signal regions (11, 12, 13, 14) are arranged symmetrically about the chip axis, and m is a positive integer;
each one of the channel signal regions (11, 12, 13, 14) has a first axis and a second axis, wherein the first axis extends along the first direction or the second direction, and the second axis and the first axis are perpendicular to each other and intersect at a center of a corresponding channel signal region (11, 12, 13, 14) thereof;
each one of the channel signal regions (11, 12, 13, 14) is penetrated through by a plurality of conductive vias along a third direction, any two of the first direction, the second direction, and the third direction are perpendicular to each other, the first direction and the second direction are parallel to a top surface of the logic chip (10), and the third direction is perpendicular to the top surface of the logic chip (10); for each one of the channel signal regions (11, 12, 13, 14), the plurality of conductive vias therein are divided into a plurality of repair unit groups;
each one of the plurality of repair unit groups comprises a first repair unit, a second repair unit, a third repair unit, and a fourth repair unit; the first repair unit and the second repair unit are arranged symmetrically about the first axis of a corresponding channel signal region (11, 12, 13, 14) thereof, the third repair unit and the fourth repair unit are arranged symmetrically about the first axis of a corresponding channel signal region (11, 12, 13, 14) thereof, and the first repair unit and the fourth repair unit are arranged symmetrically about the second axis of a corresponding channel signal region (11, 12, 13, 14) thereof;
each one of the repair units comprises at least one redundant conductive via and at least one normal conductive via, and in a case that any one of the at least one normal conductive via is damaged, an effective signal transmitted by the normal conductive via is switched to a next conductive via in a same one of the repair units along a preset switching direction; any one of the conductive vias in any one of the repair units is electrically connected to an internal circuit of the logic chip (10) when used for transmitting an effective signal;
the normal conductive via in the first repair unit and the normal conductive via in the second repair unit are in one-to-one correspondence and are arranged symmetrically about the first axis of a corresponding channel signal region (11, 12, 13, 14) thereof, the normal conductive via in the third repair unit and the normal conductive via in the fourth repair unit are in one-to-one correspondence and are arranged symmetrically about the first axis of a corresponding channel signal region (11, 12, 13, 14) thereof, and the normal conductive via in the first repair unit and the normal conductive via in the fourth repair unit are in one-to-one correspondence and are arranged symmetrically about the second axis of a corresponding channel signal region (11, 12, 13, 14) thereof.

2. The logic chip (10) according to claim 1, wherein for each one of the plurality of repair unit groups, a preset switching direction of the conductive vias in the first repair unit and a preset switching direction of the conductive vias in the second repair unit are arranged symmetrically about the first axis of a corresponding channel signal region (11, 12, 13, 14) thereof; a preset switching direction of the conductive vias in the third repair unit and a preset switching direction of the conductive vias in the fourth repair unit are arranged symmetrically about the first axis of a corresponding channel signal region (11, 12, 13, 14) thereof; the preset switching direction of the conductive vias in the first repair unit and the preset switching direction of the conductive vias in the fourth repair unit are arranged symmetrically about the second axis of a corresponding channel signal region (11, 12, 13, 14) thereof; the preset switching direction of the conductive vias in the second repair unit and the preset switching direction of the conductive vias in the third repair unit are arranged symmetrically about the second axis of a corresponding channel signal region (11, 12, 13, 14) thereof.

3. The logic chip (10) according to claim 2, wherein each one of the channel signal regions (11, 12, 13, 14) is divided into 2×2 signal zones, the conductive vias of each one of the signal zones are divided into n conductive via groups with a same arrangement manner, and n is a positive integer; in a same one of the channel signal regions (11, 12, 13, 14), the conductive via groups in a first signal zone (21) and the conductive via groups in a second signal zone (22) are in one-to-one correspondence and are arranged symmetrically about the first axis of a corresponding channel signal region (11, 12, 13, 14) thereof, the conductive via groups in a third signal zone (23) and the conductive via groups in a fourth signal zone (24) are in one-to-one correspondence and are arranged symmetrically about the first axis of a corresponding channel signal region (11, 12, 13, 14) thereof, and the conductive via groups in the first signal zone (21) and the conductive via groups in the fourth signal zone (24) are in one-to-one correspondence and are arranged symmetrically about the second axis of a corresponding channel signal region (11, 12, 13, 14) thereof;
each one of the conductive via groups comprises a first conductive via, a second conductive via, a third conductive via, and a fourth conductive via;
in a same one of the channel signal regions (11, 12, 13, 14), the first conductive via in one of the conductive via groups in the first signal zone (21), the second conductive via in a corresponding one of the conductive via groups in the second signal zone (22), the third conductive via in a corresponding one of the conductive via groups in the third signal zone (23), and the fourth conductive via in a corresponding one of the conductive via groups in the fourth signal zone (24) form a whole symmetrical about the first axis and symmetrical about the second axis;
in a same one of the channel signal regions (11, 12, 13, 14), the second conductive via in one of the conductive via groups in the first signal zone (21), the first conductive via in a corresponding one of the conductive via groups in the second signal zone (22), the fourth conductive via in a corresponding one of the conductive via groups in the third signal zone (23), and the third conductive via in a corresponding one of the conductive via groups in the fourth signal zone (24) form a whole symmetrical about the first axis and symmetrical about the second axis;
in a same one of the channel signal regions (11, 12, 13, 14), the third conductive via in one of the conductive via groups in the first signal zone (21), the fourth conductive via in a corresponding one of the conductive via groups in the second signal zone (22), the first conductive via in a corresponding one of the conductive via groups in the third signal zone (23), and the second conductive via in a corresponding one of the conductive via groups in the fourth signal zone (24) form a whole symmetrical about the first axis and symmetrical about the second axis;
in a same one of the channel signal regions (11, 12, 13, 14), the fourth conductive via in one of the conductive via groups in the first signal zone (21), the third conductive via in a corresponding one of the conductive via groups in the second signal zone (22), the second conductive via in a corresponding one of the conductive via groups in the third signal zone (23), and the first conductive via in a corresponding one of the conductive via groups in the fourth signal zone (24) form a whole symmetrical about the first axis and symmetrical about the second axis.

4. The logic chip (10) according to claim 3, wherein B conductive via groups in each one of the signal zones are referred to as one conductive via combination, conductive via groups b in corresponding conductive via combinations in all the signal zones form a whole symmetrical about the first axis and symmetrical about the second axis, B is a positive integer less than or equal to n, and b is a natural number less than B;
corresponding conductive via combinations in all of the signal zones in a same one of the channel signal regions (11, 12, 13, 14) form four repair unit groups in total:
for a first one of the repair unit groups, the first repair unit comprises respective first conductive vias of all the conductive via groups in the conductive via combination in the first signal zone (21), the second repair unit comprises respective second conductive vias of all the conductive via groups in the conductive via combination in the second signal zone (22), the third repair unit comprises respective third conductive vias of all the conductive via groups in the conductive via combination in the third signal zone (23), and the fourth repair unit comprises respective fourth conductive vias of all the conductive via groups in the conductive via combination in the fourth signal zone (24);
for a second one of the repair unit groups, the first repair unit comprises respective first conductive vias of all the conductive via groups in the conductive via combination in the second signal zone (22), the second repair unit comprises respective second conductive vias of all the conductive via groups in the conductive via combination in the first signal zone (21), the third repair unit comprises respective third conductive vias of all the conductive via groups in the conductive via combination in the fourth signal zone (24), and the fourth repair unit comprises respective fourth conductive vias of all the conductive via groups in the conductive via combination in the third signal zone (23);
for a third one of the repair unit groups, the first repair unit comprises respective first conductive vias of all the conductive via groups in the conductive via combination in the third signal zone (23), the second repair unit comprises respective second conductive vias of all the conductive via groups in the conductive via combination in the fourth signal zone (24), the third repair unit comprises respective third conductive vias of all the conductive via groups in the conductive via combination in the first signal zone (21), and the fourth repair unit comprises respective fourth conductive vias of all the conductive via groups in the conductive via combination in the second signal zone (22);
for a fourth one of the repair unit groups, the first repair unit comprises respective first conductive vias of all the conductive via groups in the conductive via combination in the fourth signal zone (24), the second repair unit comprises respective second conductive vias of all the conductive via groups in the conductive via combination in the third signal zone (23), the third repair unit comprises respective third conductive vias of all the conductive via groups in the conductive via combination in the second signal zone (22), and the fourth repair unit comprises respective fourth conductive vias of all the conductive via groups in the conductive via combination in the first signal zone (21).

5. The logic chip (10) according to claim 4, wherein when B = 3, a value of b is 0, 1, or 2; the conductive vias in all the conductive via groups 0 are normal conductive vias;
a preset switching direction of the conductive vias in an X^{th} repair unit is set such that an X^{th} conductive via in the conductive via group 0 is allowed to switch to an X^{th} conductive via in the conductive via group 1 in a same one of the signal zones, the X^{th} conductive via in the conductive via group 1 is allowed to switch to an X^{th} conductive via in the conductive via group 2 in a same one of the signal zones, and X is one, two, three, or four.

6. The logic chip (10) according to claim 4, wherein when B = 6, a value of b is 0, 1, 2, 3, 4, or 5; the conductive vias in the conductive via groups 2 of all the signal zones are normal conductive vias; a preset switching direction of the conductive vias in an X^{th} repair unit is set such that an X^{th} conductive via in the conductive via group 2 is allowed to switch to an X^{th} conductive via in the conductive via group 3 in a same one of the signal zones, the X^{th} conductive via in the conductive via group 3 is allowed to switch to an X^{th} conductive via in the conductive via group 4 in a same one of the signal zones, the X^{th} conductive via in the conductive via group 4 is allowed to switch to an X^{th} conductive via in the conductive via group 1 in a same one of the signal zones, the X^{th} conductive via in the conductive via group 1 is allowed to switch to an X^{th} conductive via in the conductive via group 0 in a same one of the signal zones, and the X^{th} conductive via in the conductive via group 0 is allowed to switch to an X^{th} conductive via in the conductive via group 5 in a same one of the signal zones.

7. The logic chip (10) according to claim 6, wherein
in each one of the signal zones, the conductive via group 0, the conductive via group 1, and the conductive via group 2 are aligned along the first direction; the conductive via group 3, the conductive via group 4, and the conductive via group 5 are aligned along the first direction; the conductive via group 0 and the conductive via group 5 are aligned along the second direction, the conductive via group 1 and the conductive via group 4 are aligned along the second direction, and the conductive via group 2 and the conductive via group 3 are aligned along the second direction.

8. The logic chip (10) according to any one of claims 1 to 7, wherein
the conductive vias are prepared by any one or more of a via-first process, a via-middle process, a via-last process, and a back side via-last process; different conductive vias in a same logic chip (10) are electrically isolated.

9. A memory chip (30), comprising m channels sequentially arranged along a first direction, wherein the memory chip (30) has a chip axis extending along a second direction and passing through a center of the memory chip (30), and the m channels are arranged symmetrically about the chip axis; each one of the channels comprises a first memory array region, a channel signal region (11, 12, 13, 14), and a second memory array region sequentially arranged along the second direction, a center of each one of the channel signal regions (11, 12, 13, 14) is coincident with a center of a corresponding channel thereof, and m is a positive integer;
each one of the channel signal regions (11, 12, 13, 14) has a first axis and a second axis, wherein the first axis extends along the first direction or the second direction, and the second axis and the first axis are perpendicular to each other and intersect at a center of a corresponding channel signal region (11, 12, 13, 14) thereof;
each one of the channel signal regions (11, 12, 13, 14) is penetrated through by a plurality of conductive vias along a third direction, any two of the first direction, the second direction, and the third direction are perpendicular to each other, the first direction and the second direction are parallel to a top surface of the memory chip (30), and the third direction is perpendicular to the top surface of the memory chip (30); for each one of the channel signal regions (11, 12, 13, 14), the plurality of conductive vias therein are divided into a plurality of repair unit groups; each one of the plurality of repair unit groups comprises a first repair unit, a second repair unit, a third repair unit, and a fourth repair unit; the first repair unit and the second repair unit are arranged symmetrically about the first axis of a corresponding channel signal region (11, 12, 13, 14) thereof, the third repair unit and the fourth repair unit are arranged symmetrically about the first axis of a corresponding channel signal region (11, 12, 13, 14) thereof, and the first repair unit and the fourth repair unit are arranged symmetrically about the second axis of a corresponding channel signal region (11, 12, 13, 14) thereof;
each one of the repair units comprises at least one redundant conductive via and at least one normal conductive via, and in a case that any one of the at least one normal conductive via is damaged, an effective signal transmitted by the normal conductive via is switched to a next conductive via in a same one of the repair units along a preset switching direction; any one of the conductive vias in the first repair unit is electrically connected to an internal circuit of the memory chip (30) when used for transmitting an effective signal;
the normal conductive via in the first repair unit and the normal conductive via in the second repair unit are in one-to-one correspondence and are arranged symmetrically about the first axis of a corresponding channel signal region (11, 12, 13, 14) thereof, the normal conductive via in the third repair unit and the normal conductive via in the fourth repair unit are in one-to-one correspondence and are arranged symmetrically about the first axis of a corresponding channel signal region (11, 12, 13, 14) thereof, and the normal conductive via in the first repair unit and the normal conductive via in the fourth repair unit are in one-to-one correspondence and are arranged symmetrically about the second axis of a corresponding channel signal region (11, 12, 13, 14) thereof.

10. The memory chip (30) according to claim 9, wherein for each one of the plurality of repair unit groups, a preset switching direction of the conductive vias in the first repair unit and a preset switching direction of the conductive vias in the second repair unit are arranged symmetrically about the first axis of a corresponding channel signal region (11, 12, 13, 14) thereof; a preset switching direction of the conductive vias in the third repair unit and a preset switching direction of the conductive vias in the fourth repair unit are arranged symmetrically about the first axis of a corresponding channel signal region (11, 12, 13, 14) thereof; the preset switching direction of the conductive vias in the first repair unit and the preset switching direction of the conductive vias in the fourth repair unit are arranged symmetrically about the second axis of a corresponding channel signal region (11, 12, 13, 14) thereof; the preset switching direction of the conductive vias in the second repair unit and the preset switching direction of the conductive vias in the third repair unit are arranged symmetrically about the second axis of a corresponding channel signal region (11, 12, 13, 14) thereof.

11. The memory chip (30) according to claim 10, wherein each one of the channel signal regions (11, 12, 13, 14) is divided into 2×2 signal zones, the conductive vias of each one of the signal zones are divided into n conductive via groups with a same arrangement manner, and n is a positive integer; in a same one of the channel signal regions (11, 12, 13, 14), the conductive via groups in a first signal zone (21) and the conductive via groups in a second signal zone (22) are in one-to-one correspondence and are arranged symmetrically about the first axis, the conductive via groups in a third signal zone (23) and the conductive via groups in a fourth signal zone (24) are in one-to-one correspondence and are arranged symmetrically about the first axis, and the conductive via groups in the first signal zone (21) and the conductive via groups in the fourth signal zone (24) are in one-to-one correspondence and are arranged symmetrically about the second axis;
each one of the conductive via groups comprises a first conductive via, a second conductive via, a third conductive via, and a fourth conductive via;
for a same one of the channel signal regions, the first conductive via in one of the conductive via groups in the first signal zone (21), the second conductive via in a corresponding one of the conductive via groups in the second signal zone (22), the third conductive via in a corresponding one of the conductive via groups in the third signal zone (23), and the fourth conductive via in a corresponding one of the conductive via groups in the fourth signal zone (24) form a whole symmetrical about the first axis and symmetrical about the second axis;
in a same one of the channel signal regions (11, 12, 13, 14), the second conductive via in one of the conductive via groups in the first signal zone (21), the first conductive via in a corresponding one of the conductive via groups in the second signal zone (22), the fourth conductive via in a corresponding one of the conductive via groups in the third signal zone (23), and the third conductive via in a corresponding one of the conductive via groups in the fourth signal zone (24) form a whole symmetrical about the first axis and symmetrical about the second axis;
in a same one of the channel signal regions (11, 12, 13, 14), the third conductive via in one of the conductive via groups in the first signal zone (21), the fourth conductive via in a corresponding one of the conductive via groups in the second signal zone (22), the first conductive via in a corresponding one of the conductive via groups in the third signal zone (23), and the second conductive via in a corresponding one of the conductive via groups in the fourth signal zone (24) form a whole symmetrical about the first axis and symmetrical about the second axis;
in a same one of the channel signal regions (11, 12, 13, 14), the fourth conductive via in one of the conductive via groups in the first signal zone (21), the third conductive via in a corresponding one of the conductive via groups in the second signal zone (22), the second conductive via in a corresponding one of the conductive via groups in the third signal zone (23), and the first conductive via in a corresponding one of the conductive via groups in the fourth signal zone (24) form a whole symmetrical about the first axis and symmetrical about the second axis.

12. The memory chip (30) according to claim 11, wherein B conductive via groups in each one of the signal zones are referred to as one conductive via combination, conductive via groups b in corresponding conductive via combinations in all the signal zones form a whole symmetrical about the first axis and symmetrical about the second axis, B is a positive integer less than or equal to n, and b is a natural number less than B;
corresponding conductive via combinations in all of the signal zones in a same one of the channel signal regions (11, 12, 13, 14) form four repair unit groups in total:
for a first one of the repair unit groups, the first repair unit comprises respective first conductive vias of all the conductive via groups in the conductive via combination in the first signal zone (21), the second repair unit comprises respective second conductive vias of all the conductive via groups in the conductive via combination in the second signal zone (22), the third repair unit comprises respective third conductive vias of all the conductive via groups in the conductive via combination in the third signal zone (23), and the fourth repair unit comprises respective fourth conductive vias of all the conductive via groups in the conductive via combination in the fourth signal zone (24);
for a second one of the repair unit groups, the first repair unit comprises respective first conductive vias of all the conductive via groups in the conductive via combination in the second signal zone (22), the second repair unit comprises respective second conductive vias of all the conductive via groups in the conductive via combination in the first signal zone (21), the third repair unit comprises respective third conductive vias of all the conductive via groups in the conductive via combination in the fourth signal zone (24), and the fourth repair unit comprises respective fourth conductive vias of all the conductive via groups in the conductive via combination in the third signal zone (23);
for a third one of the repair unit groups, the first repair unit comprises respective first conductive vias of all the conductive via groups in the conductive via combination in the third signal zone (23), the second repair unit comprises respective second conductive vias of all the conductive via groups in the conductive via combination in the fourth signal zone (24), the third repair unit comprises respective third conductive vias of all the conductive via groups in the conductive via combination in the first signal zone (21), and the fourth repair unit comprises respective fourth conductive vias of all the conductive via groups in the conductive via combination in the second signal zone (22);
for a fourth one of the repair unit groups, the first repair unit comprises respective first conductive vias of all the conductive via groups in the conductive via combination in the fourth signal zone (24), the second repair unit comprises respective second conductive vias of all the conductive via groups in the conductive via combination in the third signal zone (23), the third repair unit comprises respective third conductive vias of all the conductive via groups in the conductive via combination in the second signal zone (22), and the fourth repair unit comprises respective fourth conductive vias of all the conductive via groups in the conductive via combination in the first signal zone (21).

13. The memory chip (30) according to claim 12, wherein when B = 3, a value of b is 0, 1, or 2; the conductive vias in the conductive via group 0 are normal conductive vias;
a preset switching direction of the conductive vias in any one of the first repair units is set such that a first conductive via in the conductive via group 0 is allowed to switch to a first conductive via in the conductive via group 1 in a same one of the signal zones, and the first conductive via in the conductive via group 1 is allowed to switch to a first conductive via in the conductive via group 2 in a same one of the signal zones.

14. The memory chip (30) according to claim 13, wherein when B = 6, a value of b is 0, 1, 2, 3, 4, or 5; the conductive vias in the conductive via groups 0 of all the signal zones are normal conductive vias;
a preset switching direction of the conductive vias in the first repair unit is set such that a first conductive via in the conductive via group 2 is allowed to switch to a first conductive via in the conductive via group 3 in a same one of the signal zones, the first conductive via in the conductive via group 3 is allowed to switch to a first conductive via in the conductive via group 4 in a same one of the signal zones, the first conductive via in the conductive via group 4 is allowed to switch to a first conductive via in the conductive via group 1 in a same one of the signal zones, the first conductive via in the conductive via group 1 is allowed to switch to a first conductive via in the conductive via group 0 in a same one of the signal zones, and the first conductive via in the conductive via group 0 is allowed to switch to a first conductive via in the conductive via group 5 in a same one of the signal zones.

15. A chip stack structure (40), comprising the logic chip (10) according to any one of claims 1 to 8 and at least one stack unit, wherein the logic chip (10) and the at least one stack unit are sequentially stacked along a third direction; each one of the at least one stack unit comprises a first memory chip (31), a second memory chip (32), a third memory chip (33), and a fourth memory chip (34) sequentially stacked along the third direction, and the third direction is perpendicular to a top surface of each one of the chips; the first memory chip (31), the second memory chip (32), the third memory chip (33), and the fourth memory chip (34) are each the memory chip (30) according to any one of claims 9 to 14;
the first memory chip (31) and the second memory chip (32) are stacked in a face-to-face manner, the second memory chip (32) and the third memory chip (33) are stacked in a back-to-back manner, and the third memory chip (33) and the fourth memory chip (34) are stacked in a face-to-face manner; the logic chip (10) and the first memory chip (31) are stacked in a back-to-back manner; or the logic chip (10) and the first memory chip (31) are stacked in a face-to-back manner.

16. The chip stack structure (40) according to claim 15, wherein the logic chip (10) comprises m channel signal regions (11, 12, 13, 14) arranged along a first direction, each one of the memory chips (30) is provided with m channels arranged along the first direction, and each one of the channels comprises a first memory array region, a channel signal region (11, 12, 13, 14), and a second memory array region sequentially arranged along a second direction; any two of the first direction, the second direction, and the third direction are perpendicular to each other, and the first direction and the second direction are parallel to the top surface of each one of the chips;
in a case that the logic chip (10) and the first memory chip (31) are stacked in a back-to-back manner and respective first axes of the logic chip (10) and each one of the memory chips (30) extend along the first direction,
an (m-i)^{th} one of the channel signal regions (11, 12, 13, 14) in the logic chip (10) is aligned with the channel signal region (11, 12, 13, 14) in an (i+1)^{th} one of the channels in the first memory chip (31), the channel signal region (11, 12, 13, 14) in an (i+1)^{th} one of the channels in the second memory chip (32), the channel signal region (11, 12, 13, 14) in an (m-i)^{th} one of the channels in the third memory chip (33), and the channel signal region (11, 12, 13, 14) in an (m-i)^{th} one of the channels in the fourth memory chip (34) along the third direction, wherein i is a natural number less than m.

17. The chip stack structure (40) according to claim 16, wherein the logic chip (10) comprises m channel signal regions (11, 12, 13, 14) arranged along the first direction, each one of the memory chips (30) is provided with m channels arranged along the first direction, and each one of the channels comprises a first memory array region, a channel signal region (11, 12, 13, 14), and a second memory array region sequentially arranged along the second direction;
in a case that the logic chip (10) and the first memory chip (31) are stacked in a back-to-back manner and respective second axes of the logic chip (10) and each one of the memory chips (30) extend along the first direction,
an (i+1)^{th} one of the channel signal regions (11, 12, 13, 14) in the logic chip (10) is aligned with the channel signal region (11, 12, 13, 14) in an (i+1)^{th} one of the channels in the first memory chip (31), the channel signal region (11, 12, 13, 14) in an (m-i)^{th} one of the channels in the second memory chip (32), the channel signal region (11, 12, 13, 14) in an (m-i)^{th} one of the channels in the third memory chip (33), and the channel signal region (11, 12, 13, 14) in an (i+1)^{th} one of the channels in the fourth memory chip (34) along the third direction, wherein i is a natural number less than m.

18. The chip stack structure (40) according to claim 16 or 17, wherein the channel signal region (11, 12, 13, 14) in each one of the channels is divided into 2×2 signal zones arranged in an array;
for only a plurality of channel signal regions (11, 12, 13, 14) aligned along the third direction:
a fourth signal zone (24) belonging to the logic chip (10), a first signal zone (21) belonging to the first memory chip (31), a second signal zone (22) belonging to the second memory chip (32), a third signal zone (23) belonging to the third memory chip (33), and a fourth signal zone (24) belonging to the fourth memory chip (34) are aligned along the third direction;
a third signal zone (23) belonging to the logic chip (10), a second signal zone (22) belonging to the first memory chip (31), a first signal zone (21) belonging to the second memory chip (32), a fourth signal zone (24) belonging to the third memory chip (33), and a third signal zone (23) belonging to the fourth memory chip (34) are aligned along the third direction;
a second signal zone (22) belonging to the logic chip (10), a third signal zone (23) belonging to the first memory chip (31), a fourth signal zone (24) belonging to the second memory chip (32), a first signal zone (21) belonging to the third memory chip (33), and a second signal zone (22) belonging to the fourth memory chip (34) are aligned along the third direction;
a first signal zone (21) belonging to the logic chip (10), a fourth signal zone (24) belonging to the first memory chip (31), a third signal zone (23) belonging to the second memory chip (32), a second signal zone (22) belonging to the third memory chip (33), and a first signal zone (21) belonging to the fourth memory chip (34) are aligned along the third direction.

19. The chip stack structure (40) according to claim 18, wherein each one of the signal zones comprises n conductive via groups with a same arrangement manner, and each one of the conductive via groups comprises a first conductive via, a second conductive via, a third conductive via, and a fourth conductive via;
for only a plurality of signal zones aligned along the third direction:
the fourth conductive vias belonging to the logic chip (10), the first conductive vias belonging to the first memory chip (31), the second conductive vias belonging to the second memory chip (32), the third conductive vias belonging to the third memory chip (33), and the fourth conductive vias belonging to the fourth memory chip (34) are aligned along the third direction;
the third conductive vias belonging to the logic chip (10), the second conductive vias belonging to the first memory chip (31), the first conductive vias belonging to the second memory chip (32), the fourth conductive vias belonging to the third memory chip (33), and the third conductive vias belonging to the fourth memory chip (34) are aligned along the third direction;
the second conductive vias belonging to the logic chip (10), the third conductive vias belonging to the first memory chip (31), the fourth conductive vias belonging to the second memory chip (32), the first conductive vias belonging to the third memory chip (33), and the second conductive vias belonging to the fourth memory chip (34) are aligned along the third direction;
the first conductive vias belonging to the logic chip (10), the fourth conductive vias belonging to the first memory chip (31), the third conductive vias belonging to the second memory chip (32), the second conductive vias belonging to the third memory chip (33), and the first conductive vias belonging to the fourth memory chip (34) are aligned along the third direction;
wherein a plurality of conductive vias aligned along the third direction are coupled to form a signal transmission channel.

20. The chip stack structure (40) according to claim 19, wherein
one of the fourth repair units in the logic chip (10), one of the first repair units in the first memory chip (31), one of the second repair units in the second memory chip (32), one of the third repair units in the third memory chip (33), and one of the fourth repair units in the fourth memory chip (34) are aligned along the third direction, and switching of conductive vias is performed synchronously;
one of the third repair units in the logic chip (10), one of the second repair units in the first memory chip (31), one of the first repair units in the second memory chip (32), one of the fourth repair units in the third memory chip (33), and one of the third repair units in the fourth memory chip (34) are aligned along the third direction, and switching of conductive vias is performed synchronously;
one of the second repair units in the logic chip (10), one of the third repair units in the first memory chip (31), one of the fourth repair units in the second memory chip (32), one of the first repair units in the third memory chip (33), and one of the second repair units in the fourth memory chip (34) are aligned along the third direction, and switching of conductive vias is performed synchronously;
one of the first repair units in the logic chip (10), one of the fourth repair units in the first memory chip (31), one of the third repair units in the second memory chip (32), one of the second repair units in the third memory chip (33), and one of the first repair units in the fourth memory chip (34) are aligned along the third direction, and switching of conductive vias is performed synchronously.

21. The chip stack structure (40) according to claim 15, wherein the logic chip (10) comprises m channel signal regions (11, 12, 13, 14) arranged along the first direction, each one of the memory chips (30) is provided with m channels arranged along the first direction, and each one of the channels comprises a first memory array region, a channel signal region (11, 12, 13, 14), and a second memory array region sequentially arranged along the second direction;
in a case that the logic chip (10) and the first memory chip (31) are stacked in a back-to-back manner and respective first axes of the logic chip (10) and each one of the memory chips (30) extend along the first direction,
an (i+1)^{th} one of the channel signal regions (11, 12, 13, 14) in the logic chip (10) is aligned with the channel signal region (11, 12, 13, 14) in an (i+1)^{th} one of the channels in the first memory chip (31), the channel signal region (11, 12, 13, 14) in an (i+1)^{th} one of the channels in the second memory chip (32), the channel signal region (11, 12, 13, 14) in an (m-i)^{th} one of the channels in the third memory chip (33), and the channel signal region (11, 12, 13, 14) in an (m-i)^{th} one of the channels in the fourth memory chip (34) along the third direction, wherein i is a natural number less than m.

22. The chip stack structure (40) according to claim 15, wherein the logic chip (10) comprises m channel signal regions (11, 12, 13, 14) arranged along the first direction, each one of the memory chips (30) is provided with m channels arranged along the first direction, and each one of the channels comprises a first memory array region, a channel signal region (11, 12, 13, 14), and a second memory array region sequentially arranged along the second direction;
in a case that the logic chip (10) and the first memory chip (31) are stacked in a back-to-back manner and respective second axes of the logic chip (10) and each one of the memory chips (30) extend along the first direction,
an (m-i)^{th} one of the channel signal regions (11, 12, 13, 14) in the logic chip (10) is aligned with the channel signal region (11, 12, 13, 14) in an (i+1)^{th} one of the channels in the first memory chip (31), the channel signal region (11, 12, 13, 14) in an (m-i)^{th} one of the channels in the second memory chip (32), the channel signal region (11, 12, 13, 14) in an (m-i)^{th} one of the channels in the third memory chip (33), and the channel signal region (11, 12, 13, 14) in an (i+1)^{th} one of the channels in the fourth memory chip (34) along the third direction, wherein i is a natural number less than m.

23. The chip stack structure (40) according to claim 21 or 22, wherein the channel signal region (11, 12, 13, 14) in each one of the channels is divided into 2×2 signal zones arranged in an array;
for only a plurality of channel signal regions (11, 12, 13, 14) aligned along the third direction:
a second signal zone (22) belonging to the logic chip (10), a first signal zone (21) belonging to the first memory chip (31), a second signal zone (22) belonging to the second memory chip (32), a third signal zone (23) belonging to the third memory chip (33), and a fourth signal zone (24) belonging to the fourth memory chip (34) are aligned along the third direction;
a first signal zone (21) belonging to the logic chip (10), a second signal zone (22) belonging to the first memory chip (31), a first signal zone (21) belonging to the second memory chip (32), a fourth signal zone (24) belonging to the third memory chip (33), and a third signal zone (23) belonging to the fourth memory chip (34) are aligned along the third direction;
a fourth signal zone (24) belonging to the logic chip (10), a third signal zone (23) belonging to the first memory chip (31), a fourth signal zone (24) belonging to the second memory chip (32), a first signal zone (21) belonging to the third memory chip (33), and a second signal zone (22) belonging to the fourth memory chip (34) are aligned along the third direction;
a third signal zone (23) belonging to the logic chip (10), a fourth signal zone (24) belonging to the first memory chip (31), a third signal zone (23) belonging to the second memory chip (32), a second signal zone (22) belonging to the third memory chip (33), and a first signal zone (21) belonging to the fourth memory chip (34) are aligned along the third direction.

24. The chip stack structure (40) according to claim 23, wherein each one of the signal zones comprises n conductive via groups with a same arrangement manner, and each one of the conductive via groups comprises a first conductive via, a second conductive via, a third conductive via, and a fourth conductive via;
for a plurality of signal zones aligned along the third direction:
the second conductive vias belonging to the logic chip (10), the first conductive vias belonging to the first memory chip (31), the second conductive vias belonging to the second memory chip (32), the third conductive vias belonging to the third memory chip (33), and the fourth conductive vias belonging to the fourth memory chip (34) are aligned along the third direction;
the first conductive vias belonging to the logic chip (10), the second conductive vias belonging to the first memory chip (31), the first conductive vias belonging to the second memory chip (32), the fourth conductive vias belonging to the third memory chip (33), and the third conductive vias belonging to the fourth memory chip (34) are aligned along the third direction;
the fourth conductive vias belonging to the logic chip (10), the third conductive vias belonging to the first memory chip (31), the fourth conductive vias belonging to the second memory chip (32), the first conductive vias belonging to the third memory chip (33), and the second conductive vias belonging to the fourth memory chip (34) are aligned along the third direction;
the third conductive vias belonging to the logic chip (10), the fourth conductive vias belonging to the first memory chip (31), the third conductive vias belonging to the second memory chip (32), the second conductive vias belonging to the third memory chip (33), and the first conductive vias belonging to the fourth memory chip (34) are aligned along the third direction;
wherein a plurality of conductive vias aligned along the third direction are coupled to form a signal transmission channel.

25. The chip stack structure (40) according to claim 24, wherein
one of the second repair units in the logic chip (10), one of the first repair units in the first memory chip (31), one of the second repair units in the second memory chip (32), one of the third repair units in the third memory chip (33), and one of the fourth repair units in the fourth memory chip (34) are aligned along the third direction, and switching of conductive vias is performed synchronously;
one of the first repair units in the logic chip (10), one of the second repair units in the first memory chip (31), one of the first repair units in the second memory chip (32), one of the fourth repair units in the third memory chip (33), and one of the third repair units in the fourth memory chip (34) are aligned along the third direction, and switching of conductive vias is performed synchronously;
one of the fourth repair units in the logic chip (10), one of the third repair units in the first memory chip (31), one of the fourth repair units in the second memory chip (32), one of the first repair units in the third memory chip (33), and one of the second repair units in the fourth memory chip (34) are aligned along the third direction, and switching of conductive vias is performed synchronously;
one of the third repair units in the logic chip (10), one of the fourth repair units in the first memory chip (31), one of the third repair units in the second memory chip (32), one of the second repair units in the third memory chip (33), and one of the first repair units in the fourth memory chip (34) are aligned along the third direction, and switching of conductive vias is performed synchronously.

26. The chip stack structure (40) according to any one of claims 15 to 25, wherein
for two chips connected in a face-to-face manner, positions in the two chips where the conductive vias are aligned along the third direction are electrically connected through a hybrid bonding process; for two chips connected in a back-to-back manner or for two chips connected in a back-to-face manner, positions in the two chips where the conductive vias are aligned along the third direction are electrically connected through a conductive bump bonding process; or
for two chips connected in a face-to-face manner or for two chips connected in a back-to-back manner or for two chips connected in a back-to-face manner, positions in the two chips where the conductive vias are aligned along the third direction are electrically connected through a hybrid bonding process; or
for two chips connected in a face-to-face manner or for two chips connected in a back-to-back manner or for two chips connected in a back-to-face manner, positions in the two chips where the conductive vias are aligned along the third direction are electrically connected through a conductive bump bonding process.

27. A memory (70), comprising the chip stack structure (40) according to any one of claims 15 to 26.
